(19) Europäisches Patentamt
European Patent Office
Office européen des brevets

(11) **EP 4 498 427 A1**

(12) **EUROPEAN PATENT APPLICATION**
published in accordance with Art. 153(4) EPC

(43) Date of publication:
**29.01.2025 Bulletin 2025/05**

(21) Application number: 23773755.6

(22) Date of filing: **17.03.2023**

(51) International Patent Classification (IPC):
*H01L 23/34* (2006.01)     *H01L 21/48* (2006.01)
*H01L 23/495* (2006.01)

(52) Cooperative Patent Classification (CPC):
(C-Sets available)
H01L 2224/16225; H01L 2224/32225;
H01L 2224/48137; H01L 2224/48247;
H01L 2224/73204; H01L 2224/73253;
H01L 2224/73265; H01L 2224/97;
H01L 2924/15192; H01L 2924/181;
H01L 2924/19105                           (Cont.)

(86) International application number:
**PCT/CN2023/082358**

(87) International publication number:
**WO 2023/179507 (28.09.2023 Gazette 2023/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 20.03.2022  CN 202210274148
13.07.2022  CN 202210822506

(71) Applicant: Shanghai Metapwr Electronics Co., Ltd
Shanghai 201306 (CN)

(72) Inventor: ZENG, Jianhong
Shanghai 201306 (CN)

(74) Representative: Kurig, Thomas
Becker Kurig & Partner
Patentanwälte mbB
Bavariastraße 7
80336 München (DE)

(54) **HIGH-FREQUENCY HIGH-POWER PACKAGE MODULE, MANUFACTURING METHOD FOR MODULE, AND HYBRID SUBSTRATE**

(57)     Disclosed are a high-frequency high-power package module, a manufacturing method for a module, and a hybrid substrate. The high-frequency high-power package module comprises at least one power conversion bridge arm, at least one high-frequency capacitor, a circuit layer, an insulated thermally conductive plate, and a plastic package body , a front surface of a semiconductor power device is electrically connected to a first surface of the circuit layer; a back surface of the semiconductor power device is thermally connected to or electrically and thermally connected to a lower surface of the insulated thermally conductive plate; the high-frequency capacitor is electrically connected to the first surface of the circuit layer or a second surface of the circuit layer or the lower surface of the insulated thermally conductive plate; and at least one electrode of the high-frequency capacitor is electrically connected to at least one electrode of the at least one semiconductor power device by means of an inner-layer electrical connection layer. According to the present application, the loop inductance is greatly reduced while the heat dissipation capability is ensured, so that the high-power high frequency' is realized, advantages of a third-generation semiconductor are fully exerted, and an application basis is provided for upgrading of the performance of the third-generation semiconductor.

FIG 7D

EP 4 498 427 A1

(52) Cooperative Patent Classification (CPC): (Cont.)

C-Sets
H01L 2224/73204, H01L 2224/16225,
H01L 2224/32225, H01L 2924/00;
H01L 2924/181, H01L 2924/00012

**Description**

**TECHNICAL FIELD**

The present application belongs to the technical field of semiconductor packaging, and particularly relates to a high-frequency high-power packaging module, a manufacturing method for the module, and a hybrid substrate.

**BACKGROUND**

With the gradual maturity of the third-generation semiconductor GaN/SiC, the application of the third generation semiconductor GaN/SiC is more and more extensive. Compared with a traditional silicon device, the equivalent internal resistance of the traditional silicon device is greatly reduced, so that the applicable power of a single semiconductor power device is greatly increased. Meanwhile, the third-generation semiconductor also has more excellent switching characteristics, the switching loss of the third-generation semiconductor is greatly reduced, and the third-generation semiconductor is easier to work under high frequency. However, due to the defects of an existing packaging technology, the two advantages are difficult to obtain at the same time.

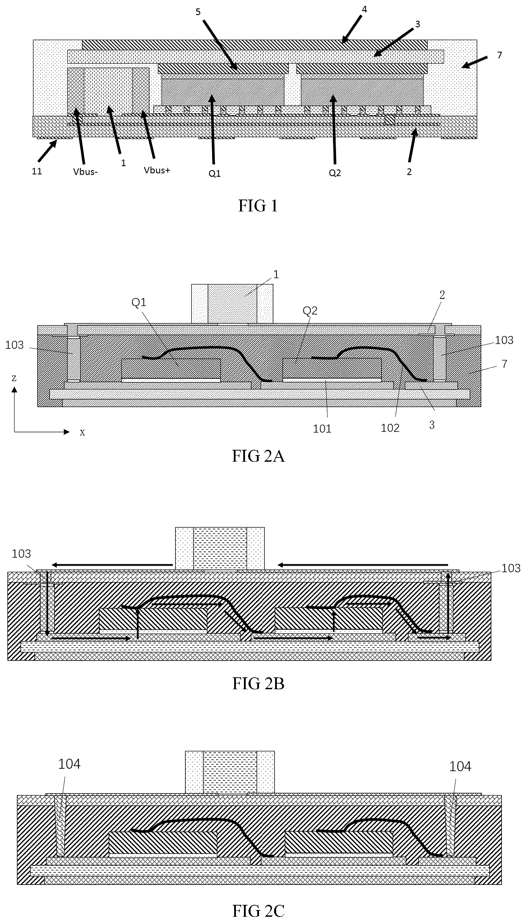

As shown in FIG. 1, due to the fact that the semiconductor power devices Q1 and Q2 are small in area and high in heat density, the thick copper ceramic substrate is needed to achieve insulation and heat-conducting, the wiring precision of the ceramic substrate is poor due to thick copper, and small-spacing SMD operation cannot be achieved. Therefore, the back surface (i.e., the top surface) of the semiconductor power device is usually welded to the ceramic plate for heat dissipation, the front surface of the semiconductor power device is subjected to wire bonding through Wirebond, and high-precision electrical arrangement on the semiconductor power device is led out. Due to the existence of the bonding wire, the loop inductance is greatly increased, the improvement of the switching speed is limited, and the frequency improvement is limited.

Therefore, how to greatly reduce the loop inductance while ensuring the heat dissipation capability, so that the high-power high frequency is realized, so as to fully exert the advantage of the third-generation semiconductor is an urgent problem to be solved.

**Summary**

In view of the above, one of the objectives of the invention is to provide a high-frequency high-power packaging module which greatly reduces the loop inductance while ensuring the heat dissipation capability, so that the high-power high frequency is realized, the advantages of the third-generation semiconductor are brought into full play, and an application basis is provided for updating the performance of the third-generation semiconductor.

The application further aims to provide the manufacturing method of the high-frequency high-power packaging module.

The high-frequency and high-power in the high-frequency high-power packaging module refers to that the power of the converter applying the module exceeds 10KW, and the working frequency is higher than 100KHz; or the working frequency of the converter applying the module is higher than 300KHz, and the power exceeds 1KW; and the converter applying the module takes power exceeding 10KW, and the working frequency exceeds 300KHz is good. Of course, this is only a preferred application scenario and is not a limitation of the present application.

The high-frequency high-power packaging module is characterized by comprising at least one power conversion bridge arm, at least one high-frequency capacitor, a circuit layer, an insulating heat-conducting plate and a plastic package body;

wherein the power conversion bridge arm comprises at least two semiconductor power devices connected in series;
wherein the high-frequency capacitor and the power conversion bridge arm are connected in parallel to form a high-frequency loop;
wherein the circuit layer comprises a first surface, an inner-layer electrical connection layer, a second surface and a vertical electrical connection path, and the inner-layer electrical connection layer is electrically connected with the first surface through at least one vertical electrical connection path;
wherein the insulating heat-conducting plate comprises an insulating heat-conducting layer, and an upper metal layer and a lower metal layer which are respectively arranged on the upper surface and the lower surface of the insulating heat-conducting layer;
wherein the plastic package body fills a gap area between the second surface of the circuit layer and the upper surface of the insulating heat-conducting plate, an external electrode is arranged on the second surface or the side edge of the circuit layer, and the external electrode is electrically connected with the power conversion bridge arm;
wherein the front surface of the semiconductor power device is electrically connected with the first surface of the circuit layer, and the back surface of the semiconductor power device is thermally connected with or electrically connected with the lower surface of the insulating heat-conducting plate;

wherein the high-frequency capacitor is electrically connected to a first surface of the circuit layer or a second surface of the circuit layer or a lower surface of the insulating heat-conducting plate, and at least one electrode of the high-frequency capacitor is electrically connected to at least one electrode of the at least one semiconductor power device by means of the inner-layer electrical connection layer.

The high-frequency high-power packaging module, wherein the semiconductor power device is electrically connected to the first surface of the circuit layer by means of a thermal resistance electrical connection layer.

Preferably, the thermal resistance Rth_DietoPCB of the thermal resistance electrical connection layer meets the following formula:

$$(Tcase+(TdieMAX-Tcase) \times Rth\_PCBtoCase/( Rth\_PCBtoCase+Rth\_DietoPCB)) \leqslant TpcbMax;$$

Tcase is the ambient temperature when the high-frequency high-power packaging module works, TdieMAX is the highest working temperature of the semiconductor power device, Rth_PCBtoCase is the total equivalent thermal resistance value from the circuit layer to the upper surface of the insulating heat-conducting plate, and TpcbMax is the highest working temperature of the circuit layer.

Preferably, wherein the thermal resistance value of the thermal resistance electrical connection layer is at least 3K/W.

Preferably, wherein an upper surface of the insulating heat-conducting plate is thermally connected to a radiator, and an air gap is provided between an upper surface of the plastic package and the radiator.

Preferably, when the high-frequency capacitor is electrically connected with the first surface of the circuit layer, the height Hc of the high-frequency capacitor meets the following conditions:

$$H1 \leqslant Hc < H2;$$

H1 is a distance from the first surface of the circuit layer to the back surface of the semiconductor power device, and H2 is a distance from the first surface of the circuit layer to the lower surface of the insulating heat-conducting layer; and the insulating heat-conducting plate extends above the high-frequency capacitor; and the lower metal layer located between the high-frequency capacitor and the insulating heat-conducting layer is isolated from the high-frequency capacitor in a thinning or removing mode.

Preferably, when the high-frequency capacitor is electrically connected with the first surface of the circuit layer, the height He of the high-frequency capacitor meets the following conditions:

$$H2 \leqslant Hc < H3;$$

H2 is a distance from the first surface of the circuit layer to the lower surface of the insulating heat-conducting layer, and H3 is a distance from the first surface of the circuit layer to the upper surface of the insulating heat-conducting layer; wherein the insulating heat-conducting plate is located above a device other than the high-frequency capacitor on the second surface of the circuit layer.

Preferably, when the high-frequency capacitor is electrically connected with the second surface of the circuit layer, the two electrodes of the high-frequency capacitor are electrically connected with the inner-layer electrical connection layer and the first surface of the circuit layer through the vertical electrical connection paths respectively.

Preferably, when the high-frequency capacitor is electrically connected with the lower surface of the insulating heat-conducting plate, at least one electrode of the high-frequency capacitor is electrically connected with the inner-layer electrical connecting layer through an electrical connecting piece, and the height He of the high-frequency capacitor meets the following conditions:

$$H1 \leqslant Hc < H4;$$

wherein H1 is the distance from the first surface of the circuit layer to the back surface of the semiconductor power device, and H4 is the distance from the second surface of the circuit layer to the lower surface of the insulating heat-conducting layer;
the circuit layer located below the high-frequency capacitor is isolated from the high-frequency capacitor in a thinning or removing mode.

Preferably, a power electrode of the semiconductor power device is located on the front surface of the high-frequency high-power packaging module.

Preferably, the high-frequency high-power packaging module further comprises at least one electrical connecting hole, and the electrical connecting hole is used for realizing electric connection between the front electrode of the semiconductor power device and the circuit board.

Preferably, the back electrode of the semiconductor power device is electrically connected to the first surface of the circuit layer by means of the lower metal layer and the conductive assembly of the insulating heat-conducting plate in sequence.

Preferably, a back electrode of the semiconductor power device is electrically connected to the front surface of the semiconductor power device through a conductive through hole formed in the back electrode.

Preferably, at least one power electrode of the semiconductor power device is a back power electrode, the back power electrode is electrically connected to a first surface of the circuit layer through a lower metal layer and a conductive assembly of the insulating heat-conducting plate, and the lower metal layer is a thick copper layer.

Preferably, the high-frequency high-power packaging module is characterized in that a high-heat-capacity element is arranged in the circuit layer, and the high-heat-capacity element is in thermal connection or electrical heating connection with the inner-layer electrical connection layer.

Preferably, the projection of the wiring connected to the two ends of the high-frequency capacitor in the circuit layer in the horizontal direction overlaps with the projection of the semiconductor power device in the horizontal direction.

Preferably, the high-frequency high-power packaging module is characterized in that the plurality of semiconductor power devices are electrically connected in parallel, the high-frequency high-power packaging module further comprises a distributed vertical connecting piece, and each semiconductor power device is arranged adjacent to the corresponding vertical connecting piece.

Preferably, the distributed vertical connecting piece comprises a first vertical connecting piece and a second vertical connecting piece, the diameter of the first vertical connecting piece is larger than that of the second vertical connecting piece, and the first vertical connecting piece is arranged adjacent to the side face of the high-frequency high-power packaging module.

Preferably, the high-frequency high-power packaging module further comprises buffer outer pins, and the buffer outer pins are used for electrically connecting the high-frequency high-power packaging module with the client mainboard.

Preferably, the buffer outer pin is arranged on the second surface of the circuit layer.

Preferably, the buffer outer pin is arranged on the side edge of the circuit layer.

Preferably, the high-frequency high-power packaging module is characterized in that the inner side of the buffer outer pin is welded to the side edge of the circuit layer, and an insulating reinforcing frame is arranged on the outer side of the buffer outer pin.

Preferably, the high-frequency high-power packaging module is characterized by further comprising an elastic insulating fixing frame, and the elastic insulating fixing frame is used for enabling the high-frequency high-power packaging module to be tightly attached to a radiator arranged on the upper surface of the insulating heat-conducting plate.

Preferably, wherein the elastic insulating fixing frame comprises an elastic member and an insulating reinforcing frame, one end of the elastic member is connected to the radiator, the other end of the elastic member is inserted into the insulating reinforcing frame, and the insulating reinforcing frame limits the high-frequency high-power packaging module by means of the edge limiting structure.

Preferably, the elastic insulating fixing frame comprises an insulating reinforcing frame with an elastic material, the insulating reinforcing frame limits the high-frequency high-power packaging module through an edge limiting structure, and the insulating reinforcing frame is connected with the client mainboard and the radiator through the through-type fixing assembly.

Preferably, a mounting area is formed between the second surface of the circuit layer and the client mainboard, and at least one circuit element is arranged in the mounting area.

Preferably, the buffer outer pin is led out by means of the redistribution structure.

Preferably, the high-frequency high-power packaging module further comprises a second surface protection part, the second surface protection part comprises a shell, sealant and a filling body, the shell is fixed and covers the second surface of the circuit layer through the sealant, a filling body is filled between the shell and the second surface of the circuit layer, and the filling body can be silica gel or plastic packaging material;
the housing is provided with an outer pin through hole for buffering the extension of the outer pin.

Preferably, one end of the shell is fixedly connected with a radiator arranged on the upper surface of the insulating heat-conducting plate.

Preferably, the high-frequency high-power packaging module is provided with an extension area which is not covered by the second surface protection part in the horizontal direction, and a fixing hole for fixing is formed in the extension area.

Preferably, the high-frequency high-power packaging module is characterized in that the buffer outer pins are led out through a redistribution structure.

Preferably, the high-frequency high-power packaging module further comprises at least one copper column and at least one bonding pad, the copper column is embedded in the second surface protection part, and the bonding pad is arranged on the surface of the second surface protection part and is electrically connected with the copper column.

Preferably, the second surface protection part comprises at least one multiplexing bonding pad, the multiplexing bonding pad comprises at least one large deep sinking hole, at least one small via hole and at least one bonding pad, the large deep sinking hole is formed by recessing the surface of the second surface protection part facing the second surface of the circuit board, the bonding pad covers the surface of the large deep sinking hole and extends out of the large deep sinking hole, the small via hole is formed in the bottom of the large deep sinking hole and electrically connected with at least one bonding pad and a circuit board, and the multiplexing bonding pad is used for welding power pins.

Preferably, the buffer outer pin is one of a direct-insertion welding pin, a direct-insertion crimping pin, a surface contact crimping pin and a surface contact welding pin.

Preferably, a copper column is arranged below a front electrode of the semiconductor power device, and the height of the copper column is at least $30\mu m$.

Preferably, the high-frequency high-power packaging module is characterized in that the semiconductor power device has at least two different thicknesses, and copper columns or metal balls with different heights are arranged below the front electrode of the semiconductor power device.

Preferably, the high-frequency high-power packaging module is characterized in that the semiconductor power device has at least two different thicknesses, a copper column is arranged below the front electrode of at least one thicker semiconductor power device, and a metal ball is arranged below the front electrode of the at least one thinner semiconductor power device.

Preferably, the high-frequency high-power packaging module is characterized in that the front electrode of the semiconductor power device is a thick copper electrode formed by packaging, and the height of the thick copper electrode is at least $30\mu m$.

Preferably, a copper-clad layer is provided above a back electrode of the semiconductor power device.

Preferably, wherein the semiconductor power device has at least two different thicknesses, and the copper-clad layer above the back electrode of the semiconductor power device has a corresponding different thickness.

Preferably, the back electrode of the semiconductor power device is a copper-clad layered electrode formed by packaging.

Preferably, the high-frequency high-power packaging module is characterized in that a power electrode and a gate electrode are arranged on the back surface of at least one semiconductor chip, and the power electrode is connected to the electrostatic potential of the circuit.

Preferably, a gate electrode of the semiconductor power device is bonded to the circuit layer through an electrical connecting wire, and welding spots of the gate electrode are protected through glue dispensing treatment.

Preferably, the semiconductor power device is an LDMOS device with a substrate electric potential capable of being arranged, and the substrate electric potential is set as the electrostatic potential of the high-frequency high-power packaging module.

Preferably, the substrate of the LDMOS device is made of sapphire.

Preferably, at least one semiconductor power device comprises a normal-on third-generation semiconductor sub-power device and a low-voltage normal-off semiconductor sub-power device, the normal-on third-generation semiconductor sub-power device is cascaded with the low-voltage normal-off semiconductor sub-power device, and the normal-on third-generation semiconductor sub-power device and the low-voltage normal-off semiconductor sub-power device form a semiconductor power device in a laminated packaging mode.

Preferably, at least one semiconductor power device is a normal-on power device, the normal-on power device is provided with a low-voltage normal-off semiconductor power device in a matched mode, the normal-on power device is cascaded with the low-voltage normal-off semiconductor power device, the low-voltage normal-off semiconductor power device is arranged on the second surface of the circuit layer, and the setting position of the low-voltage normal-off semiconductor power device is perpendicular to the position of the normal-on power device.

Preferably, the high-frequency high-power packaging module is characterized in that a plurality of power conversion bridge arms are arranged in parallel, and the direct-current end external electrodes and the alternating-current end external electrodes of the power conversion bridge arms are arranged on the two sides of the high-frequency high-power packaging module respectively.

Preferably, the side edge of the plastic package body is in a step shape.

Preferably, the high-frequency high-power packaging module further comprises a client sub-board, the client sub-board being used for electrically connecting an external electrode to a client main board, the client sub-board and the circuit layer being arranged in parallel, and the client sub-board and the circuit layer being respectively perpendicular to the client main board.

Preferably, a direct-current end external electrode of the power conversion bridge arm is arranged on one side close to a client mainboard, an alternating-current end external electrode of the power conversion bridge arm is arranged on one side far away from the client mainboard, and an alternating-current end external electrode of the power conversion bridge arm is electrically connected with an external alternating-current device arranged on the client mainboard through a client sub-board.

Preferably, the high-frequency high-power packaging module is characterized in that the back electrodes of the two semiconductor power devices in each power conversion bridge arm are electrodes such as the two direct-current ends of the power conversion bridge arm respectively.

Preferably, the high-frequency high-power packaging module is characterized by further comprising a heat-conducting column, the heat-conducting column is arranged on the upper surface of the insulation heat-conducting plate, and the heat-conducting column is used for liquid cooling heat dissipation.

Preferably, the high-frequency high-power packaging module is characterized in that the area, perpendicular to the semiconductor power device, of the upper surface of the insulating heat-conducting plate is a first heat dissipation area, and the number density of the heat-conducting columns in the first heat dissipation area is larger than the set number density of the heat-conducting column outside the first heat dissipation area.

Preferably, the high-frequency high-power packaging module is characterized in that the heat-conducting column comprises a metal shell and an ultrahigh heat-conducting filler, the ultrahigh heat-conducting filler is arranged in the metal shell, and the ultrahigh heat-conducting filler is a carbon fiber tube, a graphene sheet or a phase change liquid.

Preferably, the high-frequency high-power packaging module comprises at least one power conversion bridge arm, at least one high-frequency capacitor, an insulating heat-conducting plate, an electrical connection device, a plastic package body, a cross-ceramic layer electrical connection assembly and a common-mode suppression capacitor;

the power conversion bridge arm comprises at least two semiconductor power devices connected in series;
the high-frequency capacitor and the power conversion bridge arm are connected in parallel;
the insulating heat-conducting plate comprises an insulating heat-conducting layer, and an upper metal layer and a lower metal layer which are respectively arranged on the upper surface and the lower surface of the insulating heat-conducting layer;
at least one electrode on the front surface of the semiconductor power device is led out to the outside of the high-frequency high-power packaging module through the electrical connecting device and is electrically connected with at least one electrode of the high-frequency capacitor;
the plastic package body fills a gap area between the front surface of the semiconductor power device and the upper surface of the insulating heat-conducting plate;
one electrode of the common-mode suppression capacitor is electrically connected with the upper metal layer through a cross-ceramic layer electrical connection assembly, and the other electrode of the common-mode suppression capacitor is electrically connected with one direct-current end of the power conversion bridge arm;
the back surface of the semiconductor power device is thermally connected with or electrically connected with the lower surface of the insulating heat-conducting;

Preferably, the high-frequency high-power packaging module is characterized by further comprising a radiator;

the high-frequency high-power packaging module is mounted on the radiator, the upper surface of the insulating heat-conducting plate is thermally connected with the radiator, and the electric potential of the radiator is the ground;
the common-mode suppression capacitor is used for suppressing the current flowing through the radiator to the ground due to the jump of the AC voltage of the bridge arm.

Preferably, the common-mode suppression capacitor is arranged in the gap area, the at least one semiconductor power device is a first power device, the back electrode of the first power device is electrically connected with one direct-current end of the power conversion bridge arm and the like, one electrode of the common-mode suppression capacitor is electrically connected with the upper metal layer through the cross-ceramic layer electric connection assembly, and the other electrode of the common-mode suppression capacitor is electrically connected with the back electrode of the first power device through a lower metal layer.

Preferably, the cross-ceramic layer electrical connecting assembly comprises one side edge electrical interconnection piece, the side edge electrical interconnection piece is arranged on the side edge of the insulation heat-conducting plate, one end of the side edge electrical interconnection piece is electrically connected with the upper metal layer, and the other end of the side edge electrical interconnection piece is electrically connected with the common mode suppression capacitor through a lower metal layer.

Preferably, the cross-ceramic layer electrical connecting assembly comprises a through-type electrical interconnection piece, the through-type electrical interconnection piece penetrates through the insulating heat-conducting layer, one end of the through-type electrical interconnection piece is electrically connected with the upper metal layer, and the other end of the through-type electrical interconnection piece is electrically connected with the common mode suppression capacitor through a lower metal layer.

Preferably, the cross-ceramic layer electrical connection assembly comprises a conductive coating, the conductive coating is arranged on the side edge of the insulating heat-conducting layer and the adjacent area of the upper surface and the lower surface of the insulating heat-conducting layer, one end of the conductive coating is electrically connected with the upper metal layer, and the other end of the conductive coating is electrically connected with the common-mode suppression capacitor.

Preferably, the electrical connecting device is a circuit layer, the circuit layer comprises a first surface, an inner-layer electrical connecting layer, a second surface and a vertical electrical connection path, and the inner-layer electrical connection layer is electrically connected with the first surface through at least one vertical electrical connection path;

the plastic package body fills a gap area between the second surface of the circuit layer and the upper surface of the insulating heat-conducting plate, an external electrode is arranged on the second surface or the side edge of the circuit layer, and the external electrode is electrically connected with the power conversion bridge arm;

the front surface of the semiconductor power device is electrically connected with the first surface of the circuit layer, and the back surface of the semiconductor power device is thermally connected with or electrically connected with the lower surface of the insulating heat-conducting plate;

the high-frequency capacitor is electrically connected with the first surface of the circuit layer or the second surface of the circuit layer or the lower surface of the insulating heat-conducting plate, and at least one electrode of the high-frequency capacitor is electrically connected with at least one electrode of the at least one semiconductor power device through the inner-layer electrical connection layer.

A high-frequency high-power packaging module comprises at least one power conversion bridge arm, at least one high-frequency capacitor, an insulating heat-conducting plate, an electrical connection device, a plastic package body and an external electrode;

the power conversion bridge arm comprises at least two semiconductor power devices connected in series;

the high-frequency capacitor and the power conversion bridge arm are connected in parallel;

the insulating heat-conducting plate comprises an insulating heat-conducting layer, and an upper metal layer and a lower metal layer which are respectively arranged on the upper surface and the lower surface of the insulating heat-conducting layer;

at least one electrode on the front surface of the semiconductor power device is led out to the outside of the high-frequency high-power packaging module through the electrical connecting device and is electrically connected with at least one electrode of the high-frequency capacitor;

the plastic package body fills a gap area between the front surface of the semiconductor power device and the upper surface of the insulating heat-conducting plate;

the external electrode comprises at least one pair of direct current end external electrodes, at least one pair of alternating current end external electrodes and at least one pair of signal end external electrodes;

the back surface of the semiconductor power device is thermally connected or electrically connected to the lower surface of the insulating heat-conducting plate;

a plurality of power conversion bridge arms are arranged in parallel, and a direct-current end external electrode and an alternating-current end external electrode of the power conversion bridge arm are arranged on the two sides of the high-frequency high-power packaging module respectively;

the signal end external electrode is disposed between the direct-currnet end external electrode and the alternating-current end external electrode.

Preferably, the minimum distance between the signal end external electrode and the direct-current end external electrode is larger than 4 mm, and the minimum distance between the signal end external electrode and the alternating-current end external electrode is larger than 4 mm.

Preferably, the high-frequency high-power packaging module is characterized in that the signal end external electrodes are in a multi-pin strip which is prefabricated and formed..

Preferably, the multi-pin strip is inserted into a flexible PCB flat wire.

Preferably, the electrical connecting device is a circuit layer, the circuit layer comprises a first surface, an inner-layer electric connectional layer, a second surface and a vertical electrical connection path, and the inner-layer electrical connection layer is electrically connected with the first surface through at least one vertical electrical connection path;

the plastic package body fills a gap area between the second surface of the circuit layer and the upper surface of the insulating heat-conducting plate, an external electrode is arranged on the second surface or the side edge of the circuit layer, and the external electrode is electrically connected with the power conversion bridge arm;
the front surface of the semiconductor power device is electrically connected with the first surface of the circuit layer, and the back surface of the semiconductor power device is thermally connected with or electrically connected with the lower surface of the insulating heat-conducting plate;
the high-frequency capacitor is electrically connected to a first surface of the circuit layer or a second surface of the circuit layer or a lower surface of the insulating heat-conducting plate, and at least one electrode of the high-frequency capacitor is electrically connected to at least one electrode of the at least one semiconductor power device by means of the inner-layer electric connection layer.

The manufacturing method of the high-frequency high-power packaging module of claim 1 comprises the following steps:

Providing the circuit layer and the insulating heat-conducting plate;
Arranging the high-frequency capacitor on a circuit layer or an insulating heat-conducting plate;
Welding the semiconductor power device on the circuit layer;
Providing the insulating heat-conducting plate above the semiconductor power device;
And plastic packaging the gap area to form the plastic package body, wherein the upper surface of the insulating heat-conducting plate is exposed.

A manufacturing method for the high-frequency high-power packaging module, characterized in that the method comprises:

Providing the circuit layer and the insulating heat-conducting plate;
Arranging the high-frequency capacitor on a circuit layer or an insulating heat-conducting plate;
Welding the semiconductor power device on the circuit layer;
Pre-molding an area between the semiconductor power device and a first surface of the circuit layer to form the thermal resistance electrical connection layer;
Providing the insulating heat-conducting plate above the semiconductor power device;
And plastic packaging the gap region to form the plastic package body, the upper surface of the insulating heat-conducting plate being exposed.

The manufacturing method of the high-frequency high-power packaging module comprises the following steps:

Providing the circuit layer and the insulating heat-conducting plate;
Arranging the high-frequency capacitor on a circuit layer;
Welding the semiconductor power device on the circuit layer;
Plastic packaging the circuit layer and the semiconductor power device to form a first plastic package body, the upper surface of the semiconductor power device being exposed;
Providing the insulating heat-conducting plate on an upper surface of the semiconductor power device;
And plastic packaging the insulating heat conducting plate to form a second plastic packaging body, wherein the upper surface of the insulating heat conducting plate is exposed.

A manufacturing method of the high-frequency high-power packaging module comprises the following steps:

Providing the insulating heat-conducting plate and the circuit layer pre-provided with a circuit board through hole;
The buffer outer pin is fixedly and electrically arranged in the circuit board through hole, so that the external electrode is electrically connected with the first surface and/or the inner layer electrical connection layer and/or the second surface of the circuit layer respectively, and the buffer outer pin extends out of the second surface of the circuit layer;
Arranging the high-frequency capacitor on a circuit layer or an insulating heat-conducting plate;
Welding the semiconductor power device on the circuit layer;
Providing the insulating heat-conducting plate above the semiconductor power device;
And plastic packaging the gap region to form the plastic package body, the upper surface of the insulating heat-conducting plate being exposed.

The manufacturing method of the high-frequency high-power packaging module, the high-frequency high-power packaging module comprises:

Providing the circuit layer and the insulating heat-conducting plate;
Providing a support platform;
Providing solder and the semiconductor power device on a first surface of the circuit layer;
Placing a second surface of the circuit layer on a support platform;
Providing solder and the insulating heat-conducting plate above the semiconductor power device;
A heating flat plate is placed on the upper surface of the insulating heat conducting plate for heating to complete welding.
A high-frequency high-power packaging module, characterized by comprising a hybrid substrate, at least one power conversion bridge arm, at least one high-frequency capacitor, a circuit layer and a plastic package body;
The hybrid substrate comprises a high heat-conducting area and a low heat-conducting area; the hybrid substrate is provided with an upper surface and a lower surface which are opposite to each other;
The high heat-conducting region and the low heat-conducting region are arranged in a horizontal direction;
The high heat-conducting region is used for arranging a heating semiconductor device, and the heating semiconductor device is specifically arranged on the lower surface;
The heat-conducting coefficient of the high heat-conducting region is greater than the heat-conducting coefficient of the low heat-conducting region;
The upper surface of the hybrid substrate is used for assembling a heat dissipation device;
The hybrid substrate further comprises an upper metal layer and a lower metal layer which are respectively arranged on the upper surface and the lower surface, and the high heat-conducting area and the low heat-conducting area are made of insulating materials;
The power conversion bridge arm comprises at least two semiconductor power devices connected in series;
The high-frequency capacitor and the power conversion bridge arm are connected in parallel to form a high-frequency loop;
The circuit layer comprises a first surface, an inner-layer electrical connection layer, a second surface and a vertical electrical connection path, and the inner-layer electrical connection layer is electrically connected with the first surface through at least one vertical electrical connection path;
The plastic package body fills a gap area between the second surface of the circuit layer and the upper surface of the hybrid substrate, an external electrode is arranged on the second surface or the side edge of the circuit layer, and the external electrode is electrically connected with the power conversion bridge arm;
The front surface of the semiconductor power device is electrically connected with the first surface of the circuit layer, and the back surface of the semiconductor power device is thermally connected with or electrically connected with the lower metal layer corresponding to the high-heat-conductivity area;
The high-frequency capacitor is electrically connected to a first surface of the circuit layer or a second surface of the circuit layer or a lower surface of the hybrid substrate, and at least one electrode of the high-frequency capacitor is electrically connected to at least one electrode of the at least one semiconductor power device by means of the inner-layer electrical connection layer.

A high-frequency high-power packaging module is characterized by comprising at least three semiconductor power devices and a driver;

the semiconductor power device is provided on the same plane;
the driver provides a drive signal for each of the semiconductor power devices, and a projection of the plane overlaps with a projection of each of the semiconductor power devices on the plane.

Preferably, the high-frequency high-power packaging module further comprises a circuit layer, wherein the circuit layer comprises a first surface and a second surface which are opposite to each other; the semiconductor power device is arranged on the first surface, and the driver is arranged on the second surface.

Preferably, the wiring distance from each semiconductor power device to the corresponding driving signal end of the driver is the same.

Preferably, the high-frequency high-power packaging module further comprises at least one high-frequency capacitor, an insulating heat-conducting plate and a plastic package body;

the insulating heat-conducting plate comprises an insulating heat-conducting layer, and an upper metal layer and a lower metal layer which are respectively arranged on the upper surface and the lower surface of the insulating heat-conducting layer;

the plastic package body fills a gap area between the second surface of the circuit layer and the upper surface of the insulating heat-conducting plate, an external electrode is arranged on the second surface or the side edge of the circuit layer, and the external electrode is electrically connected with the power conversion bridge arm;

the front surface of the semiconductor power device is electrically connected with the first surface of the circuit layer, and the back surface of the semiconductor power device is thermally connected with or electrically connected with the lower surface of the insulating heat-conducting plate;

the high-frequency capacitor and the power conversion bridge arm are connected in parallel to form a high-frequency loop, the high-frequency capacitor is electrically connected with the first surface of the circuit layer or the second surface of the circuit layer or the lower surface of the insulating heat-conducting plate, and at least one electrode of the high-frequency capacitor is electrically connected with at least one electrode of the at least one semiconductor power device through the inner-layer electrical connection layer;

the wiring distances from each of the semiconductor power devices to the corresponding driving signal ends of the driver are the same.

A hybrid substrate comprises a high-heat-conducting area and a low-heat-conducting area, wherein the hybrid substrate is provided with an upper surface and a lower surface which are opposite to each other;

the high heat-conducting region and the low heat-conducting region are arranged in a horizontal direction;
the high heat-conducting region is used for arranging a heating semiconductor device, and the heating semiconductor device is specifically arranged on the lower surface;
the heat-conducting coefficient of the high heat-conducting region is greater than the heat-conducting coefficient of the low heat-conducting region;;
the upper surface of the hybrid substrate is used for assembling a heat dissipation device.

Preferably, wherein the thermal conductivity of the high thermal conductivity region is greater than twice the thermal conductivity of the low-heat-conducting region.

Preferably, the high-heat-conducting area is a high-heat-conducting particle array, or the high-heat-conducting area is a mixture of a high-heat-conducting particle array and a low-heat-conducting material.

Preferably, the hybrid substrate further comprises an upper metal layer and a lower metal layer respectively arranged on the upper surface and the lower surface, wherein the material of the high heat-conducting region and the material of the low heat-conducting region are both insulating materials.

A high-frequency high-power packaging module, the high-frequency high-power packaging module is characterized by comprising at least one power conversion bridge arm, a circuit layer, an insulating heat-conducting plate and a packaging body;

the power conversion bridge arm comprises at least two semiconductor power devices connected in series;
the high-frequency capacitor and the power conversion bridge arm are connected in parallel to form a high-frequency loop;
the circuit layer comprises a first surface, an inner-layer electrical connection layer, a second surface and a vertical electrical connection path, and the inner-layer electrical connection layer is electrically connected with the first surface through at least one vertical electrical connection path;
the plastic package body fills a gap area between the second surface of the circuit layer and the upper surface of the hybrid substrate, an external electrode is arranged on the second surface or the side edge of the circuit layer, and the external electrode is electrically connected with the power conversion bridge arm;
the front surface of the semiconductor power device is electrically connected with the first surface of the circuit layer, and the back surface of the semiconductor power device is thermally connected with or electrically connected with the lower metal layer corresponding to the high-heat-conductivity area;
The high-frequency capacitor is electrically connected to a first surface of the circuit layer or a second surface of the circuit layer or a lower surface of the hybrid substrate, and at least one electrode of the high-frequency capacitor is electrically connected to at least one electrode of the at least one semiconductor power device by means of the inner-layer electrical connection layer;
A high-frequency high-power packaging module comprises the hybrid substrate, at least one power conversion bridge arm and a heat-conducting column;
the at least one power conversion bridge arm comprises at least two semiconductor power devices connected in series, and the semiconductor power device is arranged on a lower metal layer corresponding to the high heat-conducting area;
the heat-conducting column is arranged on an upper metal layer of the hybrid substrate;
at least one part of the heat-conducting column is arranged on the upper metal layer corresponding to the high heat-conducting area.

Preferably, at least another part of the heat-conducting column is arranged on the upper metal layer corresponding to the low heat-conducting area, and the number density of the heat-conducting column in the high heat-conducting area is larger than the setting number density of the heat-conducting column in the low heat-conducting area.

Preferably, the high-frequency high-power packaging module is characterized by further comprising at least one high-frequency capacitor, a circuit layer and a plastic package body;

the high-frequency capacitor and the power conversion bridge arm are connected in parallel to form a high-frequency loop;

the circuit layer comprises a first surface, an inner-layer electrical connection layer, a second surface and a vertical electrical connection path, and the inner-layer electrical connection layer is electrically connected with the first surface through at least one vertical electrical connection path;

the plastic package body fills a gap area between the second surface of the circuit layer and the upper surface of the hybrid substrate, an external electrode is arranged on the second surface or the side edge of the circuit layer, and the external electrode is electrically connected with the power conversion bridge arm;

the front surface of the semiconductor power device is electrically connected with the first surface of the circuit layer, and the back surface of the semiconductor power device is thermally connected with or electrically connected with the lower surface of the hybrid substrate;

The high-frequency capacitor is electrically connected to a first surface of the circuit layer or a second surface of the circuit layer or a lower surface of the hybrid substrate, and at least one electrode of the high-frequency capacitor is electrically connected to at least one electrode of the at least one semiconductor power device by means of the inner-layer electrical connection layer.

A high-frequency high-power packaging module comprises at least one power conversion bridge arm, a multi-layer circuit board, an insulating heat-conducting plate and a plastic package body;

the power conversion bridge arm comprises at least two semiconductor power devices connected in series;

the multi-layer circuit board comprises a first surface and a second surface which are opposite to each other, an inner-layer electrical connection layer, at least two low-circuit bonding pads and a vertical electrical connection path, and the inner-layer electrical connection layer is electrically connected with the first surface through at least one vertical electrical connection path;

the insulating heat-conducting plate comprises an insulating heat-conducting layer and an upper surface and a lower surface which are opposite to each other;

the plastic package body fills a gap area between the second surface of the multilayer circuit board and the upper surface of the insulating heat-conducting plate, an external electrode is arranged on the second surface or the side edge of the multilayer circuit board, and the external electrode is electrically connected with the power conversion bridge arm;

the front surface of the semiconductor power device is electrically connected with the first surface of the multilayer circuit board, and the back surface of the semiconductor power device is thermally connected with or electrically connected with the lower surface of the insulating heat-conducting plate;

wherein the multi-layer circuit board is used for coupling two direct-current electrodes of the power conversion bridge arm to two corresponding low-circuit bonding pads through a first surface and an inner-layer electrical connection layer, and the low-circuit bonding pad is used for being electrically connected with a high-frequency capacitor to form a low-loop circuit.

Preferably, the at least two low-circuit bonding pads are arranged on the second surface of the multi-layer circuit board, and the second surface is further provided with a power pin and a signal pin.

Preferably, the second surface of the circuit board is electrically connected with one surface of a client mainboard, the other surface of the client mainboard is provided with a high-frequency capacitor, and the high-frequency capacitor is electrically connected with the low-circuit bonding pad through a client mainboard.

Preferably, the upper surface of the insulating heat-conducting plate is thermally connected with a heat dissipation device, and the heat dissipation device is assembled with a client mainboard through at least one fixing column.

Preferably, wherein the electric potential of at least 80% of the area of the back surface of the semiconductor power device is the electrostatic potential of the high-frequency high-power packaging module.

According to the high-frequency high-power packaging module, the heat dissipation capacity is guaranteed, meanwhile, the loop inductance is greatly reduced, high-power high-frequency is achieved, the advantages of the third-generation semiconductor are fully exerted, and an application basis is provided for upgrading of the performance of the third-generation semiconductor.

## DESCRIPTION OF DRAWINGS

In order to more clearly illustrate the embodiments of the present application or the technical solutions in the prior art, the drawings required in the description of the embodiments or the prior art are briefly described below. It is obvious that the drawings in the following description are merely some embodiments of the present application, and for a person of ordinary skill in the art, other drawings may be obtained according to these drawings without creative efforts.

FIG. 1 is a schematic diagram of a third-generation semiconductor packaging structure in the prior art;

FIG. 2A to FIG. 2I are schematic structural diagrams of a high-frequency high-power packaging module according to an embodiment of the present application;

FIG. 3A to FIG. 3C are schematic structural diagrams of a high-frequency high-power packaging module according to another embodiment of the present application;

FIG. 4A to FIG. 4C are schematic structural diagrams of a high-frequency high-power packaging module according to another embodiment of the present application;

FIG. 4D to FIG. 4E are schematic structural diagrams of a high-frequency high-power packaging module according to another embodiment of the present application;

FIG. 5A is a schematic structural diagram of a high-frequency high-power packaging module according to an embodiment of the present application;

FIG. 5B is an equivalent circuit diagram of a high-frequency high-power packaging module according to an embodiment of the present application;

FIG. 5C to FIG. 5E are schematic structural diagrams of packaging modules of semiconductor power devices with different thicknesses;

FIG. 5F is an equivalent circuit diagram of a high-frequency high-power packaging module according to an embodiment of the present application;

FIG. 5G to FIG. 5J are schematic structural diagrams of a high-frequency high-power packaging module with a thermally conductive column;

FIG. 5K is a schematic structural diagram of a high-frequency high-power packaging module with a driver;

FIG. 5L is a schematic structural diagram of a high-frequency high-power packaging module according to another embodiment of the present application;

FIG. 6 is another schematic structural diagram of a high-frequency high-power packaging module according to an embodiment of the present application;

FIG. 7A to FIG. 7E are schematic structural diagrams of a high-frequency capacitor, a multi-layer circuit board, a power conversion bridge arm and an insulating heat-conducting plate of a high-frequency high-power packaging module at different heights according to an embodiment of the present application;

FIG. 8A to FIG. 8F are schematic flow diagrams of a method for manufacturing a high-frequency high-power packaging module according to an embodiment of the present application;

FIG. 9 is a schematic structural diagram of a high-frequency high-power packaging module according to another embodiment of the present application;

FIG. 10 is a schematic structural diagram of an electrode arrangement mode of a semiconductor power device of a high-frequency high-power packaging module according to an embodiment of the present application;

FIG. 11 is a schematic structural diagram of a high-frequency high-power packaging module provided with a high-heat-capacity element according to an embodiment of the present application;

FIG. 12A to FIG. 12D are schematic structural diagrams when a buffer outer pin of a high-frequency high-power packaging module is arranged on a second surface of a multi-layer circuit board according to an embodiment of the present application;

FIG. 13A to FIG. 13D are schematic structural diagrams when the buffer outer pins of the high-frequency high-power packaging module are arranged on the side edges of the multi-layer circuit board according to the embodiment of the application;

FIG. 13E to FIG. 13F are schematic structural diagrams of other arrangement modes of buffer outer pins of the high-frequency high-power packaging module disclosed by the embodiment of the application;

FIG. 14A to FIG. 14E are schematic flow diagrams of a method for manufacturing a buffer outer pin of a high-frequency high-power packaging module according to an embodiment of the present application;

FIG. 15A to FIG. 15D are schematic structural diagrams of a buffer outer pin of a high-frequency high-power packaging module being led out by means of a redistribution structure according to an embodiment of the present application;

FIG. 16A is a schematic structural diagram of a packaged component of a high-frequency high-power packaging module directly SMD to a second surface of a multi-layer circuit board for a high-frequency high-power packaging module according to an embodiment of the present application;

FIG. 16B is a schematic structural diagram of performing whole-surface plastic packaging after elements are placed on a second surface of a multilayer circuit board of a high-frequency high-power packaging module and are interconnected;

FIG. 16C is a schematic structural diagram of fixing and protecting a second surface of a multi-layer circuit board of a high-frequency high-power packaging module and then fixing and protecting the second surface of the multi-layer circuit board of the high-frequency high-power packaging module by using a COB process according to an embodiment of the application;

FIG. 16D to FIG. 16F are schematic structural diagrams when a high-frequency high-power packaging module is provided with a second surface protection member according to an embodiment of the present application;

FIG. 17A to FIG. 17E are schematic structural diagrams of a double-sided plastic package adopted by the high-frequency high-power packaging module disclosed by the embodiment of the application;

FIG. 18 is a schematic structural diagram of an electrode arrangement mode of a semiconductor power device of a high-frequency high-power packaging module according to an embodiment of the present application;

FIG. 19A is an equivalent circuit diagram when a semiconductor power device of a high-frequency high-power packaging module disclosed by the embodiment of the application comprises a normal-on third-generation semiconductor sub-power device and a low-voltage normal-off semiconductor sub-power device;

FIG. 19B to FIG. 19D are schematic structural diagrams when a semiconductor power device of a high-frequency high-power packaging module comprises a normal-on third-generation semiconductor sub-power device and a low-voltage normal-off semiconductor sub-power device according to an embodiment of the present application;

FIG. 20A is an equivalent circuit diagram when a high-frequency high-power packaging module is provided with a plurality of power conversion bridge arms according to an embodiment of the present application;

FIG. 20B to FIG. 20D are schematic structural diagrams of a PIN surface when a high-frequency high-power packaging module is provided with a plurality of power conversion bridge arms according to an embodiment of the present application;

FIG. 21A to FIG. 21B are schematic structural diagrams of a side edge of a plastic package body of a high-frequency high-power packaging module being step-shaped according to an embodiment of the present application;

FIG. 22A to FIG. 22B are schematic structural diagrams of an electrical insulation pin bracket of a high-frequency high-power packaging module according to an embodiment of the present application;

FIG. 23 is a schematic structural diagram of a high-frequency high-power packaging module when the high-frequency high-power packaging module is mounted perpendicular to a client mainboard according to an embodiment of the present application;

FIG. 24A to FIG. 24D are schematic diagrams of heat dissipation conditions of a high-frequency high-power packaging module according to an embodiment of the present application;

FIG. 25A to FIG. 25E are schematic flow diagrams of a secondary packaging process of a high-frequency high-power packaging module according to an embodiment of the present application;

FIG. 26A to FIG. 26C are schematic diagrams of preventing electromagnetic interference of a high-frequency high-power packaging module according to an embodiment of the present application;

FIG. 27A to FIG. 27C are schematic diagrams of suppressing common mode noise of a high-frequency high-power packaging module according to an embodiment of the present application;

FIG. 27D to FIG. 27G are schematic structural diagrams of a common-mode suppression capacitor of a high-frequency high-power packaging module according to an embodiment of the present application;

FIG. 28A to FIG. 28D are schematic flow diagrams of another manufacturing method of a high-frequency high-power packaging module according to an embodiment of the present application.

FIG. 29A to FIG. 29C are schematic structural diagrams of a high-frequency high-power packaging module according to another embodiment of the present application.

1 high-frequency capacitor; 2 multilayer circuit board; 3 insulating heat-conducting layer; 3a hybrid substrate; 4 upper metal layer; 5 lower metal layer; 6 radiator; 7/70 plastic package; 8 client mainboard; 9 electrical insulation sheet; 10 conductive assembly; 11 external electrode; 12 thermal resistance electrical connection layer; 13 high-heat-capacity element; 14 buffer outer pin; 15 insulation fixing frame; 16 metal elastic piece; 17 circuit board through hole; 18 rewiring structure; 19 shell; 20 sealant; 21 filling body; 22 client sub-board; 23 high-frequency decoupling capacitor; 24 common-mode suppression capacitor; 25 cross-ceramic layer electrical connection assembly; 26 side edge electrical interconnection piece; 27 through-type electrical interconnection piece; 28 conductive coating; 29 supporting platform; 30 heating flat plate; 31 low-circuit pad; 32 fixing column; 101 bonding material; 102 bonding wire; 103 vertical connector; 104 electrochemical metal hole; 105 metal conductive bridge; 106 protruding structure; 107 shielding layer; 108 large-diameter vertical guide piece; 110 gate bonding wire; 111 source bonding wire; 112 power bonding wire; 121 electrical connection hole; 130 vertical electrical connection path; 131/132 protruding structure; 133 thermal conductive/conductive interconnect material; 134 metal ball; 135 heat-conducting column; 135a heat-conducting column top end; 135b heat-conducting column bottom end; 136 flow-guiding device; 137 high-heat-conducting region; 138 low-heat-conducting region; 139 gate electrode lead; 141 ceramic material; 142 high-heat-conducting electrically insulating particles; 143 metal shell; 144 high-heat-conducting interconnection; 145 ultra-high thermal conductivity filler; 151 fixing frame; 200 switching element; 201 first surface of the multilayer circuit board; 202 second surface of the multilayer circuit board; 301 upper surface of the insulating heat conduction layer; 302 lower surface of the insulating heat conduction layer; 400 electrode; 601 mounting hole; 602 copper column; 603 bonding pad; 611 large deep counter bore; 612 small via hole; 621 power pin; 622 signal pin; 631 copper column; 632 copper-clad layered electrode; 641/642 area; 643 electric insulation pin bracket; 644 heat-conducting electrically insulating material; A/B/C pin position; Bottom semiconductor power device front surface; C1/C2 capacitor; Cbus capacitor; Ccer ceramic equivalent capacitor; Cth distribution capacitor; Cy1 integrated Y capacitor; Cy2 integrated Y capacitor; D1-D4 vertical connecting piece; DBC insulating heat-conducting plate; Drain drain electrode; Driver driver; Gate/G1-G4 gate electrode; H1 the distance between the first surface and the Top surface; H2 the distance between the first surface and the lower surface; H3, the distance between the first surface and the upper surface; H4, the distance between the second surface and the lower surface; HC height of high-frequency capacitor; Icom common-mode current; L1 module thickness; L2 insulation distance; L3 air gap; Line_g wiring ground; Lloop loop parasitic inductor; Lth distribution inductor; Q1/Q2/Q3/Q4/Q1-1/Q1-2/Q1-3/Q2-1/Q2-2/Q2-3 semiconductor power device; Q10 a power semiconductor wafer with a high thermal density; Rin damping; Rth contact resistance; Source/S1-S4 source electrode; Top semiconductor power device back; V1-V4 vertical connection; x mode group length on-axis; y module width on-axis; z module height on-axis.

## DETAILED DESCRIPTION

By combining the drawings in the embodiment of the application, the technical scheme in the embodiment of the application is clear, it is obvious that the described embodiments are only a part but not all of the embodiments of the present application. All other embodiments obtained by a person of ordinary skill in the art based on the embodiments of the present application without creative efforts shall fall within the protection scope of the present application.

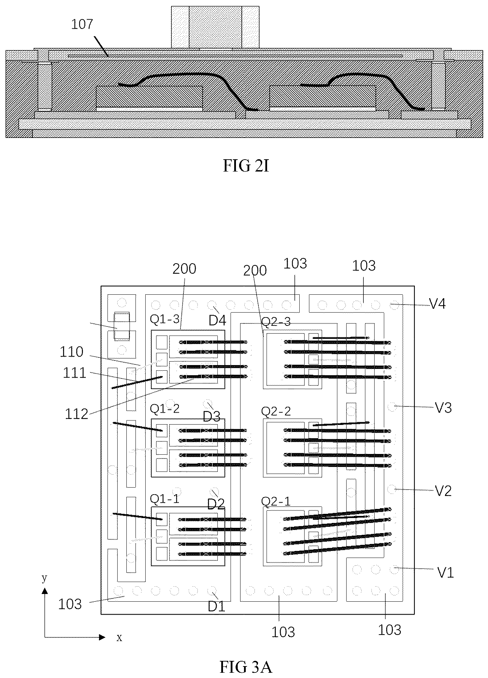

As shown in FIG. 2A, the embodiment of the application discloses a high-frequency high-power packaging module which comprises a multi-layer circuit board 2, an insulating heat-conducting plate, a plastic package body 7, at least one power conversion bridge arm and at least one high-frequency capacitor 1; the multilayer circuit board 2, namely the circuit layer, is not limited to an independent multilayer circuit board, can also refer to a wiring layer of the multilayer circuit, can also be a wiring layer with the same function formed in the module process, and refers to a multilayer circuit board; the X axis and the Y axis represent the length direction and the width direction of the module, the X axis and the Y axis form the horizontal plane of the module, and the Z axis represents the height of the module.

The power conversion bridge arm comprises at least two semiconductor power devices Q1 and Q2 connected in series, and the high-frequency capacitor 1 is connected in parallel with the power conversion bridge arm to form a high-frequency loop. At least one power conversion bridge arm is arranged on the insulation heat-conducting plate, and the plastic package body 7 fills a gap area between the multilayer circuit board and the insulation heat-conducting plate.

The front faces of the semiconductor power devices Q1 and Q2 are electrically connected with the multi-layer circuit board, and the back faces of the semiconductor power devices Q1 and Q2 are in thermally connected or electrically and thermally connecting with the lower surface of the insulating heat-conducting plate.

In the projection direction, the multilayer circuit board at least partially overlaps with the semiconductor power devices Q1 and Q2 of the high-frequency loop to which the multilayer circuit board belongs.

As shown in FIG. 2A, the semiconductor power device is bonded to the insulating heat-conducting plate DBC through the bonding material 101, the front electrode of the semiconductor power device is electrically connected with the wiring layer of the insulating heat-conducting plate in a bonding wire 102 mode, the multi-layer circuit board 2 is stacked on the insulating heat-conducting plate, the multi-layer circuit board 2 is provided with the high-frequency capacitor 1. The insulating heat-conducting plate can be a direct bonding copper-clad plate (DBC for short), comprises an insulating heat-conducting layer 3, an upper metal layer 4 and a lower metal layer 5, wherein the upper metal layer 4 is arranged on the upper surface of the insulating heat-conducting layer 3, the lower metal layer 5 is arranged on the lower surface of the insulating heat-conducting layer 3, and the insulating heat-conducting plate can be a ceramic insulating plate or a printed circuit board. The multi-layer circuit board 2 and the insulating heat-conducting plate are electrically connected through the vertical connector 103. Mechanical connection and electrical insulation are achieved between the multi-layer circuit board 2 and the insulating heat-conducting plate through plastic packaging materials 7, and the environment protection capability is effectively improved. The bonding material 101 provided by the embodiment of the application comprises but is not limited to a sintering material such as brazing filler metal, silver or copper, and the material of the upper metal layer 4 and the lower metal layer 5 of the embodiment of the application is copper.

As shown in FIG. 2B, on the current loop of the high-frequency capacitor 1, the current passing through the adjacent vertical connectors 103 is reversely set, so that the loop inductance can be controlled to be at a lower level.

In other embodiments, as shown in FIG. 2C, the electrical connection between the insulating heat-conducting plate and the multi-layer circuit board 2 can also be realized by means of the electrochemical metal hole 104.

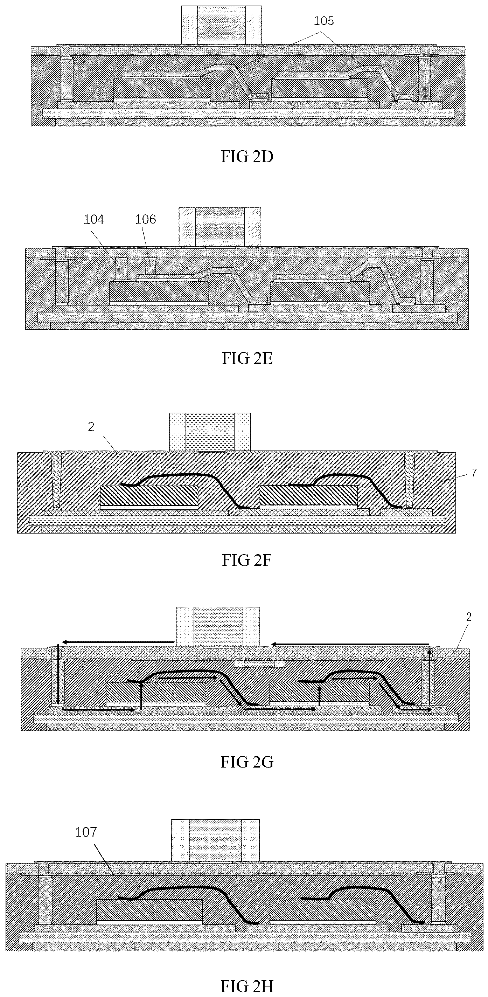

As shown in FIG. 2D, the front electrode of the semiconductor power device is interconnected with the multi-layer circuit board 2 through the metal conductive bridge 105, and compared with the bonding wire 102, the metal conductive bridge 105 can have smaller connection impedance. A connecting material between the metal conductive bridge 105 and the semiconductor power device includes, but is not limited to, a sintered material such as brazing filler metal, silver, or copper.

As shown in FIG. 2E, the front electrode of the semiconductor power device can be directly connected with the multi-layer circuit board 2 through the vertical connector 103, and can also be directly interconnected with the multi-layer circuit board through the protruding structure 106 arranged on the metal guide bridge.

As shown in FIG. 2F, the multi-layer circuit board 2 can be electroplated and etched on the surface of the plastic package 7, so that the material matching requirement is reduced, and the reliability is improved.

As shown in FIG. 2G, the multilayer circuit board 2 can be placed components on both sides to integrate more functions.

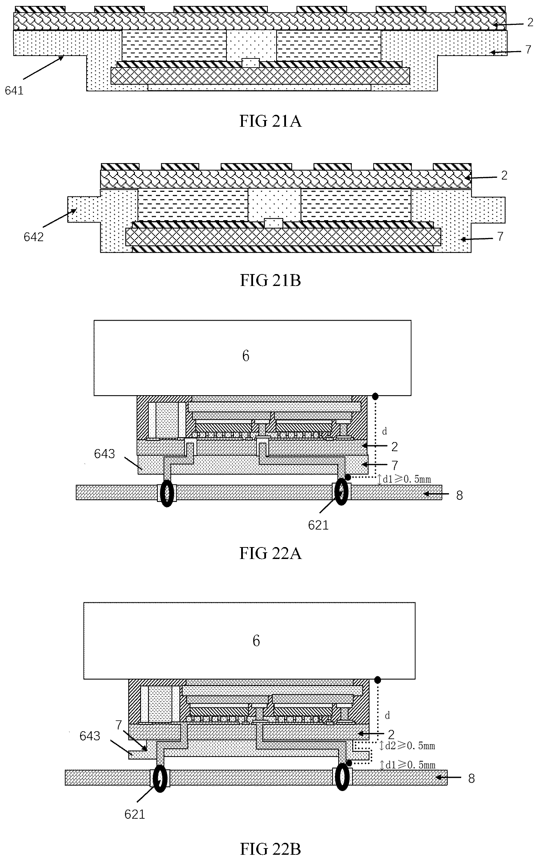

In some other embodiments, as shown in FIG. 2H, a shielding layer 107 is provided in an envelope region of a high-frequency loop comprising of a high-frequency capacitor 1 and a semiconductor power device, and the shielding layer 107 may be connected to a fixed electric potential. As shown in FIG. 21, the shielding layer 107 may also not be connected to the remaining electric potentials, for example, the shielding layer 107 is disposed inside the multilayer circuit board. According to the embodiment, the parasitic inductance of the loop can be further reduced by arranging the shielding layer 107.

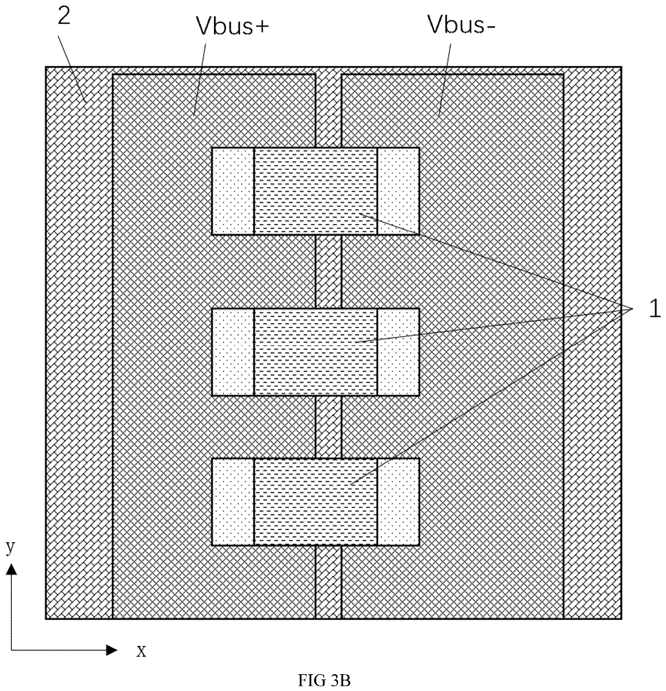

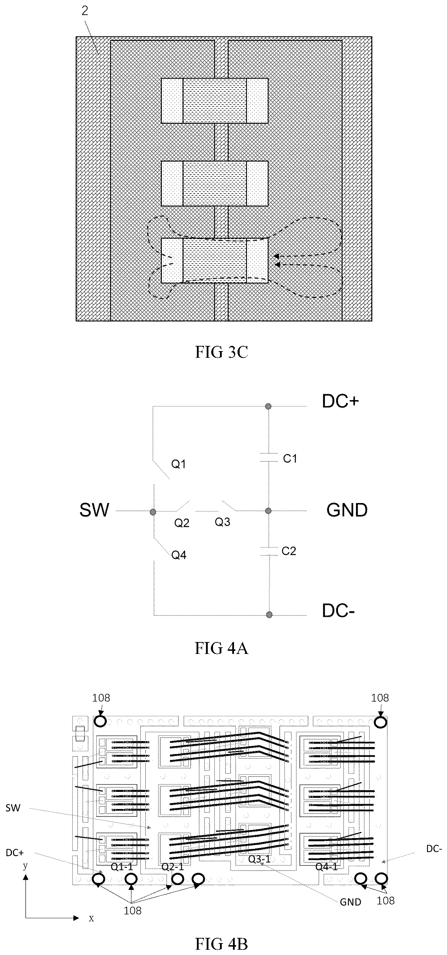

As shown in FIG. 3A, the insulating heat conducting plate is provided with a half-bridge circuit formed by connecting two switching elements 200 in series. The two switching elements 200 respectively comprises of three semiconductor power devices (such as Q1-1, Q1-2 and Q1-3 or Q2-1, Q2-2 and Q2-3), the number of the semiconductor power devices forming each switching element during actual use is not limited, and can be freely adjusted as required. The gates of the parallel chips are independently added the gate-level resistance (not shown in the figure) to improve the dynamic and static current sharing between the parallel chips. The vertical connector 103 is arranged on the insulating heat-conducting plate according to needs, so that the electrical connection with the multi-layer circuit board 2 is realized. FIG. 3B is a schematic diagram after a multilayer circuit board is arranged in a laminated layer. Wiring Vbus+ or Vbus-connected to two ends of a high-frequency capacitor 1 on the multilayer circuit board is at least overlapped with a projection part of the semiconductor power device in the horizontal direction to obtain a minimum loop inductance. It can be further seen from FIG. 3A that vertical connectors 103, such as D1-D4 and V1-V4, can be distributed between the parallel chips, such as Q1-1, Q1-2 and Q1-3 and on the outer sides of the peripheral chips Q1 and Q3 and the wiring layer of the insulating heat-conducting layer, so as to construct a plurality of high-frequency loops. High-frequency loop impedances of (Q1-1, Q2-1 groups) (Q1-2, Q2-2 groups) (Q1-3, Q2-3 groups) are approximately equivalent. Compared with a traditional plane type arrangement, the method has lower and more uniform high-frequency loop impedance, so that the voltage stress of the switching device can be reduced, and the high-frequency current sharing characteristic of the module can be further improved. Referring to FIG. 3C, the high-frequency current passing through the high-frequency capacitor 1 actually passes through a 3D loop, and as shown in the loop in the current loop reference diagram in the projection direction on the horizontal plane, since the high-frequency capacitor 1 can be distributed in the middle of (Q1-1, Q2-1 group), the magnetic fields formed by the two high-frequency currents on the two sides of the high-frequency capacitor 1 are opposite, thereby effectively reducing the interference to an external element and improving the reliability of the system.

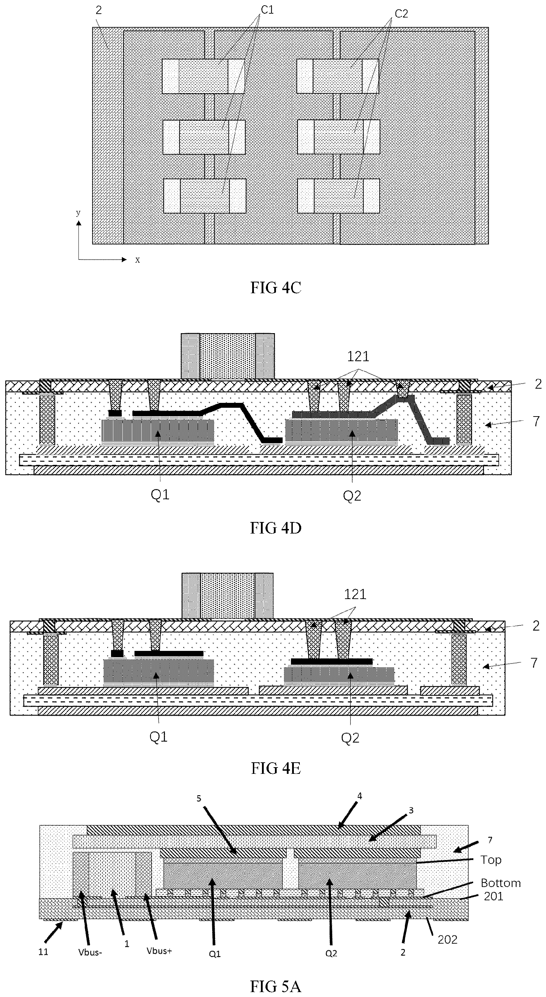

In other embodiments, as shown in FIG. 4A to FIG. 4C, the circuit topology C1/Q1/Q2/Q3 forms a high-frequency loop, and C2/Q3/Q2/Q4 forms another high-frequency loop. FIG. 4B is a wiring diagram of an insulating heat conducting plate. FIG. 4C is a schematic diagram after a multilayer circuit board is arranged in a laminated manner. In the horizontal projection, the wiring connected to two ends of a high-frequency capacitor 1 on the multilayer circuit board is at least partially overlapped with a semiconductor power device related to a high-frequency loop to which the multilayer circuit board belongs, so as to obtain a minimum loop inductance. In the embodiment, part of the vertical guide pieces for connecting the insulating heat-conducting plate DBC and the multi-layer circuit board 2 can adopt different diameters, for example, a large-diameter vertical guide piece 108 (equivalent to a first vertical connecting piece) is arranged at an included angle between four side faces of the DBC, so that the assembling parallelism of the insulating heat-conducting plate DBC and the multi-layer circuit board 2 can be ensured, and the subsequent assembly difficulty is reduced. For example, in the plastic packaging process, the parallelism difference between the insulating heat-conducting plate DBC and the multi-layer circuit board 2 can cause glue overflow, and if a large-diameter vertical guide piece 108 is adopted, the similar problems can be solved. Furthermore, the electrical properties of the at least one large-diameter vertical guide piece 108 and the at least one power terminal are the same, and the projection of the large-diameter vertical guide piece 108 on the vertical plane and the power terminal are partially overlapped, so that the parasitic impedance in the loop where the large-diameter vertical guide piece 108 is located is reduced, and the electrical performance of the product is improved

Furthermore, referring to FIG. 3A and FIG. 4B at the same time, the gates of the plurality of semiconductor chips connected in parallel are independently controlled, and after the gate bonding wires 110, the source bonding wires 111 and the power bonding wires 112 are bonded, each semiconductor chip can be independently tested, and when the failure chip is found, the failure chip can be independently isolated from the plurality of semiconductor chips in parallel by removing the corresponding vertical guide columns between the insulating heat-conducting plate DBC and the multi-layer circuit board 2; similarly, the power electrode of each semiconductor chip can also be independently isolated on the insulating heat-conducting plate DBC, and is connected to the multi-layer circuit board 2 through the corresponding vertical connector 103. Therefore, before the multilayer circuit board 2 is installed, the Die Bond and the Wire Bond of the insulating heat-conducting plate DBC are completed firstly, then the complete characteristic of each die is completed, and after further screening, the multi-layer circuit board 2 is installed. Compared with the process of testing after the module is completed, waste of various materials can be avoided.

As shown in FIG. 4D, the electrode of the semiconductor chip (equivalent to the semiconductor power device Q1 or Q2) facing one side of the multilayer circuit board 2 can be electrically connected with the multi-layer circuit board 2 by an electrical connection hole 121, and the electrical connection hole 121 is realized by drilling in the multi-layer circuit board 2 and the plastic packaging material 7, and metal, such as copper and the like are deposited through a metallization process. The drilling process of the electrical connection hole 121 can be realized in a mechanical and laser processing mode. In order to avoid damage to the front electrode of the semiconductor chip in the drilling process, as shown in FIG. 4D, a bonding metal layer (such as a copper layer) is bonded to the surface of the semiconductor chip facing the multi-layer circuit board 2 in a welding manner, silver sintering and the like, and the thickness of the bonding metal layer is greater than 50um, preferably greater than 200um. On the other hand, a thicker metal layer can also be directly metallized on the surface of the semiconductor chip. In the embodiment, when the insulation heat-conducting plate DBC assembly stage is tested, the failure chip can be isolated by not setting the corresponding electrical connection hole; or after the electrical connection hole is arranged. When the module is tested, the founded failure sample can also be removed through mechanical, laser, chemical and other methods to isolate the failure sample.

Further, as shown in FIG. 4E, the electrodes of the semiconductor chip facing the multilayer circuit board are electrical connected with the multi-layer circuit board 2 by drilling in the multi-layer circuit board 2 and the plastic packaging material 7, and depositing metal through the metallization process, so that the failure chip can be isolated more completely.

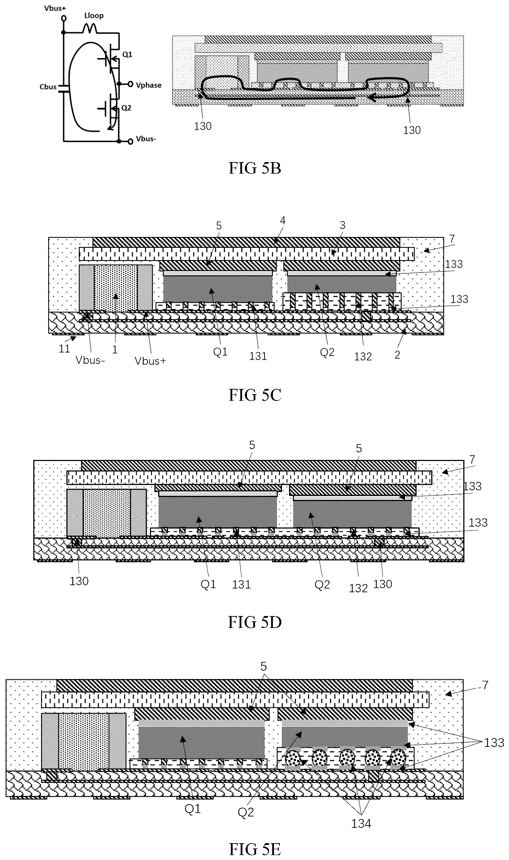

As shown in FIG. 5A and FIG. 5B, another embodiment of the application further discloses a high-frequency high-power packaging module which comprises at least one power conversion bridge arm and at least one high-frequency capacitor 1, the power conversion bridge arm comprises at least two semiconductor power devices connected in series, and the high-frequency capacitor 1 is connected with the power conversion bridge arm in parallel. In order to reduce the switching loss of switching, the extreme high speed of the switching element is pursued, the loop inductance formed by the three elements needs to be reduced, and the two electrodes of the high-frequency capacitor 1 are the Vbus+ and the Vbus- respectively, which are the two electrodes of the DC bus. The semiconductor power devices Q1 and Q2 of the present application include, but are not limited to, third generation semiconductor power devices, such as GaN devices, SiC devices, and the like.

Taking a GaN device as an example, a planar device is commonly used, that is, three electrodes of a pure die of the GaN device are on the same surface (top surface). Therefore, the PADs on the TOP surface are very dense. In order to reduce interconnection resistance and inductance, the GaN Top surface Pad of Chip Size is directly electrically interconnected to a first surface 201 of a high-precision multilayer circuit board 2 (PCB), wherein at least one electrode of Vbus+ or Vbus- is interconnected to the first surface 201 and the second surface 202 through an inner-layer electrical connection layer (Via), so that the loop inductance becomes extremely small through coupling of two layers.

Compared with the traditional package in FIG. 1, which is approach the 10nH-level, the application is suitable for application below 100kHz. The application has the opportunity to realize the loop inductance below 1nH and is sufficient to support the application of the MHz level, and the better effect can be gotten. In this way, loop inductance is guaranteed, and a basic condition is provided for realizing the high-frequency high-speed switches. Obviously, in order to realize a low loop, at least one of the two semiconductor power devices Q1 and Q2 is provided with at least two electrodes, for example, the source electrode and the gate electrode Gate are welded to the multilayer circuit board.

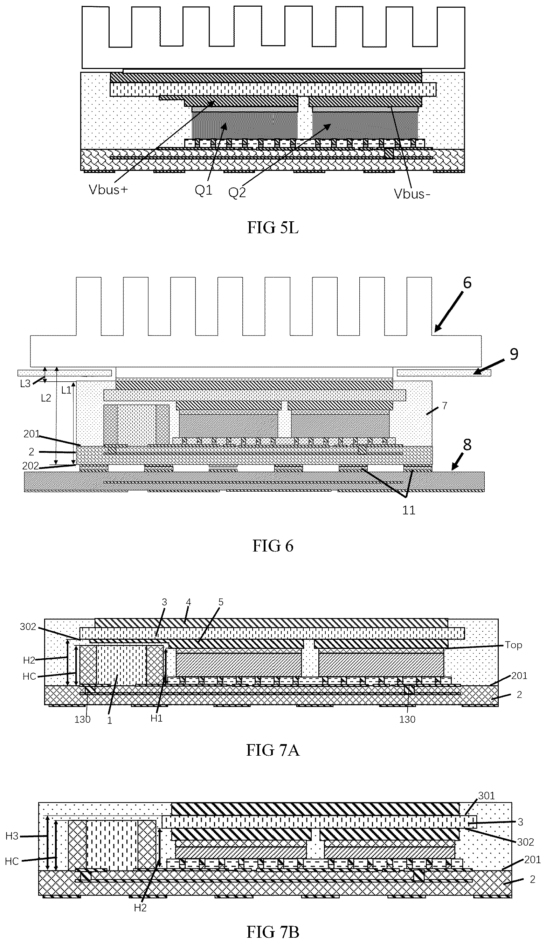

Meanwhile, the bottom surface the GaN device is thermally interconnected to an insulating heat conducting plate (DBC) through a material with a high heat conductivity coefficient, such as a ceramic substrate. The DBC comprises an insulating heat-conducting layer 3, an upper metal layer 4 and a lower metal layer 5, wherein the upper metal layer 4 and the lower metal layer 5 are arranged on the upper surface and the lower surface of the insulating heat-conducting layer 3 respectively. The heat-conducting layer 3 can conduct heat to the surface of the module, and the electrical insulation effect is achieved, and the radiator 6 (which can refer to the radiator 6 shown in FIG. 6) is convenient to assemble. Due to the fact that the two semiconductor power devices Q1 and Q2 are preferentially welded to the high-density circuit board, the heights of the bottom surfaces of the semiconductor power devices Q1 and Q2 are not prone to being flush, and therefore, the thickness of the material with the high heat conductivity coefficient needs to be relatively thick, for example, 50um or even more than 200um. Therefore, the TOP surfaces of the two semiconductor power devices Q1 and Q2 are connected to the DBC, and only one large-area PAD, such as a drain electrode or a source electrode, is provided as far as possible, so as to reduce the requirement for connection precision.

As shown in FIG. 5C, in an electronic circuit, a semiconductor chip of different types, especially a vertical structure, needs to be carried, and the thickness of the semiconductor chip is closely related to the performance of the semiconductor chip. In order to assemble the semiconductor chips with different thicknesses, in the embodiment, the protruding structures 131 and 132 (such as copper columns) with different thicknesses are adapted. In other embodiments, as shown in FIG. 5D, a portion of the lower metal layer 5 of the insulating heat-conducting plate DBC is thinned to adapt to semiconductor chips of different thicknesses. In addition, because the height of the protruding structures 131 or 132 on the surface of the semiconductor chip is usually between 50um and 300um, the thickness of the metal layer of the DCB ranges from 100um to 500um, and the range of the thickness tolerance of the protruding structures and the metal layer is limited. In the embodiment shown in FIG. 5E, the problem of thickness tolerance is solved by implanting a metal ball 134 on the surface of the semiconductor chip. The diameter of the metal ball 134 is between 100um and 1mm, and the diameter can be adjusted according to actual requirements, so that the capability of absorbing the thickness tolerance is further enhanced. In this embodiment, the material of the metal ball 134 may be a metal, such as copper, iron, nickel, an iron-nickel alloy, or a solder ball. The metal balls 134 not only have different resistivity, but also have different magnetic conductive characteristics, and can be used for realizing different resistances and inductances. Furthermore, the same semiconductor chip can carry different alloy balls at different positions and is used for matching the requirements of different parasitic parameters (equivalent to resistances or inductances) of local areas of the same semiconductor chip so as to improve the consistency of dynamic and static characteristics of different positions in the same semiconductor chip. Furthermore, differential arrangement can be carried out between a plurality of parallel semiconductor chips by using metal balls 134 of different materials, so that the consistency of dynamic and static characteristics among the plurality of parallel chips can be improved. In addition, the electrodes of one surface of all the semiconductor chips in the module can be realized in a metal ball mode and externally connected, so that the cost and the development period of directly forming the copper column on the surface metallization of the chip can be further reduced. Therefore, according to the embodiment, the product development period can be further shortened, and the cost is reduced.

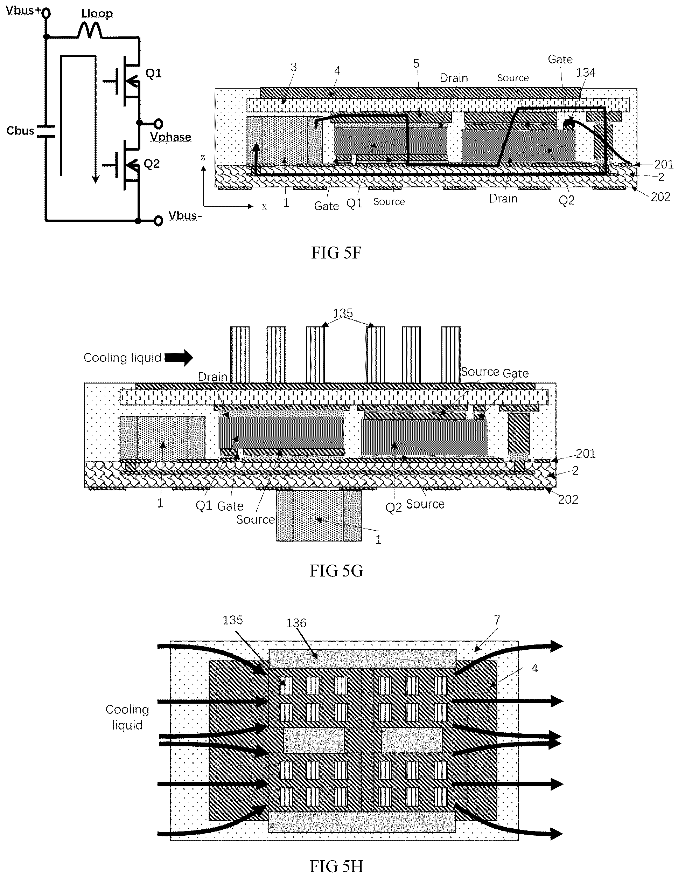

As shown in FIG. 5F, in order to further reduce the parasitic capacitance between the module and the radiator, the parasitic capacitor causes common mode noise under the jump voltage, so that the electrostatic potential electrode - the source electrode of the semiconductor chip is connected with the wiring layer of the DBC. Meanwhile, in order to reduce the thermal resistance from the semiconductor chip to the TOP surface of the DBC, the connection area between the semiconductor chip and the DBC needs to be increased as much as possible. Taking Q2 as an example, the source electrode of Q2 and the copper laying area corresponding to DBC need to be as large as possible, the gate electrode and the source electrode of Q2 are located on the top surface of the semiconductor device Q2, and when the semiconductor chip and the DBC are assembled, the gate electrode is easy to be short-circuited with the source electrode Source, so that glue dispensing treatment is carried out on the connecting welding spot of the gate electrode lead 139 and the welding spot of the gate electrode, and the gate electrode lead and the welding spot of the gate electrode is protected from being influenced by the assembly of the source electrode.

In the embodiment, the high-frequency capacitor 1 is arranged on the first surface 201 of the circuit board 2, but is not limited thereto, the high-frequency capacitor 1 can also be arranged on the second surface 202 of the circuit board 2, and the gate electrode can also be arranged on the DBC through welding, as shown in FIG. 5G. However, the thickness of the lower metal layer 5 and the thickness of the upper metal layer 4 of the DBC cannot be too thick, for example, the thickness of the lower metal layer 5 and the thickness of the upper metal layer 4 are thinner than 0.1 mm, so that the horizontal thermal diffusion capability of the plane direction formed by the X axis and the Y axis of the surfaces of the two metal layers of the DBC is reduced, and the heat dissipation capability of the vertical heat dissipation channel of the semiconductor chip in the Z-axis direction needs to be increased. In order to better solve the heat dissipation problem in the vertical direction, as shown in FIG. 5G, a heat-conducting column 135 is arranged on the outer surface (i.e., the upper metal layer 4) of the insulation heat dissipation layer 3 corresponding to the semiconductor chip in the vertical direction, and can be used for liquid cooling heat dissipation or liquid cooling heat dissipation devices, as shown in FIG. 5H. Due to the fact that the heat-conducting in the horizontal direction can be ignored. At the outside the horizontal plane projection of the semiconductor chip, the number of the heat-conducting columns 135 can be reduced and only adjusting the liquid flow direction at the position is needed, furthermore, the heat-conducting column 135 can even be not needed; that is, the number density of the heat-conducting column 135 in the projection of the horizontal plane of the semiconductor chip is larger than that of the heat-conducting column 135 outside the projection of the horizontal plane of the semiconductor chip. Because the copper layers of the upper metal layer 4 and the lower metal layer 5 are very thin, the insulating heat-conducting layer 3 can only be electroplated with copper on the surface of the insulating heat-conducting material.

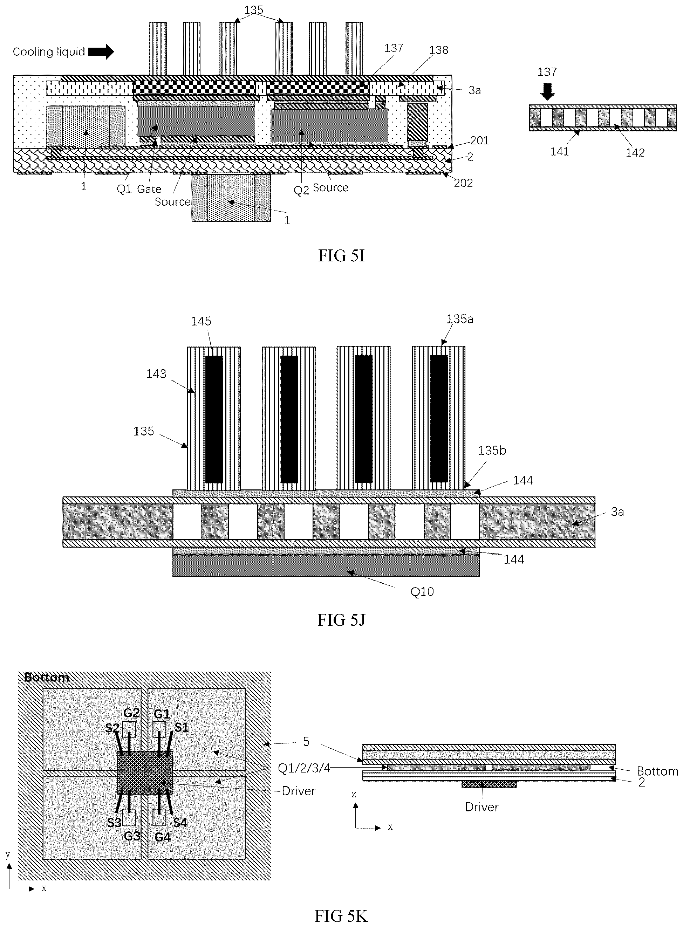

In another embodiment, as shown in FIG. 5I, the hybrid substrate 3a comprises two thermally conductive materials, a projection portion (equivalent to a high-heat-conducting region 137) of the semiconductor chip on the hybrid substrate 3a can adopt a high-heat-conducting material, and the remaining portion of the hybrid substrate 3a (equivalent to the low-heat-conducting region 138) can adopt a low-heat-conducting material with a relatively low thermal conductivity, and furthermore, the thermal conductivity coefficient of the high-heat-conducting material is greater than twice that of the low-heat-conducting material. Specifically, the high-heat-conducting material can be high-heat-conducting particles, such as a high-purity diamond particle array, especially an array formed by mixing diamond particles arranged in order and a ceramic material. Because the heat conductivity coefficient of the diamond is ten times that of the ceramic material, the equivalent heat conductivity coefficient can be greatly improved as long as the proportion of the diamond in the area is greater than 10% or greater than 20%. The structure of the hybrid substrate 3a disclosed by the embodiment can be suitable for all the embodiments disclosed by the application, and is also suitable for a thick copper DBC scheme and other traditional packaging schemes. On the other hand, the embodiment is a three-dimensional structure, that is, one surface of the insulating heat-conducting plate is used for heat dissipation, and the other surface is used for electrical performance connection, so that the heat dissipation capability cannot be upgraded through double-sided heat dissipation, the heat dissipation capability is improved by performing more-step treatment on the heat dissipation surface, as the Die Bond of the semiconductor chip shown in FIG. 5I, the sintering silver process can be used for improving the high junction temperature operation capability, and the heat dissipation capability is further improved.

For example, as shown in FIG. 5J, the hybrid substrate 3a may further comprise an upper metal layer 4 and a lower metal layer 5, the bottom surface of the lower metal layer 5 is connected to a high-thermal-density power semiconductor wafer Q10 by means of a high-heat-conducting interconnection 144, the high-heat-conducting interconnection 144 may be sintered silver, and the high-thermal-density power semiconductor wafer Q10 is fixed to the hybrid substrate 3a by sintering; the top surface of the hybrid substrate 3a is connected with the heat-conducting column 135 through the high heat-conducting interconnection 144, the heat-conducting column 135 is generally made of a copper material, the heat conductivity of the heat-conducting column 135 is 400W/(m • K), and when the high heat-conducting hybrid substrate is used (the heat conductivity of the diamond is higher than 2000 W/(m • K)), the copper heat-conducting column becomes a heat dissipation bottleneck due to the fact that the height of the heat-conducting column is greater than the thickness of the hybrid substrate. Therefore, in the embodiment shown in FIG. 5J, the heat-conducting column 135 adopts a carbon fiber tube or a composite body, the composite body herein can be a metal shell 143 with high heat conductivity, the ultrahigh heat-conducting filler 145 is coated with the metal shell 143, the metal shell 143 can be made of a copper material, and the ultrahigh heat-conducting filler 145 can be a carbon fiber tube, a graphene sheet or a phase change liquid (a heat pipe). The structure shown in FIG. 5J guides the heat generated by the high-heat-density power semiconductor wafer to the outer surface of the module, then the heat is conducted to the surface of the heat-conducting column through the heat-conducting columns 135 with a plurality of high-heat-conductivity coefficients, the surface of the heat-conducting column exchanges heat with the cooling liquid, and high efficient of heat dissipation is achieved. The hybrid substrate disclosed by the application can be suitable for all the embodiments disclosed by the application, and can also be applied to other embodiments as long as the above technical features are met.

In addition, the application also discloses an embodiment of multi-wafer parallel connection under high-power application, as shown in FIG. 5K. According to the multi-wafer parallel connection, the multiple wafers and drivers of the multiple wafers are arranged on the packaging structure of the same plane, so that the distances from the drivers to all the chips are not equal, the driving signals received by each wafer are inconsistent, and the phenomenon of no current sharing is generated after the multiple wafers are connected in parallel. The application discloses a multi-wafer parallel three-dimensional packaging, which can solve the problem of consistency of multi-wafer parallel driving. As shown in the bottom view and the side view shown in FIG. 5K, the four wafers are arranged on the first surface 201 of the multilayer circuit board in a 2X2 row, and the gate electrodes of each semiconductor wafer are arranged nearby; the driver is arranged on the second surface 202 of the multilayer circuit board, and the lower metal layer 5 of the DBC is attached to the top surface of the four wafers. Referring to the bottom view schematic diagram shown in FIG. 5K, the multilayer circuit board 2 is removed, the driver Driver is arranged in the center of four wafers arranged in 2X2, that is, the projection of the driver on the first surface is partially overlapped with the projection of each semiconductor wafer on the first surface, so that the wiring distance between each driving output pin and the gate electrode Gate of the corresponding wafer is equal, and the distance is the shortest; and the consistency of each driving loop can be improved through the uniform wiring of the wiring layer of the multi-layer circuit board 2; and the current sharing among the wafers can be realized, and high-speed driving can also be realized.

By integrating the heat dissipation optimization structure, high-frequency and high-power application can be realized. A large current driver Driver may be used to drive a plurality of semiconductor wafers, or each semiconductor wafer may be driven by a respective driver. Aiming at the scheme of a plurality of drivers, the current of each semiconductor wafer can be sampled at the same time, the sampled current information is fed back to the driver, the driving of each semiconductor wafer is differentially adjusted in real time, and active current sharing control is achieved. The plurality of semiconductor wafers herein are not limited to only four or three or other, as long as the projection of the driver on the first surface 201 of the multilayer circuit board partially overlaps with the projection of each semiconductor wafer on the first surface 201 of the multilayer circuit board.

As shown in FIG. 5F, by staggered welding of the pins of the two semiconductor wafers, for example, the source electrode of one semiconductor wafer and the drain electrode of the other semiconductor wafer are arranged on the circuit board, the drain electrode (electrostatic potential) of one semiconductor wafer and the source electrode (electrostatic potential) of the other semiconductor wafer are arranged on the lower metal layer 5, low common-mode interference is achieved, the requirement for a common mode inductor during system application is greatly reduced, the cost is reduced, and the size is reduced. According to the embodiment shown in FIG. 5L, another technical scheme for achieving the same effect is disclosed. In the present embodiment, the semiconductor wafer is an LD/MOS, such as a low-voltage GaN MOS, which can be flexibly set by using a substrate electric potential, or a GaN/MOS using an electrically insulating material such as ceramic (sapphire) as a substrate. The substrate of the semiconductor wafer is thermally connected to the lower metal layer of the DBC, and the pin positioned in thermal connection with the lower metal layer is set to be an electrostatic potential, such as Vbus+ or Vbus- or power GND.

The high-frequency high-power packaging module disclosed by the embodiment of the application further comprises a plastic package body 7, the plastic package body 7 is thinnest and can be controlled between the upper surface of the insulating heat-conducting plate DBC and the first surface 201 of the multilayer circuit board 2, and the safety insulation capability is achieved. As shown in FIG. 6, the plastic package 7 fills a gap area between the first surface 201 of the multilayer circuit board and the upper surface of the insulation heat-conducting board, the upper surface of the insulation heat-conducting board is exposed, the second surface 202 and the side edge of the multilayer circuit board are exposed, the second surface 202 or the side edge of the multilayer circuit board is provided with an external electrode 11, and the external electrode 11 is electrically connected with the power conversion bridge arm. According to the embodiment, the mechanical strength is greatly improved, thinner DBC, such as 0.4mm or even lower insulation thickness, can be supported, compared with silica gel packaging in FIG. 1, the thickness is at least 0.6mm or above, lower thermal resistance can be achieved, falling is reduced by 30% or above, and higher power is supported.

According to the high-frequency high-power packaging module disclosed by the embodiment of the application, the front surface (equivalent to the bottom surface) of the semiconductor power device is electrically connected with the first surface 201 of the multi-layer circuit board, the back surface (equivalent to the TOP surface) of the semiconductor power device is thermally connected or electrically connected with the lower surface 302 of the insulating heat-conducting plate, and the semiconductor power device and the DBC are thermally interconnected for welding. Therefore, the back surface of the semiconductor power device is excellent in metallization treatment.

The high-frequency capacitor 1 is electrically connected with the first surface 201 of the multi-layer circuit board or the second surface 202 of the multi-layer circuit board or the lower surface of the insulating heat-conducting board, and at least one electrode of the high-frequency capacitor 1 is electrically connected with at least one electrode of the at least one semiconductor power device through the inner-layer electrical connection layer. It should be noted that the bottom surface and the top surface of the semiconductor power device referred to in the present application are only one relative concept, and do not specifically refer to that a certain surface is a front surface or a back surface.

As an embodiment, as shown in FIG. 6, as the application pursues ultra-thinness, the second surface 201 of the multilayer circuit board is used as a surface bonding pad (SMD PAD) and is electrically interconnected to the client mainboard 8, so that the thinning of the whole client system is realized, or the space of the module in the client system is as small as possible. When the thickness L1 of the module is thinner than a certain degree, such as Smm, the thickness of the module is thinner than the creepage distance required by safety insulation (usually greater than 6mm), the radiator 6 can only make contact with the insulating heat dissipation plate DBC, the heat dissipation effect is guaranteed, an air gap not smaller than 1mm is arranged between the heat dissipation effect and the plastic packaging material at the edge of the module, the air gap L3 is formed between the upper surface of the plastic package body 7 and the radiator 6, and the air gap L3 is larger than 1mm. In other embodiments, an electrical insulation sheet 9 may be provided between the upper surface of the plastic package 7 and the heat sink 6 for increasing the insulation effect, as shown in FIG. 6.

In order to achieve a smaller loop inductor, the high-frequency capacitor 1 is integrated on the module, and the high-frequency capacitor 1 should be close to the semiconductor power devices Q1 and Q2 as far as possible in practical application, so that the high-frequency capacitor and the semiconductor power device are not easy to get close. A high power usually means a high-voltage occasion higher than 200V, for example, 400V Vbus, a 630V ceramic capacitor is needed, and the capacitor of the high-voltage application often needs a relatively high height to achieve the required capacity, such as 1mm or more. Furthermore, in order to achieve smaller thermal resistance, the thickness of the semiconductor power devices Q1 and Q2 is as thin as possible, which causes the high-frequency capacitor 1 to be blocked by the DBC. The high-frequency capacitor 1 is taken as an example, and the high-frequency capacitor 1 is also applicable to other higher elements.

As shown in FIG. 7A, the higher element is welded on the multilayer circuit board 2. In order to help the semiconductor power devices Q1 and Q2 to thermally diffuse and improve the heat capacity, and enhance the heat management capability of the transient state and the steady state, and the DBC double-sided thick copper, namely the upper metal layer 4 and the lower metal layer 5 of the insulating heat-conducting layer 3, can be thinned or removed by thinning or removing the lower metal layer 5 above the high-frequency capacitor 1, so that the high-frequency capacitor 1 can be arranged between the insulating heat-conducting layer 3 and the multilayer circuit board 2. That is, the high-frequency capacitor 1 is electrically connected to the first surface 201 of the multilayer circuit board, and the height Hc of the high-frequency capacitor 1 satisfies the following conditions:

$$H1 \leqslant Hc < H2;$$

Wherein H1 is the distance from the first surface 201 of the multilayer circuit board to the TOP surface of the semiconductor power device Q1 and Q2, and H2 is the distance from the first surface 201 of the multilayer circuit board to the lower surface 302 of the insulating heat-conducting layer; and the insulating heat-conducting plate extends to the upper of the high-frequency capacitor 1, and the lower metal layer 5 located between the high-frequency capacitor 1 and the insulating heat-conducting plate is isolated from the high-frequency capacitor 1 in a thinning or removing mode.

As shown in FIG. 7B, the higher element is welded on the multi-layer circuit board 2, and when the height Hc of the high-frequency capacitor 1 is higher than the height between the lower surface 302 of the insulating heat-conducting layer and the first surface 201 of the multi-layer circuit board, the whole insulating heat-conducting plate can be retracted, so that only a plastic packaging material exists between the upper part of the high-frequency capacitor 1 and the upper surface of the module. The thickness of the plastic packaging material is preferably 0.4mm or more so as to ensure the electrical insulation strength. That is, the high-frequency capacitor 1 is electrically connected to the first surface 201 of the multilayer circuit board, and the height He of the high-frequency capacitor 1 satisfies the following conditions:

$$H2 \leqslant Hc < H3;$$

Wherein H2 is the distance from the first surface 201 of the multilayer circuit board to the lower surface 302 of the insulating heat conducting layer 3, and H3 is the distance from the first surface 201 of the multilayer circuit board to the upper surface 301 of the insulating heat conducting layer. The insulating heat conducting plate 3 is only located above the semiconductor power devices Q1 and Q2.

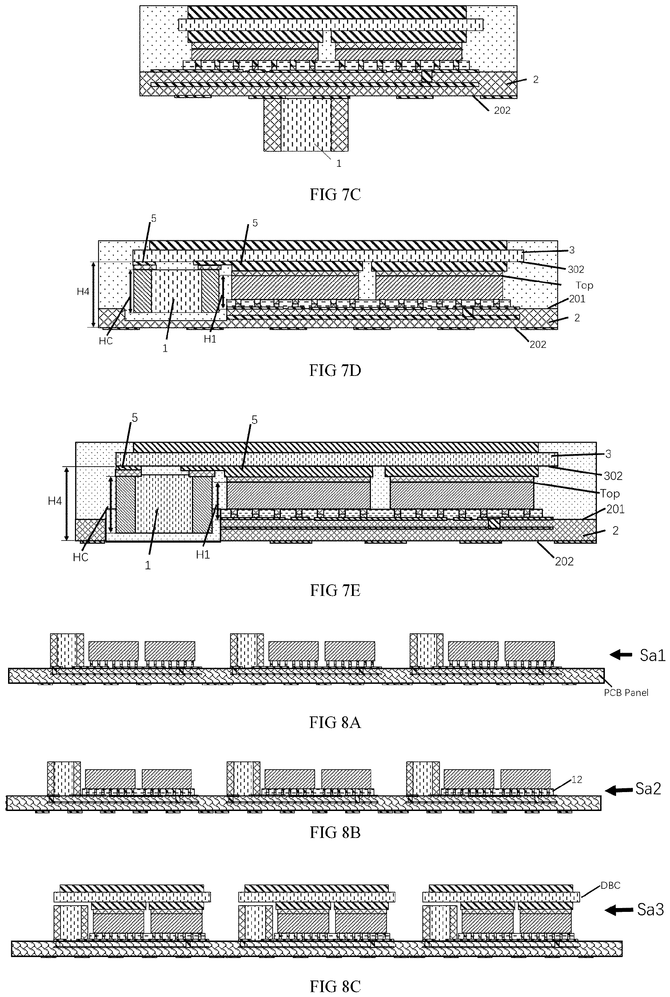

As shown in FIG. 7C, since the height of the high-frequency capacitor 1 is limited, in order to pursue extreme thermal performance, the thickness of the insulating heat-conducting plate DBC is as thin as possible. Therefore, even if the scheme of FIG. 7B is adopted, the thickness of the plastic package material on the high-frequency capacitor 1 can not meet the safety requirement or even be exposed. Therefore, the solution of FIG. 7C may be used, that is, the high-frequency capacitor 1 is placed on the second surface 202 of the multilayer circuit board. Not only can the loop be reduced, but also the size of the module can be reduced. Namely the high-frequency capacitor 1 is electrically connected with the second surface 202 of the multi-layer circuit board, and the two electrodes of the high-frequency capacitor 1 are electrically connected with the inner-layer electrical connection layer and the first surface 201 of the multi-layer circuit board through vertical electrical connection paths 130 respectively.

According to the scheme of FIG. 7D and FIG. 7E, the higher elements are welded on the lower surface 302 of the insulating heat conducting layer, the part of the corresponding part is insufficient, and the local area of the multilayer circuit board 2 is thinned or removed. The lower metal layer 5 of the insulating heat-conducting layer 3 can also be thinned. The high-frequency capacitor 1 is electrically connected with the lower surface 302 of the insulating heat-conducting layer, at least one electrode of the high-frequency capacitor 1 is electrically connected with the inner-layer electrical connecting layer through an electrical connecting piece (not shown in the figure), and the height Hc of the high-frequency capacitor 1 meets the following conditions:

$$H1 \leqslant Hc < H4;$$

Wherein H1 is the distance from the first surface 201 of the multilayer circuit board to the TOP surface of the semiconductor power device, and H4 is the distance from the second surface 202 of the multilayer circuit board to the lower surface 302 of the insulating heat-conducting layer; and the multilayer circuit board 2 located below the high-frequency capacitor 1 is isolated from the high-frequency capacitor 1 by means of thinning or removing.

As an embodiment, as shown in FIGS. 8A~8F, in a high-frequency occasion, the internal loop of the module is small, but the internal capacitance is limited due to the limited space, so that the upper capacitor of the client mainboard 8 and the high-frequency capacitor 1 in the module need to be placed nearby. Therefore, the modules of different application scenes comprise different powers, different internal circuits, an optimized packaging form and PIN arrangement, which means that a plurality of packages can be packaged. The packaging of the plastic package is different from that of the silica gel, and the cost of the mold is very high. The embodiment of the application discloses a manufacturing method of a high-frequency high-power packaging module. The problem that the cost of a mold is very high is effectively solved, the performance of the mold composition can be reserved, the cost can be reduced in a mode of sharing one mold through multiple types of modules, automatic large-batch production can be achieved, the cost is further reduced, and the steps are as follows:

First step Sa1: the semiconductor power devices Q1, Q2 and other necessary components SMD of the plurality of modules are SMD to corresponding partitions of the PCB panel; and if necessary, the PCB can double-sided SMD elements, as shown in FIG. 8A.

And a second step Sa2: optionally, pre-molding a region between the semiconductor power devices Q1, Q2 and the first surface 201 of the multilayer circuit board to form a thermal resistance electrical connection layer 12 to improve the strength of the semiconductor power devices Q1 and Q2 and eliminate bottom bubbles, as shown in FIG. 8B.

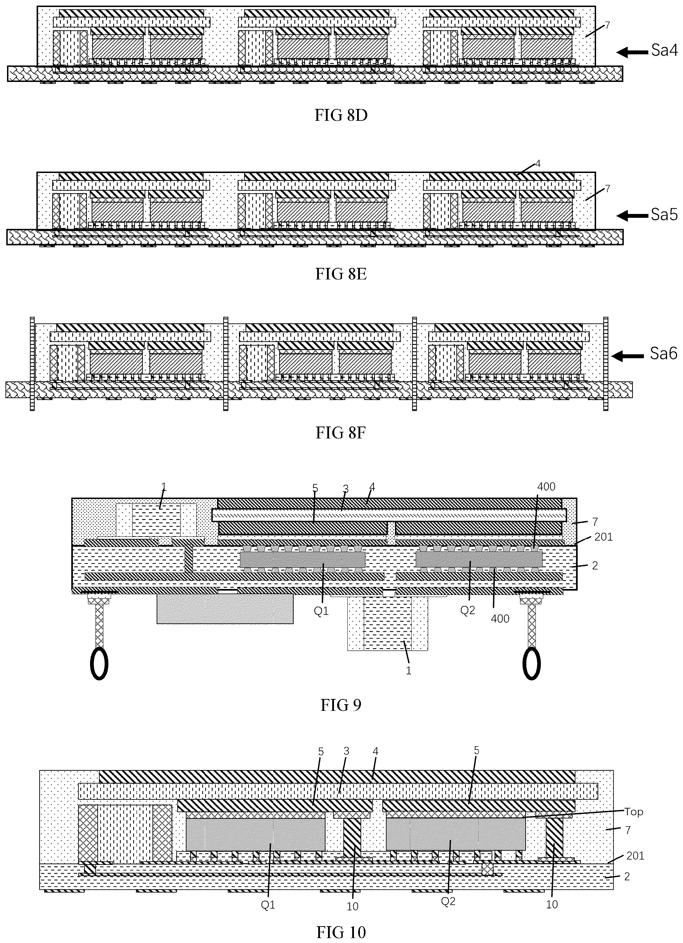

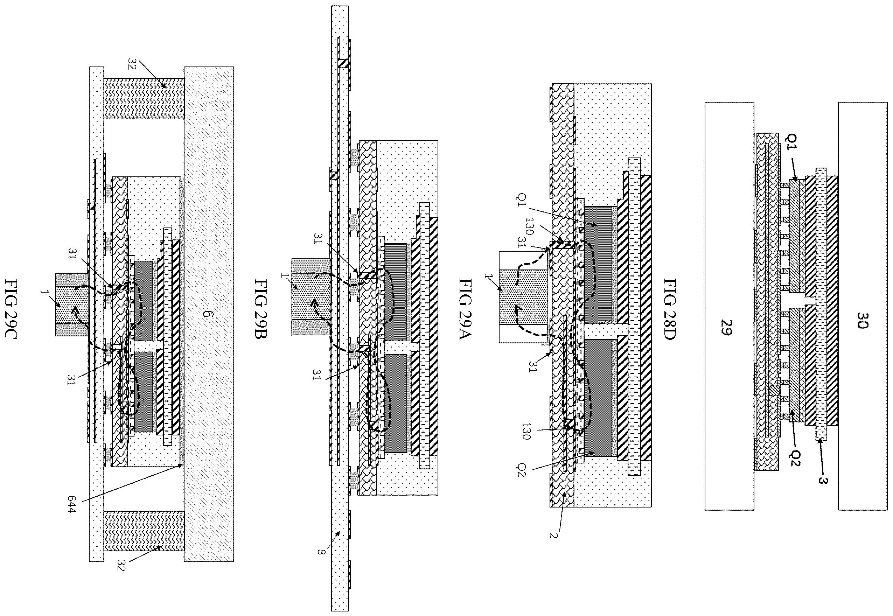

A third step Sa3: bonding/welding DBC of each module to the Top surface of the corresponding semiconductor power device Q1 and Q2; and if it is the solution of FIG. 8D, FIG. 8E and FIG. 29C, before thermally connecting to the semiconductor power devices Q1 and Q2, the DBC first welding necessary components such as a high-frequency capacitor 1 and a common-mode suppression capacitor 24, as shown in FIG. 8C.

And a fourth step Sa4: taking the periphery of the PCB panel as a plastic package sealing area, preventing plastic package from overflowing, and effectively plastic packaging the upper part of the PCB to form a plastic package body 7, as shown in FIG. 8D.

Fifth step SaS: optionally, polishing one side of the upper metal layer 4 of the DBC, removing the glue overflow, improving the DBC flatness of the insulation heat-conducting plate, reducing the thickness of the subsequently installed heat dissipation glue, improving the thickness consistency of each module, and reducing the thickness of the subsequent multi-module installation heat dissipation glue, as shown in FIG. 8E.

Sixth step Sa6: cutting is performed, and each module is separated from the panel, as shown in FIG. 8F.

According to the module provided by the embodiment or the module manufacturing process, one feature is achieved, and due to the fact that cutting separation can enable the periphery of the side face of the module and the side face of the plastic packaging body 7 to be flush with the side face of the multi-layer circuit board. Due to the fact that a large panel is cut into a plurality of modules, the same mold can be used as long as the size in the large panel meets the size of a plurality of module combinations, that is, one mold can be used for manufacturing a plurality of types of modules.

In other embodiments, as shown in FIG. 9, the semiconductor power device can be embedded in a multi-layer circuit board 2, and after the electrode 400 is led out through the via hole and the electroplating, the semiconductor power device is electrically interconnected with the insulating heat-conducting plate and the pin. In this way, welding and wire bonding processes can be omitted, and the reliability is higher.

As an embodiment, as shown in FIG. 10, a planar device such as GaN, an electrode on the Top surface of a semiconductor power device thereof often needs to be connected to a certain suitable electric potential, such as a source electrode or a gate electrode gate electrode thereof. Due to the Top surface being connected to the DBC, the electrode on Top surface of the semiconductor power device needs to be electrically connected with the first surface 201 of the multi-layer circuit board through the lower metal layer 5 and the conductive assembly 10 in sequence, and the first surface 201 is connected to the multi-layer circuit board 2 from the DBC. The electrical connection only needs to obtain the necessary electric potential for the semiconductor power device, large current is not needed, and thick copper does not need to be laid on the DBC.

When a vertical device such as SiC is used, the power electrode of the vertical device is arranged on the upper surface and the lower surface of the device, and the electrode on the Top surface of the vertical device is often an electrostatic potential electrode. Therefore, the drain electrode needs to be electrically connected to the first surface 201 of the multi-layer circuit board through the lower metal layer 5 and the conductive assembly 10, and the lower metal layer 5 is a thick copper layer.

As an embodiment, referring to FIG. 5A, the height of the conductive assembly 10 between the multi-layer circuit board 2 and the DBC, and the height precision requirements of the semiconductor power devices Q1 and Q2 are high, which may cause high costs and complex processes. Due to the fact that only the electrical property of the semiconductor power device BASE is stabilized, the BASE is connected to a required electrode, such as a source electrode, in the semiconductor power device through the conductive through hole in the semiconductor power device, so that the challenge and cost of the packaging level can be omitted.

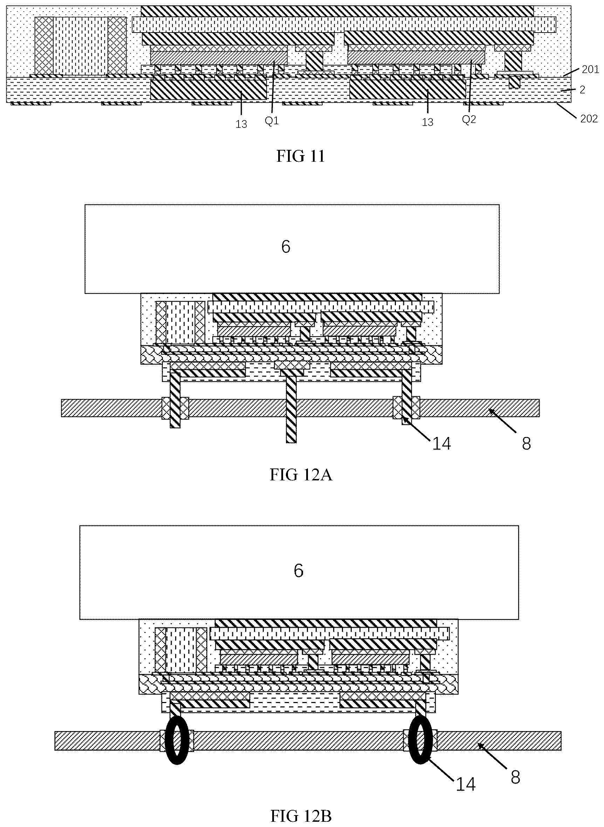

As an embodiment, as shown in FIG. 11, due to the trend of the electrical vehicle, the application of the SiC/GaN in the vehicle gauge occasion is more and more popular, especially the driving of the electrical motor. According to the particularity of an automobile, a second-level acceleration, namely, a second-level high-power output, is normally provided. Therefore, in the module, the second-level heat capacity is set for the semiconductor power devices Q1 and Q2, so that it is most effective and economical. Due to the fact that the semiconductor power devices Q1 and Q2 are very thin, the transverse thermal resistance of the semiconductor power devices Q1 and Q2 is large, and it is difficult to be improved. The top surface of the semiconductor power device Q1 and Q2 is already connected with DBC, and on the premise that the packaging stress is allowed, DBC copper-coated as thick as possible is used to obtain the second-level low-thermal-resistance high-heat-capacity. Therefore, opportunities can only be found from TOP layers of the semiconductor power devices Q1 and Q2. However, due to the requirement of electrical wiring, the copper thickness of the surface of the top layer is limited, and enough large second-level heat capacity is difficult to obtain. Therefore, the application selects a low-thermal-resistance large heat-capacitance object, such as thick copper, at the inner-layer electrical connection layer of the circuit board directly below the TOP surface of the semiconductor power devices Q1 and Q2. Through the high-heat-capacity element 13 with high-density arrangement, interconnection of the first surface 201, the second surface 202 and the inner-layer electric connection layer of the multilayer circuit board 2 is realized, and low-thermal-resistance interconnection is realized. Therefore, the high-precision electrical interconnection of the surface layer is realized, the low thermal resistance and large heat capacity is additionally obtained for the semiconductor power devices Q1 and Q2 which provides support for the transient high-power impact of the module.

As shown in FIG. 6, the module is mounted to the client motherboard 8 by an SMD process, but this is also insufficient in some applications. For example, when a plurality of modules are installed with the same radiator 6 due to the fact that the tolerance of the module thickness and the tolerance of the SMD process, the heat dissipation surfaces of a plurality of modules are often different in height, and thicker heat-conducting silicone grease is needed to buffer the tolerance. The thick heat-conducting silicone grease increases the thermal resistance of the module and limits the power. Therefore, the embodiment to buffer the tolerance is needed.

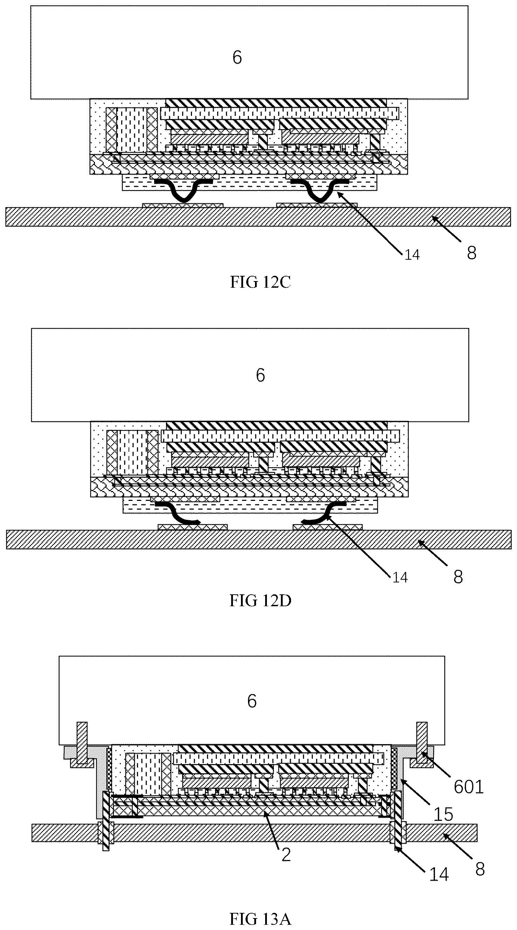

As an embodiment, as shown in FIGS. 12A-12D. A buffer outer pin 14 (PIN) is implanted on the SMD PAD of the module. FIG. 12A is a direct-insertion welding pin, which is welded to a client mainboard 8 and is electrically connected with solder; and FIG. 12B is a direct-insertion crimping pin, pressing the outer pin 14 into the through hole of the client mainboard 8, and forming a contact force by the buffer elasticity of the PIN for electrical connection; FIG. 12C shows a surface contact crimping pin, and the elastic PIN is pressed to the SMD PAD of the client mainboard 8; and FIG. 12D shows a surface contact welding pin, and the elastic PIN is welded to the SMD PAD of the client mainboard 8. When the multi-module is installed, the thickness tolerance is buffered by the elasticity of the PIN or the insertion depth difference, so that the thinnest heat-conducting silicone grease can be used, the lowest thermal resistance is obtained, and the maximum power is guaranteed.

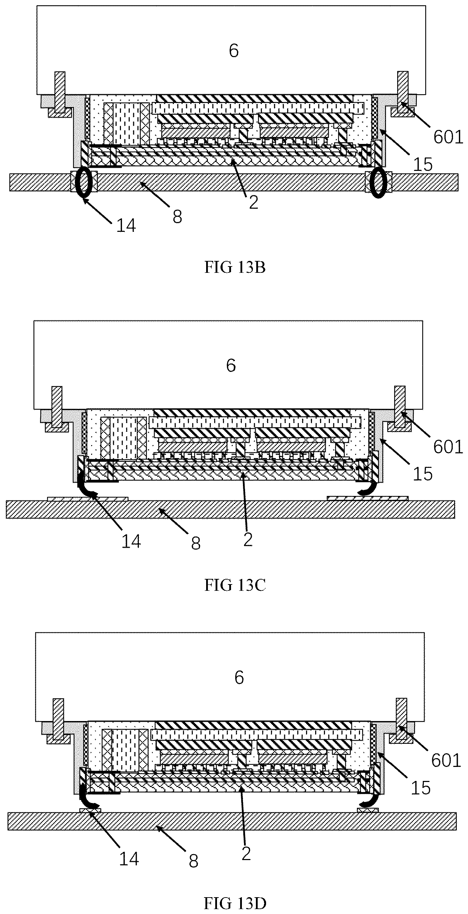

As an embodiment, as shown in FIG. 13A to FIG. 13E, the required electrode is guided to the side edge of the multi-layer circuit board in the multi-layer circuit board 2, that is, the outer side PIN of the multilayer circuit board on the side surface of the module is formed, the buffer outer pin 14 is implanted into the multi-layer circuit board 2. FIG. 13A shows a direct-insertion welding pin, and the direct-insertion welding pin is welded to the client mainboard 8 and is electrically connected with the solder. FIG. 13B shows a direct insertion crimping pin, which is crimped to the through hole on the PCB and is elastically buffered by the PIN, and electrical connection is carried out. FIG. 13C shows a surface contact crimping pin, and the elastic PIN is pressed to the SMD PAD of the client mainboard 8. FIG. 13D shows a surface contact welding pin, and the elastic PIN is welded to the SMD PAD of the client mainboard 8. When the multi-module is installed, the thickness tolerance is buffered by the elasticity of the PIN or the insertion depth difference, so that the thinnest heat-conducting silicone grease can be used, the lowest thermal resistance is obtained, and the maximum power is guaranteed.

As an embodiment, as shown in FIGS. 13A~13D, in order to reduce the size of the plastic package 7 of the module as much as possible and improve, the productivity, the module fixed to the mounting hole 601 of the radiator 6 may not be provided in the plastic package 7. Then, the insulating fixing frame 15 can be added to the plastic package 7. The section view of the insulation fixing frame 15 is L-shaped, one side of the L-shaped is adhered to the side face of the plastic package body 7 through glue, and mechanical reinforcement and electrical insulation reinforcement are carried out. The other side of the L shape is provided with a screw mounting hole 601 for mounting the fixing frame 15 to the radiator 6.

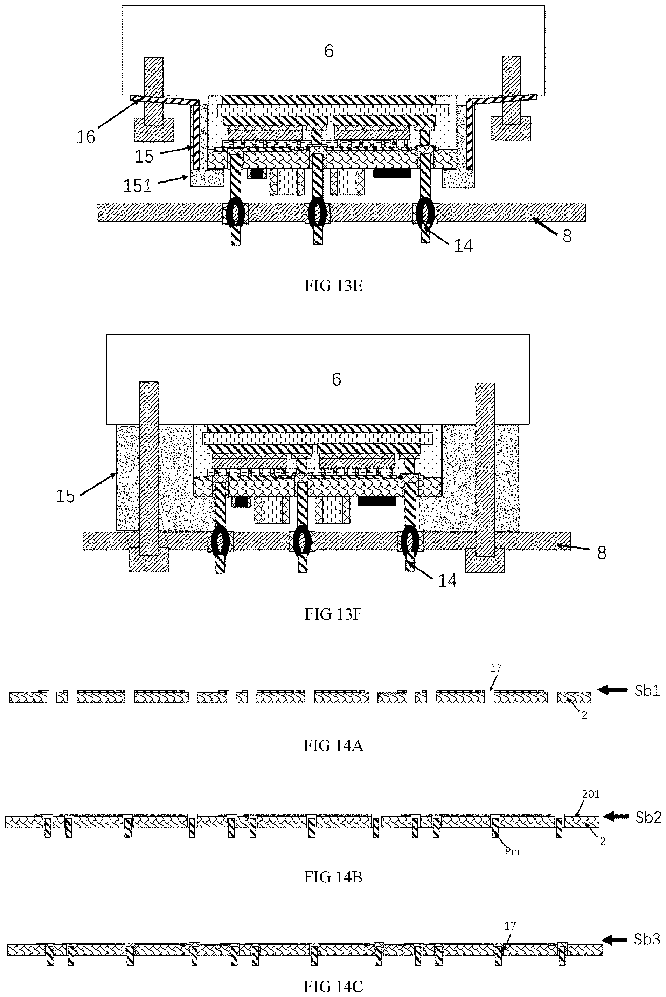

As an embodiment, as shown in FIG. 13E, a Z-shaped elastic insulating fixing frame 15 is adopted, one end of the elastic insulating fixing frame 15 is a part of the fixing frame 151 of an insulating material and is pressed on the outer side edge of the module multi-layer circuit board 2, the other end of the elastic insulating fixing frame 15 is a metal elastic piece 16 (equivalent to an elastic piece), and the elastic insulating fixing frame 15 is pressed on the radiator 6 through screws; and the metal elastic piece 16 is pressed and molded in a part of the fixing frame 151. The pressure of the metal elastic piece 16 is transmitted to the module through the partial fixing frame 151 to form a mounting force. The plastic part ensures insulation.

As an embodiment, as shown in FIG. 13F, an L-shaped insulating fixing frame 15 is adopted which has certain elasticity to balance the thickness tolerance balance force. One end of the insulating fixing frame 15 is pressed on the edge of the outer side of the module circuit board, the insulating fixing frame 15, the module and the radiator 6 are locked together through screws, and equalization pressure is formed.

FIG. 13E and FIG. 13F also show the PIN-out mode of the technical solution shown in FIG. 7C, that is, the gap between the insulating fixing frame 15 and the second surface 202 of the multilayer circuit board is fully utilized, and SMD elements, such as Cbus, Driver and other necessary elements are arranged on the second surface 202 of the multilayer circuit board. The space is fully utilized, the size of the module is greatly reduced, the cost is reduced, and the yield is improved. The buffer outer pin 14 of the solution shown in FIG. 13E and FIG. 13F is electrically connected to an external electrode provided on the second surface 202 of the multilayer circuit board. It should be noted that the buffer outer pin 14 can also be directly electrically connected to the circuit structure inside the circuit board.

According to the previous embodiments, the buffer output pin 14 is implanted into the module, whether the side surface or the bottom surface, the simplest method is Reflow welding. However, the plastic package 7 is hard curing, so that all different materials are needed to be hard-connected together. Due to the internal stress of the plastic package body 7 caused by Reflow, the structural stability is easily damaged, and the reliability problem is caused. According to the embodiment of the application, the technical scheme of implanting the PIN before plastic packaging is provided, and the problem is effectively solved. The detailed technical solutions are as shown in FIGS. 14A-14E.

In the first step Sb1, the position for implanting the Pin on the PCB panel is reserved and welded. As shown in FIG. 14A.

In the second step Sb2, the PIN is mechanically implanted into through hole 17 of the circuit board through hole 17, and the top of the PIN is suitable for not exceeding the first surface 201 of the multilayer circuit board. As shown in FIG. 14B.

In the third step Sb3, before the SMD elements are reflowed on the multilayer circuit board 2, enough solder paste is arranged at the top of the PIN. After the process of reflow, the solder not only reliably electrically connects the PIN with the PCB, but also fully fills the gap between the PIN and the multi-layer circuit board to prevent glue overflow during plastic packaging. As shown in FIG. 14C.

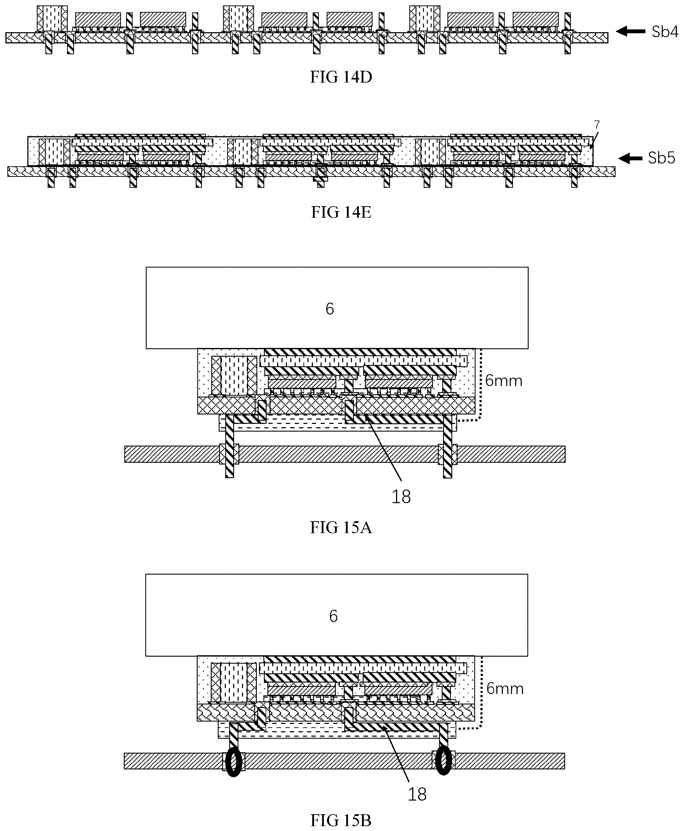

In the fourth step Sb4, the other elements on the multi-layer circuit board 2 are welded through the Reflow SMD. As shown in FIG. 14D.

A fifth step Sb5: plastic packaging and forming a plastic package 7, as shown in FIG. 14E, the subsequent process is similar to that of FIGS. 8A-8F.

So far, each implanted buffer outer pin 14 can be fixedly and electrically connected with the client mainboard 8 by referring to the direct welding mode as shown in FIG. 12A, the direct-insertion crimping mode shown in FIG. 12B, the surface crimping mode shown in FIG. 12C and the surface welding mode shown in FIG. 12D. The plastic package 7 is not required to be subjected to high-temperature Reflow, so that the reliability of the module is better. Moreover, the PIN can be designed according to actual needs, so that the transverse diffusion resistance of the circuit in the multilayer circuit board 2 is reduced, and the utilization rate of the multilayer circuit board and the electrical performance of the module are greatly improved.

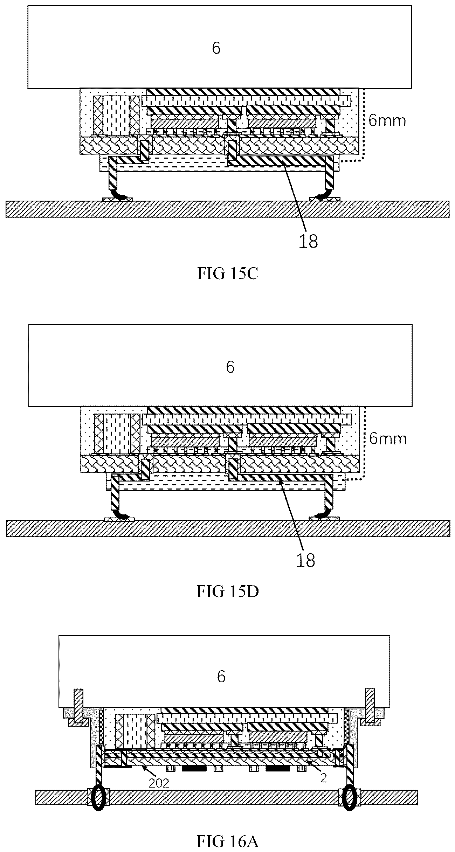

As shown in FIG. 15A to FIG. 15D, through the rewiring structure 18, each PIN is unifiedly led to a required position, and it is facilitated to use by customers. Moreover, the flexibility of the PIN-out of the circuit board in the module is considered, and the internal performance of the circuit board is guaranteed.

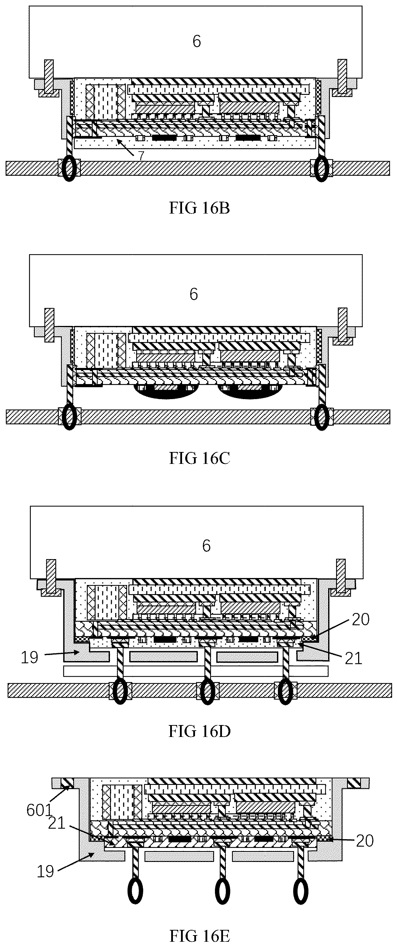

As an embodiment, as shown in FIGS. 16A~16F, the derivatives of the solutions of FIGS. 13A and 13F are derived. In order to better improve the performance of the module, a Cbus, a driving or control IC and a peripheral circuit are often needed to be placed nearby. If the module and the semiconductor power devices Q1 and Q2 are placed on the same surface of the multi-layer circuit board 2, firstly, the area of the circuit board is increased, so that the module volume is increased; secondly, the parasitic parameters in the high-frequency loop are increased, and the high-frequency performance of the module is affected; and thirdly, the IC and the capacitor are high in temperature, and the performance and reliability of other elements in the module are influenced. According to the embodiment, part of elements, such as the Cbus, the driving IC or the control IC and the peripheral circuit are placed on the second surface 202 of the multilayer circuit board and are far away from the heat source, so that the problem of the three aspects is solved, and the convenience of using the module by the client can be obtained. As shown in FIG. 16A, the packaged IC and other components directly SMD on the second surface 202 of the multilayer circuit board; as shown in FIG. 16C, the semiconductor power devices Q1, Q2 and Die Bond are arranged on the second surface 202 of the multilayer circuit board, then are wired to the PAD on the second surface 202 of the multilayer circuit board through wirebond, and then are fixed and protected by using a COB process; or as shown in FIG. 16B, components are placed and interconnected on the second surface 202 of the multilayer circuit board, and then the whole surface plastic packaging, silica gel filling, COB or spraying of the three-proofing paint is carried out to enhance protection. This is because if there is no protection, the size and reliability of the module are affected regardless of the waterproof, dust-proof, and electrical voltage-resistant insulation spacing.

FIG. 16D is the step-in of FIG. 16C, that is, filling assemblies (equivalent to second surface protection pieces) are additionally arranged on the outer edges of the two sides of the module PCB.

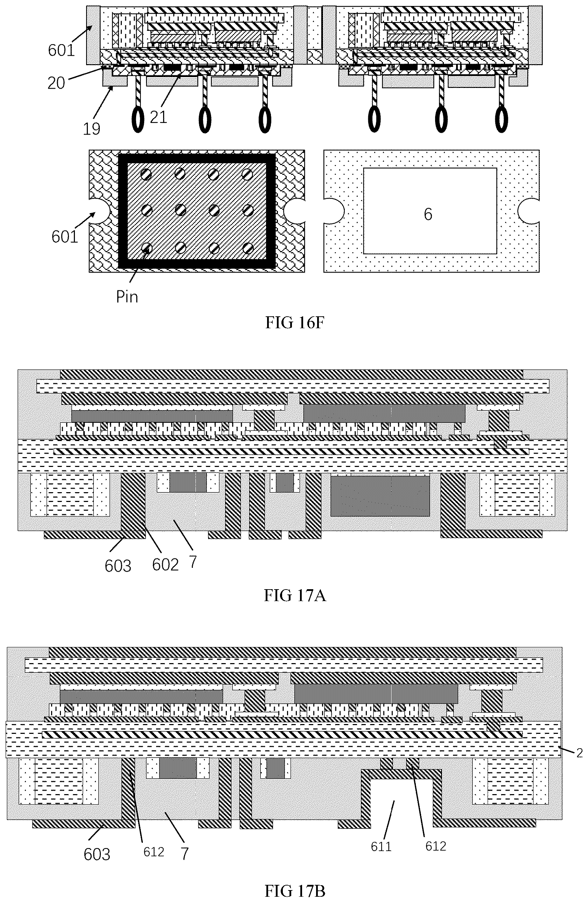

The filling assembly comprises a shell 19, a sealant 20 and a filling body 21 The shell 19 is fixed by means of the sealant 20 and covers the second surface 202 of the multi-layer circuit board, and filling body 21 is filled between the shell 19 and the second surface 202 of the multi-layer circuit board. The element on the second surface 202 of the multi-layer circuit board is within the range of the filling assembly, so that the protection of the filling body on the electronic element is realized, and the filling body herein can be silica gel or plastic packaging material. FIGS. 16E and 16F are two different implementations of FIG. 16D. FIG. 16E is a structural schematic diagram formed by performing a silica gel process flow on an independently formed plastic package module, so as to form a single module obtained by molding a rear panel, and the corresponding electronic element has been installed on the second surface 202 of the multilayer circuit board in the module, such as a resistor, capacitor, driving and IC pin, etc.

Firstly completing an independently formed packaging module; and a sealant 20 is arranged at the boundary of the filling range of the silica gel; the shell 19 is installed, and the shell 19 is fixed to the module through the sealant 20; then, silica gel is poured, related electronic elements are protected by silica gel in the module shell 19, so that the filling assembly 21 can be provided with a screw hole, and the mounting function of the module on the radiator 6 is considered. FIG. 16F is a schematic structural diagram of a multi-module plastic package panel after plastic packaging is completed but not de-paneled. The corresponding electronic components of each module have been installed on the second surface 202 of the multi-layer circuit board of the multi-module plastic package panel, such as resistor, capacitor, driving and IC pin, etc. First completing the multi-module plastic packaging panel; and a sealant 20 is arranged at the boundary of the filling range of the silica gel in each module; each module is installed corresponding to the shell 19, and the shell 19 is fixed to the module through the sealant 20; silica gel is poured in each module area, related electronic elements are protected by silica gel in the module shell 19, and a silica gel filling body 21 is formed; and then de-panel is carried out. Therefore, the silica gel filling efficiency can be greatly improved. However, the size of the filling assembly is smaller than that of the module, so that the fixing and mounting function of the finished module on the radiator 6 is not easily independently borne. The scheme of FIG. 16F is suitable for a module fixed to a screw hole of the radiator 6 to be arranged on the plastic package body 7, that is, a screw hole is formed in each of the two sides of the plastic package body 7, and the screw hole can be a whole hole, or a half hole is formed in order to save space

FIG. 16B is characterized in that the pins are led out from the side surfaces of the multi-layer circuit board 2 and the current passing through the side surface of the multi-layer circuit board is laterally collected through the multi-layer circuit board 2, and the current loss is large. As an embodiment of the double-sided plastic package, perpendicular to the plastic package body 7, the copper pillar is embedded and a via hole is formed, and the top end of the copper pillar is used as a bonding pad; or the via hole and the bonding pad are formed through electroplating; or after the copper pillar is embedded, the large-area bonding pad is electroplated at the top end.

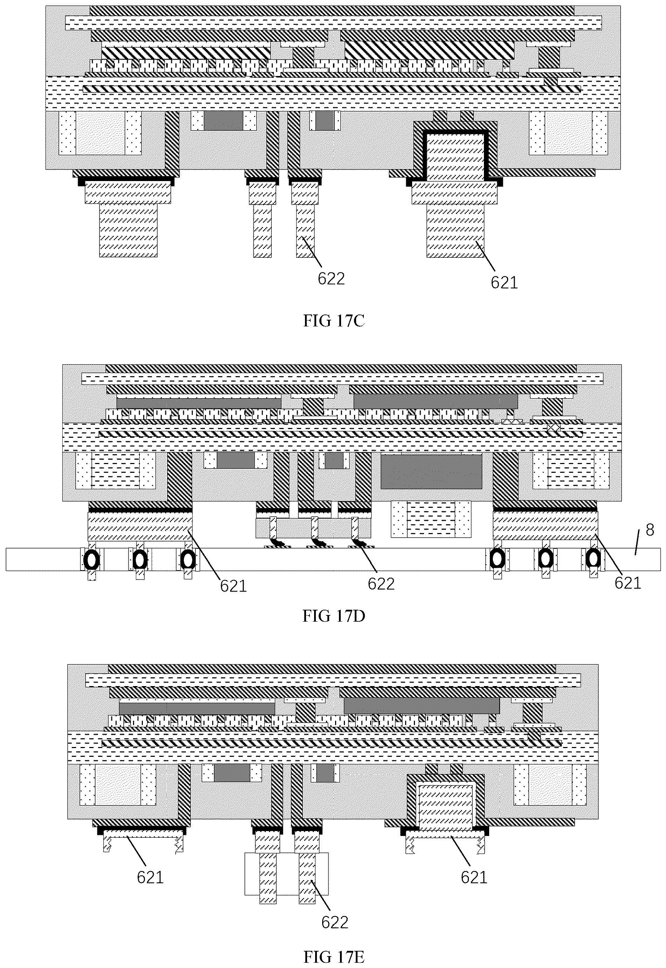

As shown in FIG. 17A, pins are welded on a plane, the welding strength is a great challenge, or the copper column 602 is embedded in the plastic package 7 or the silica gel filling body, and then the surface of the plastic package 7 near the copper column 602 is electroplated to form the bonding pad 603, so that only the cost is increased, and the process is relatively complex. As shown in FIG. 17B and FIG. 17C, a large deep counter bore 611 is used to add a plurality of small via holes 612; the large deep counter bore is formed by recessing a silica gel filling body or a plastic package body into the second surface of the circuit board; a bonding pad is formed by electroplating the surface of the large deep counter bore and the surface of the adjacent plastic package body 7 or the silica gel filling body; the plurality of small via holes 612 are arranged at the bottom of the large deep counter bore 611 and are electrically connected with the bonding pad and the circuit board, and a multiplexing bonding pad is formed to be used for welding power pins 621 of a large current. Due to the fact that the number of the small via holes 612 is large, the stroke is short, and the resistance is small; and the large deep counterbore 611 is large in surface area, large in diameter, large in pin welding strength and small in resistance.

As shown in FIG. 17D, a novel pin design is used in a module. Because the number of the signal pins 622 are relatively large, in the previous embodiments, the signal pins 622 are often required to use a through hole in the client applications. If the distance is large, the occupied area is large; if the distance is small, alignment is not easy to do during installation. According to the embodiment, the signal pin 622 is designed to be in pressure contact and is in contact with the plane bonding pad on the surface of the client mainboard, the power pin 621 is still designed by using the through hole to guarantee the large current capability. In this way, it is possible to achieve very convenient installation in a very small size.

As shown in FIG. 17E, the power pin 621 is threaded and guided through the cable to a distal position using a screw. The signal pin 622 is guided through the flat cable to a distal position. Due to the fact that the high-power occasion, the magnetic element and the capacitor element are large in size, the electrical connection position between the magnetic element and the power module is difficult to be matched with the size of the power module, and a great challenge is brought to system design. According to the embodiment, the high-frequency and high-power of the module can be ensured, and meanwhile, interconnection between the power pins and the signal pins is allowed through the cable.

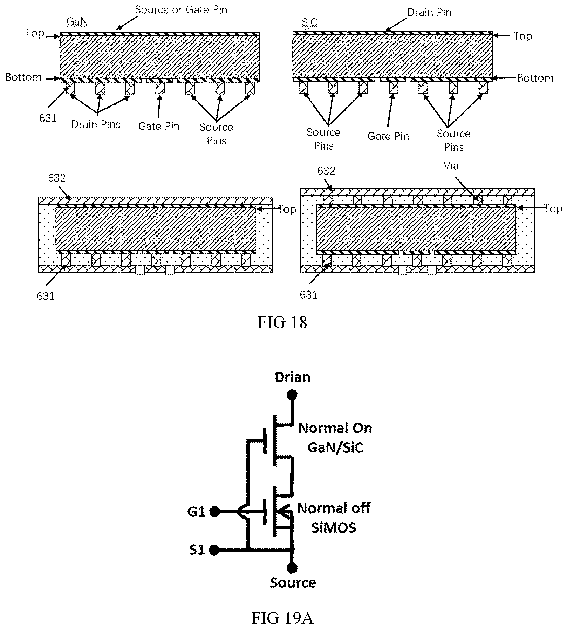

As an embodiment, as shown in FIG. 18, due to plastic packaging, the mold flow needs a certain gap to more reliably remove bubbles. If the semiconductor power devices Q1 and Q2 are directly welded to the module multi-layer circuit board of the module, because the metal layers on the surfaces of the semiconductor power devices Q1 and Q2 are very thin and are usually thinner than 10um, it means that the gap between the semiconductor power devices Q1, Q2 and the PCB is only less than 10um, reliability of removing bubbles cannot be achieved, and the reliability problems such as insufficient voltage resistance can be caused. A feasible scheme is that a copper column 631 is implanted on the electrode surface of the bottom surface of the semiconductor power device Q1 and Q2. The gap is raised to above 30um, and reliability of removing bubbles of the mold flow is facilitated. According to another feasible scheme, the semiconductor power devices Q1 and Q2 are packaged firstly, for example, an embedded process or an Fanout process, the air gap is raised by using the thick copper on the surface of the package, and the thick copper is good in thickness of 30um. The top surfaces of the semiconductor power devices Q1 and Q2 are directly coated with copper in a large area to form a copper-clad layer or a copper-clad layered electrode 632 formed by packaging, so that the thermal resistance of the top surfaces of semiconductor power devices Q1 and Q2 Top surfaces is not obviously influenced.

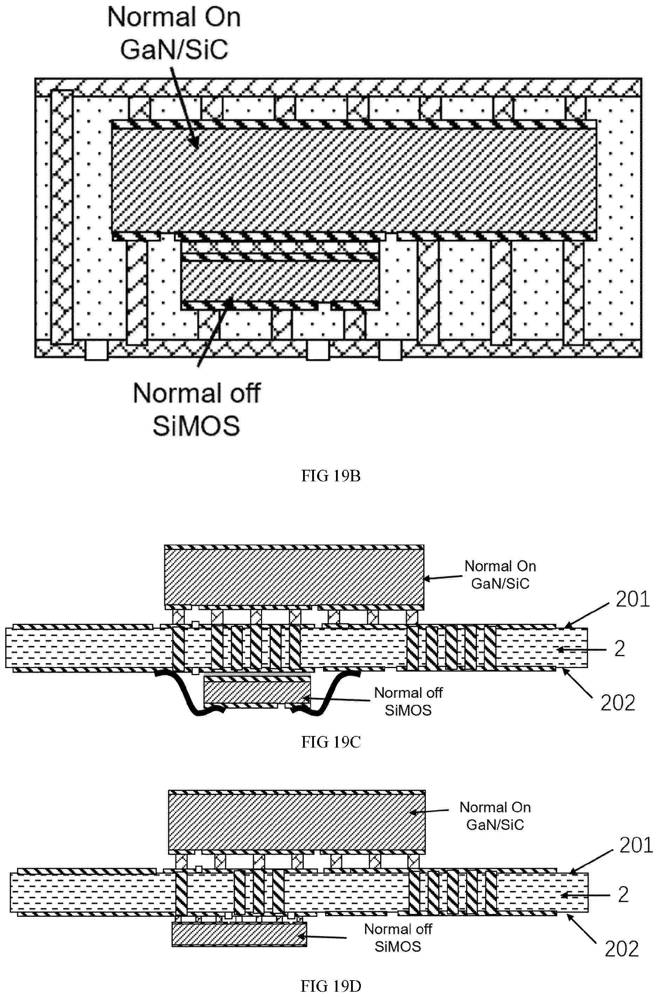

As an embodiment, as shown in FIGS. 19A~19D, because part of the GaN/SiC power devices is normal-ON, such as D mode of GaN and JFET of SiC. This type of devices has better performance, cost and reliability advantages. Due to the normal-ON, a low-voltage normally off device such as a low-voltage Si MOS or an E-Mode of GaN FET is usually required to be cascaded to form the semiconductor power devices Q1 and Q2 of the embodiment of the application. Due to the cascade structure, the semiconductor power devices Q1 and Q2 have both a power loop and a driving loop. In order to obtain the optimal performance, the power loop and the driving loop are needed to be as small as possible.

According to a preferred embodiment, a normal-on third-generation semiconductor sub-power device (ie, normal-on GaN/SiC) is cascaded with a normal-off SiMOS of a low-voltage normal-off semiconductor sub-power device, the normal-on, third-generation semiconductor sub-power device and the low-voltage normal-off semiconductor sub-power device form semiconductor power devices Q1 and Q2 in a laminated packaging mode, ie, and the drain electrode of the low-voltage normal-off semiconductor sub-power device is directly welded to the source electrode of the high-voltage device for packaging. The top surface of the package body transmits the heat generated by the high-voltage device to the TOP surface of the package body through the low thermal resistance, and leads out the electrodes and the low-loop inductor or inner interconnects of the electrodes and the low-loop inductor. In this way, the realization of high power and high frequency on the normal-on device can be considered.

As a further embodiment, the at least one semiconductor power device is a normal-on power device (ie, normal-on semiconductor), the normal-on type power device is provided with a low-voltage normal-off type semiconductor power device (ie, normal-off GaN/SiC), the normal-on power device is cascaded with the low-voltage normal-off semiconductor power device, the low-voltage normal-off semiconductor power device is arranged on the second surface 202 of the multi-layer circuit board, and the setting position of the low-voltage normal-off semiconductor power device corresponds to the position of the normal-on power device. Namely the low-voltage normal-off semiconductor power device and the normal-on power device are respectively SMD on the second surface 202 and the first surface 201 of the module multilayer circuit board and are interconnected through the circuit board. The large-power and high-frequency interconnection is realized on the premise that no process step is added. If the low-voltage normal-off semiconductor power device is Vertical MOS, Die Bond and Wirebond processes can be directly interconnected on the circuit board. If the low-voltage normal-off semiconductor power device is the Lateral MOS, the SMD can be directly carried out on the circuit board, and the low-voltage semiconductor power device is interconnected.

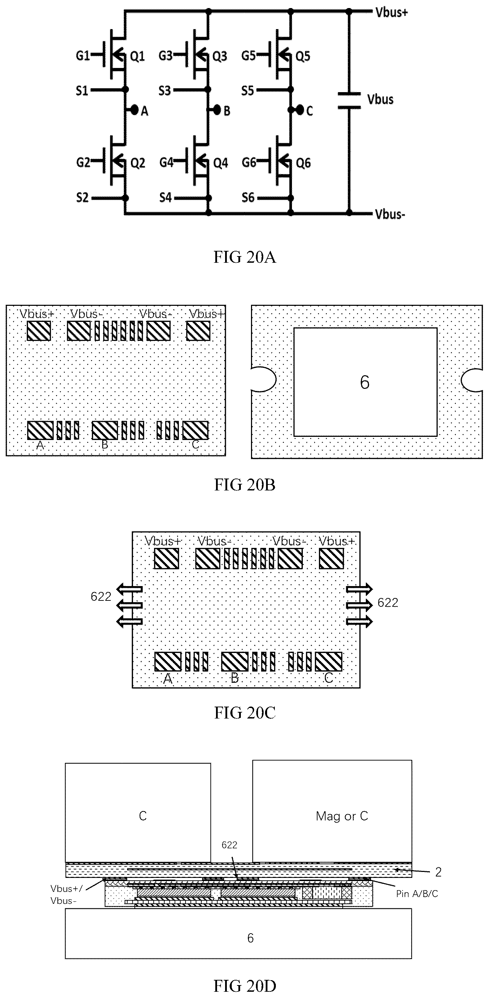

As an embodiment, as shown in FIG. 20A to FIG. 20D, the high-power converter often needs a plurality of power conversion bridge arms, that is, a plurality of large-current high-frequency voltage output pins, as Pin A, Pin B and Pin C in FIG. 20A. Serving as two pins Vbus+ and Vbus- of Vbus, in order to reduce the requirement of the internal capacitance of the module, Vbus+ and Vbus- can be designed into a plurality of pairs, so that the client can conveniently place corresponding capacitors on the mainboard, and the loop inductance between the capacitor of the client mainboard 8 and the high-frequency capacitor 1 in the module is reduced as much as possible. As shown in FIG. 20B, Vbus+ and Vbus- are placed on one side as a direct current Pin, an alternating current Pin A/B/C is placed on the other side, thereby facilitating a customer to set a high-power bulk capacitor and an alternating current magnetic element or capacitive element.

Due to the fact that the size of the module can be small, under certain high-voltage occasions, the distance between the high-voltage power Pin (direct current Pin, alternating current Pin) is short, and no space to dispose the signal Pin, such as a driving signal. Due to the use of the multi-layer circuit board 2, the position of the pin can be flexibly set, so that the embodiment of FIG. 20C is provided, the withstand voltage processing between the module pins can be considered, and the layout of the client can be facilitated.

Power pins (direct current pins Vbus+ and Vbus-, and alternating current pins Pin A/B/C) are arranged on the upper side and the lower side respectively, and the signal pins 622 are placed in the middle positions of the two rows of power pins. In this way, the signal pin 622 does not occupy the space position between the power pins, so that the size of the module is smaller, or the module is suitable for a higher working voltage scene due to the fact that the space is increased.

When the client is applied, the circuit board resources of the client mainboard above and below the module can be respectively used for the direct-current power pin and the alternating-current power pin, so that the large-current path is smooth. The signal pin 622 can be led out from the left side or the right side of the module, as shown in FIG. 20D, the signal pin 622 and the power pin do not interfere with each other.

Preferably, the minimum space between the driving pin and the power pin needs to exceed 4mm, so that the withstand voltage greater than 2kV can be realized. That is, the internal integrated signal of the module is isolated from the driving output of the driving IC. The function of isolating the driving power semiconductor is realized under the condition that the client does not need an external isolation element. A traditional module cannot realize large-power and isolated driving at the same time in such a small-size scene, such as a 6cm * 4cm area.

Preferably, the plurality of driving pins are inserted in advance so as to reduce the occupied area, and are compatible with clients board through welding or connector plug-in to lead out the signal pins 622. Due to the fact that the current of the driving pins is small, if each signal pin 622 is independently implanted, the required area of welding is large, and the space between the driving signal pins is increased.

Preferably, the lead-out of the signal pin 622 can be a flat wire of the flexible circuit board. A smaller size and a better anti-interference capability are achieved.

As an embodiment, as shown in FIG. 21A and FIG. 21B, when the pin-out of the module through SMD, the creepage distance is insufficient due to the fact that the module is very thin. According to the area 641 shown in FIG. 21A, the plastic package 7 is polished out of the step, or the area 642 shown in FIG. 21B is polished, and part of the multi-layer circuit board 2 and the plastic package 7 are polished at the same time to form a step shape to increase the creepage distance.

As an embodiment, as shown in FIG. 22A and FIG. 22B, the larger the creepage distance D between the module power pin 621 and the radiator 6 is, the better safety coefficient can be obtained, and even more than 6mm or even more than 12mm is met. If the thickness is increased to meet the creepage distance, it is obvious that it is not economical and practical. According to the application, the power pin 621 can be retracted, the surface distance of the circuit board 2 is fully utilized, and even the creepage distance is expanded by electrically insulating the surface distance of the electrical insulation pin bracket 643. The air distance from the surface of the insulating material to the other surface needs to have a certain length, for example, the distance between d1 is 0.5mm or above so that the client can be inserted into the insulating sheet, or more than 1mm can be directly filled with air.

As shown in FIG. 22B, the size of the pin is reduced due to the contracting the pins. Therefore, the outer side of the electrical insulation pin bracket 643 is arranged in a step shape, the air distance d2 between the upper surface of the step and the circuit board, and the air distance d1 between the lower surface of the step and the customer main board 8 are all set above 0.5mm, so that the customer can insert the insulation sheet; or both D1 and D2 are arranged above 1mm, and the electrical insulation pin bracket 643 can be directly filled with air. The number of steps can be adjusted as needed.

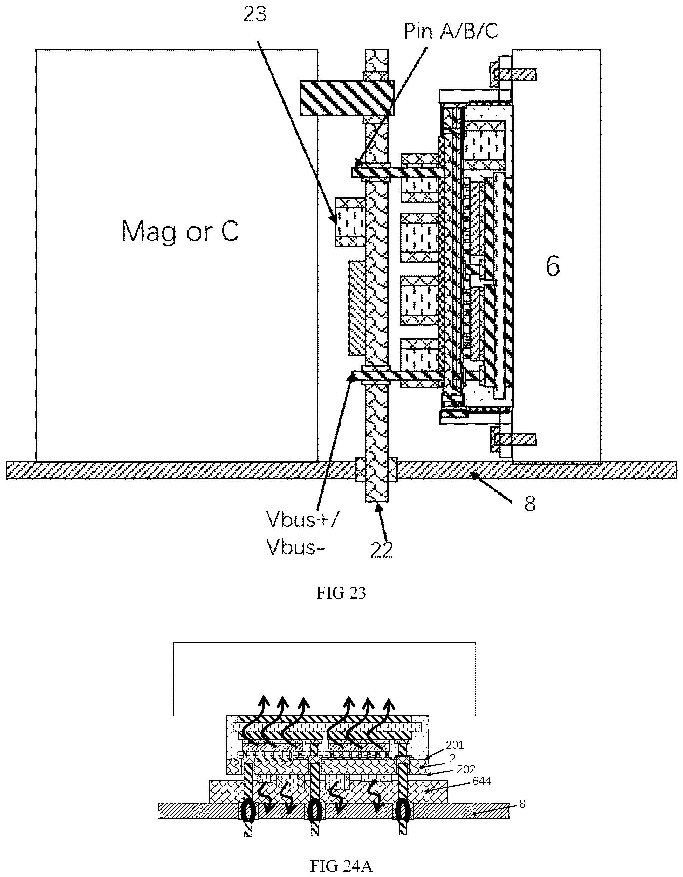

As an embodiment, as shown in FIG. 23, in the previous embodiments, the modules are mounted on the client motherboard 8 in horizontal direction. In a plurality of occasions, the module needs to be installed perpendicular to the client mainboard 8, so that the module and the radiator 6 are installed independently, and the optimal heat dissipation performance is obtained. The pin-out of the module needs to be adjusted to be parallel with the heat dissipation surface from perpendicular to the heat dissipation surface.

As shown in FIG. 23, a pin perpendicular to the surface of the module is used to be connected nearby to the client sub-board 22. The client sub-board 22 can be provided with a high-frequency decoupling capacitor 23, a high-voltage isolation driver or a controller and other system control elements. One side of the client sub-board 22 (such as the top side) is connected with one or all of the high-frequency pins of the power magnetic element, namely one or all of Pin A, Pin B and Pin C. The other side of the client sub-board 22 (such as the bottom side) is connected with the client main board 8 and connected with the Bulk capacitor through the main board. In this way, the respective paths are connected in a short way and do not interfere with each other, so that higher efficiency and power density can be realized.

As an embodiment, as shown in FIGS. 24A-24D, due to the highest operating temperature of the driving IC and the capacitor is often lower than the operating temperature of the SiC/GaN. For example, the highest working temperature of SiC is 175 °C , and the highest working temperature of the high-frequency capacitor 1 is 125°C. Therefore, if without specially processed, the performance and reliability of the high-frequency capacitor are affected due to the too high temperature.

As shown in FIG. 24A, when these elements are disposed on the outside of the multi-layer circuit board 2 of the module, a thermally conductive electrically insulating material 644 can be added between the elements and the client motherboard 8 to help heat the components.

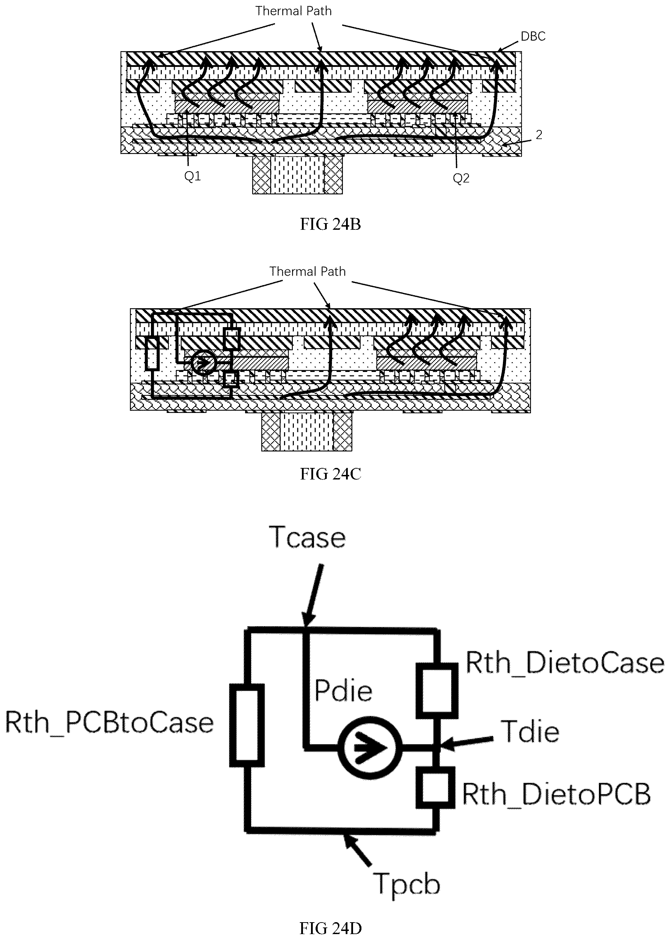

As shown in FIG. 24B and FIG. 24C and FIG. 24D, the thermal limit temperature of the high-density multilayer circuit board is often low, such as 145°C. Therefore, when the temperature of the semiconductor power devices Q1 and Q2 reaches 175°C, the thermal limit temperature of the high-density multilayer circuit board is often low, such as 145°C, and the multi-layer circuit board 2 needs to have its own heat dissipation channel Rth_PCBtoCase, that is, the total equivalent thermal resistance from the multi-layer circuit board 2 to the environment. And a certain thermal resistance Rth_DietoPCB needs to be arranged between the semiconductor power devices Q1 and Q2, so that the above thermal resistances, the power consumption Pdie of the Die and the thermal resistance Rth_DietoCase of the Die-to-DBC outer surface, namely the module Case, needs to meet a certain relationship, so that the temperature difference at the thermal resistance Rth_DietoPCB formed by the semiconductor power devices Q1 and Q2 through the multilayer circuit board 2 is close to or even larger than the highest tolerance temperature difference of the Die and the multilayer circuit board. That is, when the semiconductor power devices Q1 and Q2 reach the highest temperature TdieMAX, the temperature of the multilayer circuit board is less than or equal to the highest temperature resistance value TpcbMax. That is, (Tcase+(TdieMAX-Tcase) $\times$ Rth_PCBtoCase/(Rth_PCBtoCase+Rth_DietoPCB)) $\leq$ TpcbMax. It can be seen that the proper increase of Rth_DietoPCB is beneficial to control the temperature of the circuit board. The thermal resistance of 1m$\Omega$ resistor making of copper is about 150K/W. If 10W of heat is desired to form temperature difference above 30 °C from Die to PCB, then the thermal resistance from Die to PCB is Rth_DietoPCB^3K/W, that is, the parallel resistance of all copper connected to the multilayer circuit board from Die is greater than 0.02mOhm.

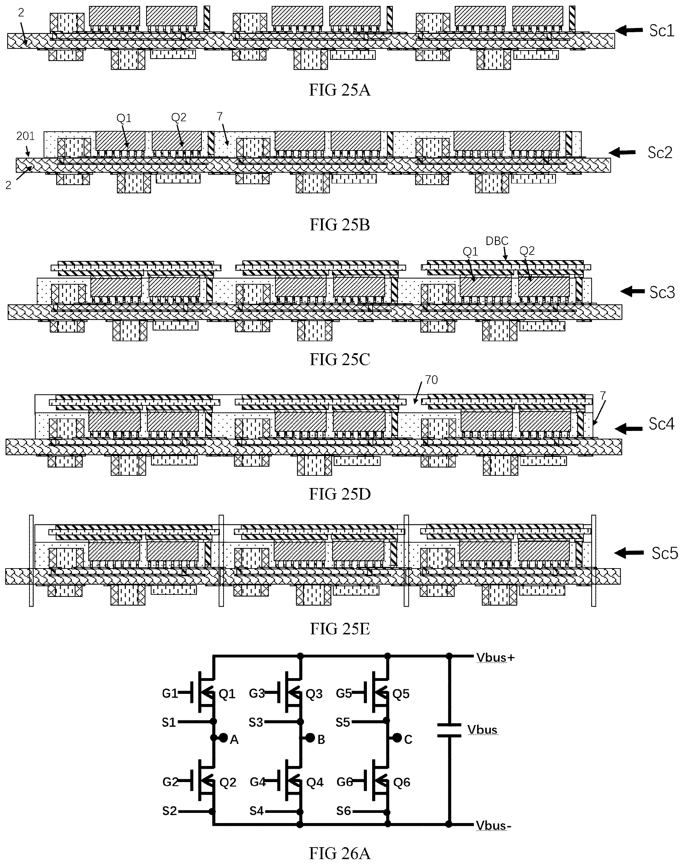

As an embodiment, as shown in FIG. 25A to FIG. 25E, in order to solve the problems that in the previous embodiment, only one-time plastic packaging is used, and the mode flow is difficult to control. According to the particularity of the structure of the scheme, two-time plastic packaging is carried out.

In the first step Sc1, corresponding elements such as semiconductor power devices Q1 and Q2, a high-frequency capacitor 1, a copper column connected with a DBC circuit board and the like are welded on one side or double sides of the multilayer circuit board 2 according to needs, as shown in FIG. 25A.

And a second step Sc2: performing plastic packaging one side of the circuit board 2 including the first surface 201 of the circuit board 2 and the semiconductor power devices Q1 and Q2 to form a plastic package 7, keeping the top surface of the semiconductor power devices Q1 and Q2 exposed after plastic packaging, and maintaining the weldability of the exposed semiconductor power devices Q1 and Q2 when necessary. For example, during plastic packaging, a protective film is added to a welding surface needing to be exposed; or after plastic packaging, a metal layer is flattened and plated. Due to the fact that the plastic package cavity is small, the moldflow is easier to control according to needs, as shown in FIG. 25B.

In the third step Sc3, the DBC is welded or bonded, so that the DBC has good heat-conducting capability with the semiconductor power devices Q1 and Q2, and the DBC has conductive capability when necessary, as shown in FIG. 25C.

In the fourth step Sc4, on the basis of one-time plastic packaging, the DBC and the primary plastic package body 7 are subjected to second plastic packaging to form the plastic package body 70, and whether the plastic package body 70 is polished after the plastic package is completed or not is determined according to needs, as shown in FIG. 25D.

A fifth step Sc5: de-panel to corresponding module, as shown in FIG. 25E.

As an embodiment, as shown in FIG. 26A to FIG. 26C, as the application is suitable for high-frequency and high-voltage occasions, the problem that high-voltage and high-frequency jump is easy to occur is solved. In order to better dissipate heat, the thickness of the insulating heat conducting layer 3 is reduced by using a plastic packaging structure, such as 0.4mm or less and even 0.3mm or below, so that the parasitic capacitance between the upper metal layer 4 and the lower metal layer 5 on the two surfaces of the insulating heat conducting layer 3 is very large. The upper metal layer 4 is connected to the heat sink 6 so as to be grounded. If the electric potential of the lower metal layer 5 is high-frequency and high-voltage jump, the common-mode current is large, and the electromagnetic interference of the system is increased.

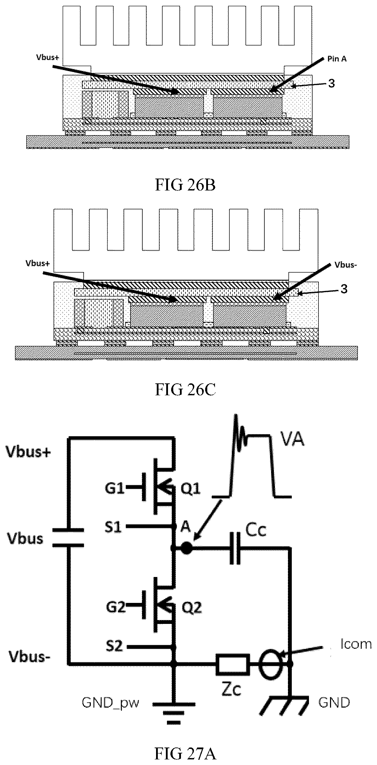

As shown in FIG. 26A, the two ends of each power conversion bridge arm are direct-current voltages, the electric potentials of Vbus+ and Vbus- are relatively flat, and large electromagnetic interference is not likely to be caused. The midpoint of the power conversion bridge arm, such as A, B and C points, has a high-frequency high-voltage jump potential, and most electromagnetic interference of the system comes from such potential. FIG. 26B shows a conventional processing method, namely the upper power switch and lower power switch, such as Q1 and Q2, the drain electrodes are set to the thermal dissipated surface; In FIG. 26A, Vbus+ and A potential are respectively set to the thermal dissipated surface, so that the drain electrode namely A potential of Q2, can cause great electromagnetic interference.

As shown in FIG. 26C, a bridge arm switch with different heat dissipation surfaces is selected in the embodiment. If power currents flowing such as SiC/MOS IGBTs vertically penetrate through the devices on the upper surface and the lower surface of the semiconductor power devices Q1 and Q2, the heat dissipation surface of the upper power switch Q1 is a drain electrode, and the heat dissipation surface of the lower power switch Q2 is a source electrode. Namely, the electric potential connected to the DBC is an electrostatic potential, such as Vbus+ and Vbus-, so that common-mode electromagnetic interference is greatly reduced.

If the power current flows on the same surface of the semiconductor power devices Q1 and Q2, such as GaN, the heat dissipation surface of the upper power switch Q1 is a drain electrode, and the heat dissipation surface of the lower power switch Q2 is a source or a gate electrode. The electric potential connected to the DBC is an electrostatic potential, such as Vbus+ and Vbus- or Vbus+ and Vgs, so that common-mode electromagnetic interference is greatly reduced. Because the jump voltage and the electrostatic potential are opposite, the electrostatic potential can be defined as one tenth of the voltage of the bridge arm power device Vds, namely the A voltage. For situations where a generally A voltage amplitude is greater than 400V, a driving voltage lower than 20V can be regarded as an electrostatic potential.

As an embodiment, as shown in FIG. 27A to FIG. 27C, a common mode suppression capacitor 24 (Y capacitor) for suppressing common mode noise is integrated into the module nearby, so that common mode noise, especially high frequency common mode noise, is pressed in the module.

As shown in FIG. 27A, a middle point of a power conversion bridge arm is a high-frequency high-voltage jump VA, and at least one electrode of two interconnection electrodes of a semiconductor power device Q1 or Q2 is usually a drain electrode of Q2 applying a SiC power switch, and a source electrode of Q1 applying a GaN power switch and is electrically connected to a lower metal layer 5 of the DBC, so that a large parasitic common-mode capacitor Cc is formed through the insulating heat-conducting layer 3 and the DBC upper metal layer 4, and the capacitor is short-circuited to the radiator 6, so that the capacitor is connected with the ground GND. Namely, the voltage source VA forms a large common-mode current ICOM through the impedance between the Cc and the ground and the power ground GND_pw.

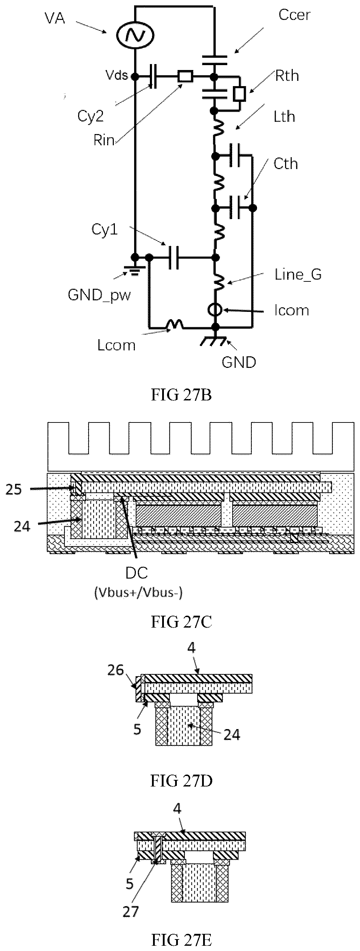

The actual system is far more complex than shown in FIG. 27A, as shown in FIG. 27B, the radiator 6 is a combination of a multi-parasitic inductance and a plurality of pairs of geodetic parasitic capacitors. Even if the Y capacitor Cy1 and the common-mode inductor Lcom are added between the ground and the power ground in the system, the complexity of the parasitic circuit is greatly reduced, or the suppression effect is greatly reduced, or the common-mode inductor and the capacitor with larger size can be inhibited. According to the application, the Y capacitor Cy2 and the integrated damping Rin are integrated in the module nearby, that is, the common mode energy is inhibited in the module before the complex parasitic circuit, so that the whole radiator 6 is almost free of voltage drop. Line_G is a wiring ground connected with the ground, Ccer is a ceramic equivalent capacitor, Rth is the contact resistance of the outer copper and the radiator, Lth is a radiator distribution inductance, and Cth is a radiator distribution capacitance.

In order to achieve a better effect, a damping element, such as a resistor or a high-impedance magnetic bead, can be added to the built-in Y capacitor.

FIG. 27C is an implementation solution of a specific structure, that is, a Y capacitor is provided in the module, one electrode of the Y capacitor is electrically connected to the upper metal layer 4 by means of the cross-ceramic layer electrical connection assembly 25, and the other electrode of the Y capacitor is electrically connected to the electrode on the top surface of the first power device by means of the lower metal layer 5, so that the equivalent effect of FIG. 29B can be achieved.

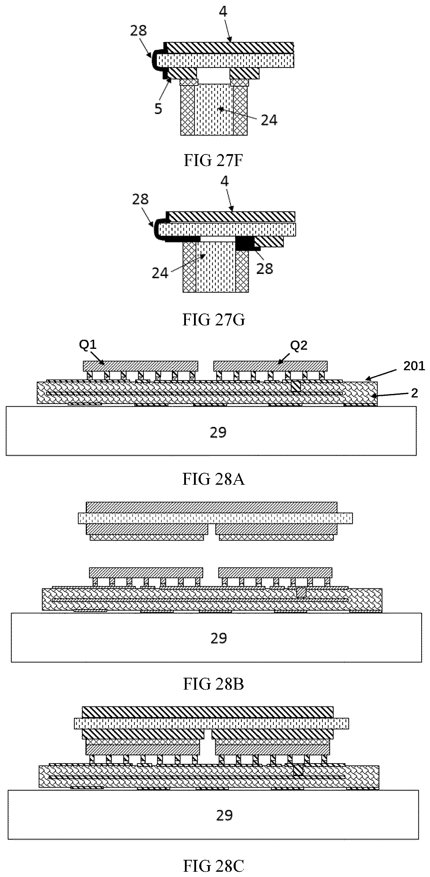

As shown in FIGS. 27D-27G, since the upper metal layer 4 of the DBC is to be mounted to the heat sink 6, the requirement for the flatness thereof is very high. The cross-ceramic layer electrical connection assembly 25 interconnecting the Y capacitor to the upper metal layer 4 cannot exceed the upper metal layer 4. In FIG. 27D, the cross-ceramic layer electrical connection assembly 25 is a side edge electrical interconnection piece 26 which is arranged on the side edge of the insulating heat-conducting plate, one end of the side edge electrical interconnection piece 26 is electrically connected with the upper metal layer 4, and the other end of the side edge electrical interconnection piece 26 is electrically connected with the Y capacitor through the lower metal layer 5. In FIG. 27E, the cross-ceramic layer electrical connection assembly 25 is a through-type electrical interconnection piece 27, the through-type electrical interconnection piece 27 penetrates through the insulation heat-conducting layer 3, one end of the through-type electrical interconnection piece 27 is electrically connected with the upper metal layer 4, and the other end of the through-type electrical interconnection piece 27 is electrically connected with the common-mode suppression capacitor 24 through the lower metal layer 5. In FIG. 27F and FIG. 27G, since the copper wire welding process is complex to operate and the current of the Y capacitor is small, the scheme shown in FIG. 27F can use the conductive coating 28 to interconnect the upper metal layer 4 and the lower metal layer 5 of the DBC, for example, a silver paste coating. As shown in FIG. 27C, due to the fact that the height of the Y capacitor is large, a groove is formed on the first surface of the circuit board to dispose the Y capacitor, and the DBC lower metal layer 5 is locally thinned. However, an additional process is needed for local thinning of the copper layer. The conductive coating 28 can be used for achieving the thinning effect on the basis of the scheme shown in FIG. 27F, that is, the interconnection of the Y capacitor and the conductive coating 28 shown in FIG. 27G can be directly realized by using the viscosity of the conductive coating 28, and can also be bonded through the conductive adhesive.

According to the embodiment, the manufacturing of the module is completed through multiple times of welding, the technological process is large, the thermal resistance electrical connecting layer 12 needs to be made at the bottom of the semiconductor power devices Q1 and Q2, the manufacturing process time is long, and the cost is high. Therefore, a simplified manufacturing method is provided, as shown in FIGS. 28A to 28D, specifically as follows:
In the first step Sd1, the semiconductor power devices Q1 and Q2 are placed on the first surface 201 of the multilayer circuit board, welding materials are arranged between the front surfaces of the semiconductor power devices Q1 and Q2 and the multilayer circuit board, and then the multilayer circuit boards 2 on which the semiconductor power devices Q1 and Q2 are placed is arranged on a supporting platform 29. The welding material can be printed on the multi-layer circuit board 2, and can also be preset on the front surfaces of the semiconductor power devices Q1 and Q2. In order to reduce the welding temperature difference, the supporting platform 29 below the multilayer circuit board 2 may also be a heating plate, as shown in FIG. 28A.

A second step Sd 2: placing the DBC on the TOP surface of the semiconductor power devices Q1 and Q2, a welding material being provided between the TOP surfaces of the semiconductor power devices Q1 and Q2 and the DCB, and the welding material being printed on the DBC or preset on the TOP surfaces of the semiconductor power devices Q1 and Q2, as shown in FIG. 28B and FIG. 28C.

A third step Sd3: pressing a heating flat plate 30 on the DBC and then heating, wherein the DBC and the semiconductor power devices Q1 and Q2 are both good thermal conductors, and the heat can be quickly transferred to each welding spot. In order to reduce energy consumption and heating speed, the copper layer of the DBC can be heated by electrical induction heating, as shown in FIG. 28D.

In the embodiment shown above, in order to meet the safety insulation requirement, the vertical electrical connection path 130 in the multi-layer circuit board 2 is close to the edge of the module as much as possible. In some applications which do not need safety insulation, such as 48V low-voltage electrode driving or rectification inverter application, or the radiator 6 is connected to a power ground and non-geodetic of an converter, since the withstand voltage requirement is relatively low, a large safety distance requirement is not needed, so that the thickness of the module can be further reduced.

As shown in FIG. 29A, the low-circuit pad 31 is arranged on the second surface 202 of the multi-layer circuit board, the high-frequency capacitor 1 can be welded to the second surface 202 of the circuit board 2 through the low-circuit pad 31, the vertical electrical connection path 130 is arranged close to the low-circuit pad 31 as much as possible, the two electrodes of the high-frequency capacitor 1 form a low loop with the semiconductor power device through the vertical electrical connection path 130, the wiring layer in the multi-layer circuit board, the first surface 201 of the multi-layer circuit board and the semiconductor power device. In the low loop, the transmission path of the high-frequency signal is short, the envelope area of the loop is small, and therefore the parasitic inductance and other parasitic parameters in the loop are small, so that the peak voltage is reduced, and the loss is reduced. In the same manner as the previous embodiment, the electrode provided on the back surface of the semiconductor power device is connected to the insulating heat-conducting plate by means of the heat-conducting electrically insulating material 644, and the area of the back surface area of the semiconductor power device exceeds 80% and is set to be an electrostatic potential, so as to reduce common-mode interference.

In another embodiment, as shown in FIG. 29B, the module is arranged on one surface of the client mainboard 8 through surface patch welding, the high-frequency capacitor 1 and the module are correspondingly arranged on the other surface of the client mainboard 8, and the high-frequency capacitor is arranged close to the low-circuit bonding pad 31 of the module, so that the wiring of the high-frequency capacitor electrically connected with the low-loop bonding pad through the client mainboard is as short as possible, and a low loop is formed. The same high-frequency effect is obtained in this structure, meanwhile, the number of internal elements of the module is reduced, the yield of the module is improved, the height of the module is reduced, and the cost is saved.

Referring to FIG. 29C, on the basis of the application shown in FIG. 29B, a radiator 6 is assembled on the upper surface of the module, heat generated by the semiconductor wafer is guided to the heat dissipation device 6 through the insulating heat-conducting plate, and the heat dissipation device 6 is connected and assembled with the client mainboard 8 through the fixing column 32. The heat dissipation capability of the module is improved, and meanwhile, the stability of the module is also enhanced.

According to the application, the reduction of the extreme loop and the excellent heat-conducting performance are considered, so that the manufacturing of the high-frequency high-power packaging module is realized, and the high-frequency high-power packaging module is electrically insulated from the heat dissipation surface and has a good heat-conducting effect. Therefore, the selection of the insulating heat-conducting material of the DBC is particularly important, and the material with high thermal conductivity, such as aluminum oxide, aluminum nitride and silicon nitride materials, is better; and the DBC of the case refers to an electrically insulating substrate with good conductivity, and is not limited to a DBC body. The circuit board essentially refers to a multilayer circuit wiring layer, which is not limited to an independent multilayer circuit board, and can also be a wiring layer with the same function formed in a module process. The semiconductor power device can also be suitable for semiconductor wafers or semiconductor chips and is suitable for the technical scheme disclosed by the application. The application provides a high-frequency and high-power module scheme capable of dealing with the future demand trend, various improving schemes are provided to play the potential of the application, part of the improving scheme is also suitable for other application scenes, and the scheme is not necessarily limited to the method disclosed by the application.

**Claims**

1.   A high-frequency high-power packaging module, comprising at least one power conversion bridge arm, at least one high-frequency capacitor, a circuit layer, an insulating heat-conducting plate, and a plastic package body;

wherein the at least one power conversion bridge arm comprises at least two semiconductor power devices connected in series;
wherein the at least one high-frequency capacitor and the at least one power conversion bridge arm are connected in parallel to form a high-frequency loop;
wherein the circuit layer comprises a first surface, an inner-layer electrical connection layer, a second surface and at least one vertical electrical connection path, and the inner-layer electrical connection layer is electrically connected with the first surface through the at least one vertical electrical connection path;
wherein the insulating heat-conducting plate comprises an insulating heat-conducting layer, and an upper metal layer and a lower metal layer which are respectively arranged on an upper surface and a lower surface of the insulating heat-conducting layer;
wherein the plastic package body fills a gap area between the second surface of the circuit layer and the upper surface of the insulating heat-conducting plate, an external electrode is arranged on the second surface or a side edge of the circuit layer, and the external electrode is electrically connected with the at least one power conversion bridge arm;
wherein a front surface of each of the at least two semiconductor power devices is electrically connected with the first surface of the circuit layer, and a back surface of each of the at least two semiconductor power device is thermally connected with or electrically connected with the lower surface of the insulating heat-conducting plate;
wherein the at least one high-frequency capacitor is electrically connected to the first surface of the circuit layer or the second surface of the circuit layer or a lower surface of the insulating heat-conducting plate, and at least one electrode of the at least one high-frequency capacitor is electrically connected to at least one electrode of one of the at least two semiconductor power devices by means of the inner-layer electric connection layer.

2. The high-frequency high-power packaging module of claim 1, wherein the semiconductor power device is electrically connected to the first surface of the circuit layer by means of a thermal resistance electrical connection layer.

3. The high-frequency high-power packaging module of claim 2, wherein the thermal resistance Rth_DietoPCB of the thermal resistance electrical connection layer meets the following formula:

$$(Tcase+(TdieMAX-Tcase) \times Rth\_PCBtoCase/(Rth\_PCBtoCase+Rth\_DietoPCB)) \leq TpcbMax;$$

Tcase is the ambient temperature when the high-frequency high-power packaging module works, TdieMAX is the highest working temperature of the semiconductor power device, Rth_PCBtoCase is the total equivalent thermal resistance value from the circuit layer to the upper surface of the insulating heat-conducting plate, and TpcbMax is the highest working temperature of the circuit layer.

4. The high-frequency high-power packaging module of claim 2, wherein the thermal resistance value of the thermal resistance electrical connection layer is at least 3K/W.

5. The high-frequency high-power packaging module of claim 1, wherein an upper surface of the insulating heat-conducting plate is thermally connected to a radiator, and an air gap is provided between an upper surface of the plastic package and the radiator.

6. The high-frequency high-power packaging module of claim 1, wherein when the high-frequency capacitor is electrically connected with the first surface of the circuit layer, the height Hc of the high-frequency capacitor meets the following conditions:

$$H1 \leq Hc < H2;$$

H1 is a distance from the first surface of the circuit layer to the back surface of the semiconductor power device, and H2 is a distance from the first surface of the circuit layer to the lower surface of the insulating heat-conducting layer;
and the insulating heat-conducting plate extends above the high-frequency capacitor; and the lower metal layer located between the high-frequency capacitor and the insulating heat-conducting layer is isolated from the high-frequency capacitor in a thinning or removing mode.

7. The high-frequency high-power packaging module of claim 1, wherein when the high-frequency capacitor is electrically connected with the first surface of the circuit layer, the height Hc of the high-frequency capacitor meets the following conditions:

$$H2 \leq Hc < H3;$$

H2 is a distance from the first surface of the circuit layer to the lower surface of the insulating heat-conducting layer, and H3 is a distance from the first surface of the circuit layer to the upper surface of the insulating heat-conducting layer;
wherein the insulating heat-conducting plate is located above a device other than the high-frequency capacitor on the second surface of the circuit layer.

8. The high-frequency high-power packaging module of claim 1, wherein when the high-frequency capacitor is electrically connected with the second surface of the circuit layer, the two electrodes of the high-frequency capacitor are electrically connected with the inner-layer electrical connection layer and the first surface of the circuit layer through the vertical electrical connection paths respectively.

9. The high-frequency high-power packaging module of claim 1, wherein when the high-frequency capacitor is electrically connected with the lower surface of the insulating heat-conducting plate, at least one electrode of the high-frequency capacitor is electrically connected with the inner-layer electrical connecting layer through an electrical connecting piece, and the height He of the high-frequency capacitor meets the following conditions :

$$H1 \leqslant Hc < H4;$$

wherein H1 is a distance from the first surface of the circuit layer to the back surface of the semiconductor power device, and H4 is a distance from the second surface of the circuit layer to the lower surface of the insulating heat-conducting layer;

the circuit layer located below the high-frequency capacitor is isolated from the high-frequency capacitor in a thinning or removing mode.

10. The high-frequency high-power packaging module of claim 1, wherein a power electrode of the semiconductor power device is located on the front surface of the high-frequency high-power packaging module.

11. The high-frequency high-power packaging module of claim 10, further comprising:
at least one electrical connecting hole, and the electrical connecting hole is used for realizing electrical connection between the front electrode of the semiconductor power device and the circuit board.

12. The high-frequency high-power packaging module of claim 10, wherein the back electrode of the semiconductor power device is electrically connected to the first surface of the circuit layer by means of the lower metal layer and the conductive assembly of the insulating heat-conducting plate in sequence.

13. The high-frequency high-power packaging module of claim 10, wherein a back electrode of the semiconductor power device is electrically connected to the front surface of the semiconductor power device through a conductive through hole formed in the back electrode.

14. The high-frequency high-power packaging module of claim 1, wherein at least one power electrode of the semiconductor power device is a back power electrode, the back power electrode is electrically connected to a first surface of the circuit layer through a lower metal layer and a conductive assembly of the insulating heat-conducting plate, and the lower metal layer is a thick copper layer.

15. The high-frequency high-power packaging module of claim 1, wherein a high-heat-capacity element is arranged in the circuit layer, and the high-heat-capacity element is in thermal connection or electrical heating connection with the inner-layer electrical connection layer.

16. The high-frequency high-power packaging module of claim 1, wherein a projection of a wiring connected to the two ends of the high-frequency capacitor in the circuit layer in the horizontal direction overlaps with a projection of the semiconductor power device in the horizontal direction.

17. The high-frequency high-power packaging module of claim 16, wherein a plurality of semiconductor power devices are electrically connected in parallel, the high-frequency high-power packaging module further comprises a distributed vertical connecting piece, and each semiconductor power device is arranged adjacent to the corresponding vertical connecting piece.

18. The high-frequency high-power packaging module of claim 17, wherein the distributed vertical connecting piece comprises a first vertical connecting piece and a second vertical connecting piece, the diameter of the first vertical connecting piece is larger than that of the second vertical connecting piece, and the first vertical connecting piece is arranged adjacent to the side face of the high-frequency high-power packaging module.

19. The high-frequency high-power packaging module of claim 1, wherein the high-frequency high-power packaging module further comprises buffer outer pins, and the buffer outer pins are used for electrically connecting the high-frequency high-power packaging module with the client mainboard.

20. The high-frequency high-power packaging module of claim 19, wherein the buffer outer pin is arranged on the second surface of the circuit layer.

21. The high-frequency high-power packaging module of claim 19, wherein the buffer outer pin is arranged on the side edge of the circuit layer.

22. The high-frequency high-power packaging module of claim 21, wherein the inner side of the buffer outer pin is welded to the side edge of the circuit layer, and an insulating reinforcing frame is arranged on the outer side of the buffer outer pin.

23. The high-frequency high-power packaging module of claim 19, further comprising:an elastic insulating fixing frame, wherein the elastic insulating fixing frame is used for enabling the high-frequency high-power packaging module to be tightly attached to a radiator arranged on the upper surface of the insulating heat-conducting plate.

24. The high-frequency high-power packaging module of claim 23, wherein the elastic insulating fixing frame comprises an elastic member and an insulating reinforcing frame, one end of the elastic member is connected to the radiator, the other end of the elastic member is inserted into the insulating reinforcing frame, and the insulating reinforcing frame limits the high-frequency high-power packaging module by means of the edge limiting structure.

25. The high-frequency high-power packaging module of claim 23, wherein the elastic insulating fixing frame comprises an insulating reinforcing frame with an elastic material, the insulating reinforcing frame limits the high-frequency high-power packaging module through an edge limiting structure, and the insulating reinforcing frame is connected with the client mainboard and the radiator through the through-type fixing assembly.

26. The high-frequency high-power packaging module of claim 19, wherein a mounting area is formed between the second surface of the circuit layer and the client mainboard, and at least one circuit element is arranged in the mounting area.

27. The high-frequency high-power packaging module of claim 19, wherein the buffer outer pin is led out by means of the redistribution structure.

28. The high-frequency high-power packaging module of claim 19 further comprising:a second surface protection part, wherein the second surface protection part comprises a shell, sealant and a filling body, the shell is fixed and covers the second surface of the circuit layer through the sealant, a filling body is filled between the shell and the second surface of the circuit layer, and the filling body can be silica gel or plastic packaging material;
the shell is provided with an outer pin through hole for buffering the extension of the outer pin.

29. The high-frequency high-power packaging module of claim 28, wherein one end of the shell is fixedly connected with a radiator arranged on the upper surface of the insulating heat-conducting plate.

30. The high-frequency high-power packaging module of claim 28, wherein the high-frequency high-power packaging module is provided with an extension area which is not covered by the second surface protection part in the horizontal direction, and a fixing hole for fixing is formed in the extension area.

31. The high-frequency high-power packaging module of claim 28, wherein the buffer outer pins are led out through a redistribution structure.

32. The high-frequency high-power packaging module of claim 28 further comprising:at least one copper column and at least one bonding pad, wherein the at least one copper column is embedded in the second surface protection part, and the at least one bonding pad is arranged on the surface of the second surface protection part and is electrically connected with the copper column.

33. The high-frequency high-power packaging module of claim 28, wherein the second surface protection part comprises at least one multiplexing bonding pad, the multiplexing bonding pad comprises at least one large deep sinking hole, at least one small via hole and at least one bonding pad, the large deep sinking hole is formed by recessing the surface of the second surface protection part facing the second surface of the circuit board, the bonding pad covers the surface of the large deep sinking hole and extends out of the large deep sinking hole, the small via hole is formed in the bottom of the large deep sinking hole and electrically connected with at least one bonding pad and a circuit board, and the multiplexing bonding pad is used for welding power pins.

34. The high-frequency high-power packaging module of claim 19-33, wherein the buffer outer pin is one of a direct-inserting welding pin, a direct-inserting crimping pin, a surface contact crimping pin and a surface contact welding pin.

35. The high-frequency high-power packaging module of claim 1, wherein a copper column is arranged below a front electrode of the semiconductor power device, and a height of the copper column is at least 30μm.

36. The high-frequency high-power packaging module of claim 1, wherein each of the at least two semiconductor power device has at least two different thicknesses, and copper columns or metal balls with different heights are arranged below the front electrode of the semiconductor power device.

37. The high-frequency high-power packaging module of claim 1, wherein each of the at least two semiconductor power device has at least two different thicknesses, a copper column is arranged below the front electrode of at least one thicker semiconductor power device, and a metal ball is arranged below the front electrode of the at least one thinner semiconductor power device.

38. The high-frequency high-power packaging module of claim 1, wherein the front electrode of the semiconductor power device is a thick copper electrode formed by packaging, and the height of the thick copper electrode is at least 30μm.

39. The high-frequency high-power packaging module of claim 1, wherein a copper-clad layer is provided above a back electrode of the semiconductor power device.

40. The high-frequency high-power packaging module of claim 39, wherein the semiconductor power device has at least two different thicknesses, and the copper-clad layer above the back electrode of the semiconductor power device has a corresponding different thickness.

41. The high-frequency high-power packaging module of claim 1, , wherein the back electrode of the semiconductor power device is a copper-clad layered electrode formed by packaging.

42. The high-frequency high-power packaging module of claim 1, wherein a power electrode and a gate electrode are arranged on the back surface of at least one semiconductor chip, and the power electrode is connected to the electrostatic potential of the circuit.

43. The high-frequency high-power packaging module of claim 42, wherein a gate electrode of the semiconductor power device is bonded to the circuit layer through an electric connecting wire, and welding spots of the gate electrode are protected through glue dispensing treatment.

44. The high-frequency high-power packaging module of claim 1, wherein the semiconductor power device is an LDMOS device with a substrate electric potential capable of being arranged, and the substrate electric potential is set as an electrostatic potential of the high-frequency high-power packaging module.

45. The high-frequency high-power packaging module of claim 44, wherein the substrate of the LDMOS device is made of sapphire.

46. The high-frequency high-power packaging module of claim 1, wherein at least one semiconductor power device comprises a normal-on third-generation semiconductor sub-power device and a low-voltage normal-off semiconductor sub-power device, the normal-on third-generation semiconductor sub-power device is cascaded with the low-voltage normal-off semiconductor sub-power device, and the normal-on third-generation semiconductor sub-power device and the low-voltage normal-off semiconductor sub-power device form a semiconductor power device in a laminated packaging mode.

47. The high-frequency high-power packaging module of claim 1, wherein at least one semiconductor power device is a normal-on power device, the normal-on power device is provided with a low-voltage normal-off semiconductor power device in a matched mode, the normal-on power device is cascaded with the low-voltage normal-off semiconductor power device, the low-voltage normal-off semiconductor power device is arranged on the second surface of the circuit layer, and the setting position of the low-voltage normal-off semiconductor power device is perpendicular to the position of the normal-on power device.

48. The high-frequency high-power packaging module of claim 1, wherein a plurality of power conversion bridge arms are arranged in parallel, and the direct-current end external electrodes and the alternating-current end external electrodes of the power conversion bridge arms are arranged on the two sides of the high-frequency high-power packaging module respectively.

49. The high-frequency high-power packaging module of claim 1, wherein a side edge of the plastic package body is in a step shape.

50. The high-frequency high-power packaging module of claim 1, further comprising:a client sub-board, the client sub-board being used for electrically connecting the external electrode to a client main board, the client sub-board and the circuit layer being arranged in parallel, and the client sub-board and the circuit layer being respectively perpendicular to the client main board.

51. The high-frequency high-power packaging module of claim 50, wherein a direct-current end external electrode of the at least one power conversion bridge arm is arranged on one side close to a client mainboard, an alternating-current end external electrode of the power conversion bridge arm is arranged on one side far away from the client mainboard, and an alternating-current end external electrode of the power conversion bridge arm is electrically connected with an external alternating-current device arranged on the client mainboard through a client sub-board.

52. The high-frequency high-power packaging module of claim 1, wherein the back electrodes of the two semiconductor power devices in each power conversion bridge arm are electrodes such as the two direct-current ends of the power conversion bridge arm respectively.

53. The high-frequency high-power packaging module of claim 1, further comprising:a heat-conducting column, wherein the heat-conducting column is arranged on the upper surface of the insulation heat-conducting plate, and the heat-conducting column is used for liquid cooling heat dissipation.

54. The high-frequency high-power packaging module of claim 53, wherein an area, perpendicular to the semiconductor power device, of the upper surface of the insulating heat-conducting plate is a first heat dissipation area, and a set number density of the heat-conducting column in the first heat dissipation area is larger than a set number density of the heat-conducting column outside the first heat dissipation area.

55. The high-frequency high-power packaging module of claim 53, wherein the heat-conducting column comprises a metal shell and an ultrahigh heat-conducting filler, the ultrahigh heat-conducting filler is arranged in the metal shell, and the ultrahigh heat-conducting filler is a carbon fiber tube, a graphene sheet or a phase change liquid.

56. A high-frequency high-power packaging module, comprising:at least one power conversion bridge arm, at least one high-frequency capacitor, an insulating heat-conducting plate, an electrical-connecting device, a plastic package body, a cross-ceramic layer electrical-connecting assembly and a common-mode suppression capacitor; wherein

the power conversion bridge arm comprises at least two semiconductor power devices connected in series; the high-frequency capacitor and the power conversion bridge arm are connected in parallel; the insulating heat-conducting plate comprises an insulating heat-conducting layer, and an upper metal layer and a lower metal layer which are respectively arranged on the upper surface and the lower surface of the insulating heat-conducting layer;
at least one electrode on the front surface of the semiconductor power device is led out to the outside of the high-frequency high-power packaging module through the electric connecting device and is electrically connected with at least one electrode of the high-frequency capacitor;
the plastic package body fills a gap area between the front surface of the semiconductor power device and the upper surface of the insulating heat-conducting plate;
one electrode of the common-mode suppression capacitor is electrically connected with the upper metal layer through a cross-ceramic layer electrical connection assembly, and the other electrode of the common-mode suppression capacitor is electrically connected with one direct-current end of the power conversion bridge arm;
the back surface of the semiconductor power device is thermally connected with or electrically connected with the lower surface of the insulating heat-conducting.

57. The high-frequency high-power packaging module of claim 56, further comprisinga radiator,

wherein the high-frequency high-power packaging module is mounted on the radiator, the upper surface of the insulating heat-conducting plate is thermally connected with the radiator, and an electric potential of the radiator is the ground,
wherein the common-mode suppression capacitor is used for suppressing the current flowing through the radiator to the ground due to the jump of the AC voltage of the bridge arm.

58. The high-frequency high-power packaging module of claim 56, wherein the common-mode suppression capacitor is arranged in the gap area, the at least one semiconductor power device is a first power device, the back electrode of the first power device is electrically connected with one direct-current end of the power conversion bridge arm and the like, one electrode of the common-mode suppression capacitor is electrically connected with the upper metal layer through the cross-ceramic layer electrical connection assembly, and the other electrode of the common-mode suppression capacitor is electrically connected with the back electrode of the first power device through a lower metal layer.

59. The high-frequency high-power packaging module of claim 58, wherein the cross-ceramic layer electrical-connecting assembly comprises one side edge electrical interconnection piece, the side edge electrical interconnection piece is arranged on the side edge of the insulation heat-conducting plate, one end of the side edge electrical interconnection piece is electrically connected with the upper metal layer, and the other end of the side edge electrical interconnection piece is electrically connected with the common mode suppression capacitor through a lower metal layer.

60. The high-frequency high-power packaging module of claim 58, wherein the cross-ceramic layer electrical connecting assembly comprises a through-type electrical interconnection piece, the through-type electrical interconnection piece penetrates through the insulating heat-conducting layer, one end of the through-type electrical interconnection piece is electrically connected with the upper metal layer, and the other end of the through-type electrical interconnection piece is electrically connected with the common mode suppression capacitor through a lower metal layer.

61. The high-frequency high-power packaging module of claim 58, wherein the cross-ceramic layer electrical connection assembly comprises a conductive coating, the conductive coating is arranged on the side edge of the insulating heat-conducting layer and the adjacent area of the upper surface and the lower surface of the insulating heat-conducting layer, one end of the conductive coating is electrically connected with the upper metal layer, and the other end of the conductive coating is electrically connected with the common-mode suppression capacitor.

62. The high-frequency high-power packaging module of claims 56-61, wherein

the electrical-connecting device is a circuit layer, the circuit layer comprises a first surface, an inner-layer electrical connection layer, a second surface and a vertical electrical connection path, and the inner-layer electric connection layer is electrically connected with the first surface through at least one vertical electrical connection path;
the plastic package body fills a gap area between the second surface of the circuit layer and the upper surface of the insulating heat-conducting plate, an external electrode is arranged on the second surface or the side edge of the circuit layer, and the external electrode is electrically connected with the power conversion bridge arm;
the front surface of the semiconductor power device is electrically connected with the first surface of the circuit layer, and the back surface of the semiconductor power device is thermally connected with or electrically connected with the lower surface of the insulating heat-conducting plate;
the high-frequency capacitor is electrically connected with the first surface of the circuit layer or the second surface of the circuit layer or the lower surface of the insulating heat-conducting plate, and at least one electrode of the high-frequency capacitor is electrically connected with at least one electrode of the at least one semiconductor power device through the inner-layer electrical connection layer.

63. A high-frequency high-power packaging module, comprising at least one power conversion bridge arm, at least one high-frequency capacitor, an insulating heat-conducting plate, an electrical connection device, a plastic package body and an external electrode; wherein

the power conversion bridge arm comprises at least two semiconductor power devices connected in series;
the high-frequency capacitor and the power conversion bridge arm are connected in parallel; the insulating heat-conducting plate comprises an insulating heat-conducting layer, and an upper metal layer and a lower metal layer which are respectively arranged on the upper surface and the lower surface of the insulating heat-conducting layer;
at least one electrode on the front surface of the semiconductor power device is led out to the outside of the high-frequency high-power packaging module through the electrical connecting device and is electrically connected with at least one electrode of the high-frequency capacitor;
the plastic package body fills a gap area between the front surface of the semiconductor power device and the upper surface of the insulating heat-conducting plate;
the external electrode comprises at least one pair of direct-current end external electrodes, at least one pair of alternating-current end external electrodes and at least one pair of signal end external electrodes;

the back surface of the semiconductor power device is thermally connected or electrically connected to the lower surface of the insulating heat-conducting plate;

a plurality of power conversion bridge arms are arranged in parallel, and a direct-current end external electrode and an alternating-current end external electrode of the power conversion bridge arm are arranged on the two sides of the high-frequency high-power packaging module respectively;

the signal end external electrode is disposed between the direct-current end external electrode and the alternating-current end external electrode.

64. The high-frequency high-power packaging module of claim 63, wherein a minimum distance between the signal end external electrode and the direct-current end external electrode is larger than 4mm, and a minimum distance between the signal end external electrode and the alternating-current end external electrode is larger than 4mm.

65. The high-frequency high-power packaging module of claim 63, wherein the signal end external electrodes are a multi-pin strip which is prefabricated and formed.

66. The high-frequency high-power packaging module of claim 65, wherein the multi-pin strip is inserted into a flexible PCB flat wire.

67. The high-frequency high-power packaging module of claims 63-66, wherein

the electrical-connecting device is a circuit layer, the circuit layer comprises a first surface, an inner-layer electrical connection layer, a second surface and a vertical electrical connection path, and the inner-layer electrical connection layer is electrically connected with the first surface through at least one vertical electrical connection path;

the plastic package body fills a gap area between the second surface of the circuit layer and the upper surface of the insulating heat-conducting plate, an external electrode is arranged on the second surface or the side edge of the circuit layer, and the external electrode is electrically connected with the power conversion bridge arm;

the front surface of the semiconductor power device is electrically connected with the first surface of the circuit layer, and the back surface of the semiconductor power device is thermally connected with or electrically connected with the lower surface of the insulating heat-conducting plate;

the high-frequency capacitor is electrically connected to a first surface of the circuit layer or a second surface of the circuit layer or a lower surface of the insulating heat-conducting plate, and at least one electrode of the high-frequency capacitor is electrically connected to at least one electrode of the at least one semiconductor power device by means of the inner-layer electrical connection layer.

68. A manufacturing method for the high-frequency high-power packaging module of claim 1-55, comprising the following steps:

providing the circuit layer and the insulating heat-conducting plate;
arranging the high-frequency capacitor on a circuit layer or an insulating heat-conducting plate;
welding the semiconductor power device on the circuit layer;
providing the insulating heat-conducting plate above the semiconductor power device; and
plastic packaging the gap area to form the plastic package body, wherein the upper surface of the insulating heat-conducting plate is exposed.

69. A manufacturing method for the high-frequency high-power packaging module of claim 2-4, comprising:

providing the circuit layer and the insulating heat-conducting plate;
arranging the high-frequency capacitor on a circuit layer or an insulating heat-conducting plate;
welding the semiconductor power device on the circuit layer;
pre-molding an area between the semiconductor power device and a first surface of the circuit layer to form the thermal resistance electrical connection layer;
providing the insulating heat-conducting plate above the semiconductor power device; and
plastic packaging the gap region to form the plastic package body, the upper surface of the insulating heat-conducting plate being exposed.

70. A manufacturing method for the high-frequency high-power packaging module of claim 1-55, comprising the following steps:

providing the circuit layer and the insulating heat-conducting plate;
arranging the high-frequency capacitor on a circuit layer;
welding the semiconductor power device on the circuit layer;
plastic packaging the circuit layer and the semiconductor power device to form a first plastic package body, the upper surface of the semiconductor power device being exposed;
providing the insulating heat-conducting plate on an upper surface of the semiconductor power device; and
plastic packaging the insulating heat conducting plate to form a second plastic packaging body, wherein the upper surface of the insulating heat conducting plate is exposed.

71. A manufacturing method for the high-frequency high-power packaging module of claim 19-34, comprising the following steps:

providing the insulating heat-conducting plate and the circuit layer pre-provided with a circuit board through hole;
arranging the buffer outer pins fixedly and electrically in the circuit board through hole, so that the external electrode is electrically connected with the first surface and/or the inner layer electrical connection layer and/or the second surface of the circuit layer, and the buffer outer pins extend out of the second surface of the circuit layer;
disposing the at least one high-frequency capacitor on the circuit layer or on the insulating heat-conducting plate;
welding the at least two semiconductor power devices on the circuit layer;
providing the insulating heat-conducting plate above the at least two semiconductor power devices; and
plastic packaging the gap region to form the plastic package body, the upper surface of the insulating heat-conducting plate being exposed.

72. The manufacturing method for the high-frequency high-power packaging module of claim 1-52, comprising:

providing the circuit layer and the insulating heat-conducting plate;
providing a support platform;
providing solder and the semiconductor power device on a first surface of the circuit layer;
placing a second surface of the circuit layer on a support platform;
providing solder and the insulating heat-conducting plate above the semiconductor power device; and
placing a heating flat plate on the upper surface of the insulating heat-conducting plate for heating to complete welding.

73. A high-frequency high-power packaging module, comprising at least three semiconductor power devices and a driver; wherein

the at least three semiconductor power devices are provided on the same plane; and
the driver provides a drive signal for each of the semiconductor power devices, and a projection on the plane overlaps with a projection of each of the semiconductor power devices on the plane.

74. The high-frequency high-power packaging module of claim 73, further comprising a circuit layer, wherein the circuit layer comprises a first surface and a second surface which are opposite to each other; the semiconductor power device is arranged on the first surface, and the driver is arranged on the second surface.

75. The high-frequency high-power packaging module of claim 73, wherein a wiring distance from each semiconductor power device to a corresponding driving signal end of the driver is the same.

76. The high-frequency high-power packaging module of claim 74, further comprising at least one high-frequency capacitor, an insulating heat-conducting plate and a plastic package body; wherein

the insulating heat-conducting plate comprises an insulating heat-conducting layer, and an upper metal layer and a lower metal layer which are respectively arranged on the upper surface and the lower surface of the insulating heat-conducting layer;
the plastic package body fills a gap area between the second surface of the circuit layer and the upper surface of the insulating heat-conducting plate, an external electrode is arranged on the second surface or the side edge of the circuit layer, and the external electrode is electrically connected with the power conversion bridge arm;
the front surface of the semiconductor power device is electrically connected with the first surface of the circuit layer, and the back surface of the semiconductor power device is thermally connected with or electrically connected with the lower surface of the insulating heat-conducting plate;

the high-frequency capacitor and the power conversion bridge arm are connected in parallel to form a high-frequency loop, the high-frequency capacitor is electrically connected with the first surface of the circuit layer or the second surface of the circuit layer or the lower surface of the insulating heat-conducting plate, and at least one electrode of the high-frequency capacitor is electrically connected with at least one electrode of the at least one semiconductor power device through the inner-layer electrical connection layer;

the wiring distances from each of the semiconductor power devices to the corresponding driving signal ends of the driver are the same.

77. A hybrid substrate, comprising a high-heat-conducting area and a low-heat-conducting area, wherein the hybrid substrate is provided with an upper surface and a lower surface which are opposite to each other; wherein

the high heat-conducting region and the low heat-conducting region are arranged in a horizontal direction;

the high heat-conducting region is used for arranging a heating semiconductor device, and the heating semiconductor device is specifically arranged on the lower surface;

the heat-conducting coefficient of the high heat-conducting region is greater than the heat-conducting coefficient of the low heat-conducting region;

the upper surface of the hybrid substrate is used for assembling a heat dissipation device.

78. The hybrid substrate of claim 77, wherein a thermal conductivity of a high heat-conducting region is greater than twice a thermal conductivity of a low heat-conducting region.

79. The hybrid substrate of claim 77, wherein the high-heat-conducting area is a high-heat-conducting particle array, or the high-heat-conducting area is a mixture of a high-heat-conducting particle array and a low-heat-conducting material.

80. The hybrid substrate of claim 77, further comprising an upper metal layer and a lower metal layer respectively arranged on the upper surface and the lower surface, wherein a material of the high heat-conducting region and a material of the low heat-conducting region are both insulating materials.

81. A high-frequency high-power packaging module comprises the hybrid substrate of claim 80, at least one power conversion bridge arm, at least one high-frequency capacitor, a circuit layer and a plastic package body;

the power conversion bridge arm comprises at least two semiconductor power devices connected in series;

The high-frequency capacitor and the power conversion bridge arm are connected in parallel to form a high-frequency loop;

the circuit layer comprises a first surface, an inner-layer electrical connection layer, a second surface and a vertical electrical connection path, and the inner-layer electrical connection layer is electrically connected with the first surface through at least one vertical electrical connection path;

the plastic package body fills a gap area between the second surface of the circuit layer and the upper surface of the hybrid substrate, an external electrode is arranged on the second surface or the side edge of the circuit layer, and the external electrode is electrically connected with the power conversion bridge arm;

the front surface of the semiconductor power device is electrically connected with the first surface of the circuit layer, and the back surface of the semiconductor power device is thermally connected with or electrically connected with the lower metal layer corresponding to the high-heat-conductivity area;

the high-frequency capacitor is electrically connected with the first surface of the circuit layer or the second surface of the circuit layer or the lower surface of the hybrid substrate, and at least one electrode of the high-frequency capacitor is electrically connected with at least one electrode of the at least one semiconductor power device through the inner-layer electrical connection layer.

82. A high-frequency high-power packaging module comprises the hybrid substrate of claim 80, at least one power conversion bridge arm and a heat-conducting column;

the at least one power conversion bridge arm comprises at least two semiconductor power devices connected in series, and the semiconductor power device is arranged on a lower metal layer corresponding to the high heat-conducting area;

the heat-conducting column is arranged on an upper metal layer of the hybrid substrate;

at least one part of the heat-conducting column is arranged on the upper metal layer corresponding to the high heat-conducting area.

83. The high-frequency high-power packaging module of claim 82 is **characterized in that** at least another part of the heat conduction column is arranged on the upper metal layer corresponding to the low heat conduction area, and the number density of the heat conduction column in the high heat conduction area is larger than the setting number density of the heat conduction column in the low heat conduction area.

84. The high-frequency high-power packaging module of claim 82, further comprising at least one high-frequency capacitor, a circuit layer and a plastic package body; wherein

the high-frequency capacitor and the power conversion bridge arm are connected in parallel to form a high-frequency loop;

the circuit layer comprises a first surface, an inner-layer electrical connection layer, a second surface and a vertical electrical connection path, and the inner-layer electrical connection layer is electrically connected with the first surface through at least one vertical electrical connection path;

the plastic package body fills a gap area between the second surface of the circuit layer and ththe plastic package body fills a gap area between the second surface of the circuit layer and the upper surface of the hybrid substrate, an external electrode is arranged on the second surface or the side edge of the circuit layer, and the external electrode is electrically connected with the power conversion bridge arm;

the front surface of the semiconductor power device is electrically connected with the first surface of the circuit layer, and the back surface of the semiconductor power device is thermally connected with or electrically connected with the lower surface of the hybrid substrate;

the high-frequency capacitor is electrically connected to a first surface of the circuit layer or a second surface of the circuit layer or a lower surface of the hybrid substrate, and at least one electrode of the high-frequency capacitor is electrically connected to at least one electrode of the at least one semiconductor power device by means of the inner-layer electrical connection layer.

85. A high-frequency high-power packaging module comprises at least one power conversion bridge arm, a multi-layer circuit board, an insulating heat-conducting plate and a plastic package body;

the power conversion bridge arm comprises at least two semiconductor power devices connected in series;

the multi-layer circuit board comprises a first surface and a second surface which are opposite to each other, an inner-layer electrical connection layer, at least two low-circuit bonding pads and a vertical electrical connection path, and the inner-layer electrical connection layer is electrically connected with the first surface through at least one vertical electrical connection path;

the insulating heat-conducting plate comprises an insulating heat-conducting layer and an upper surface and a lower surface which are opposite to each other;

the plastic package body fills a gap area between the second surface of the multilayer circuit board and the upper surface of the insulating heat-conducting plate, an external electrode is arranged on the second surface or the side edge of the multilayer circuit board, and the external electrode is electrically connected with the power conversion bridge arm;

the front surface of the semiconductor power device is electrically connected with the first surface of the multilayer circuit board, and the back surface of the semiconductor power device is thermally connected with or electrically connected with the lower surface of the insulating heat-conducting plate;

according to the multi-layer circuit board, two direct-current electrodes of the power conversion bridge arm are coupled to two corresponding low-circuit bonding pads through a first surface and an inner-layer electrical connection layer, and the low-circuit bonding pad is used for being electrically connected with a high-frequency capacitor to form a low-loop circuit.

86. The high-frequency high-power packaging module of claim 85, wherein the at least two low-circuit bonding pads are arranged on the second surface of the multi-layer circuit board, and the second surface is further provided with a power pin and a signal pin.

87. The high-frequency high-power packaging module of claim 86, wherein the second surface of the circuit board is electrically connected with one surface of a client mainboard, the other surface of the client mainboard is provided with a high-frequency capacitor, and the high-frequency capacitor is electrically connected with the low-circuit bonding pad through a client mainboard.

88. The high-frequency high-power packaging module of claim 87, wherein the upper surface of the insulating heat-conducting plate is thermally connected with a heat dissipation device, and the heat dissipation device is assembled with a client mainboard through at least one fixing column.

89. The high-frequency high-power packaging module of claim 85, wherein the electric potential of at least 80% of the area of the back surface of the semiconductor power device is the electrostatic potential of the high-frequency high-power packaging module.

FIG 1

FIG 2A

FIG 2B

FIG 2C

FIG 2D

FIG 2E

FIG 2F

FIG 2G

FIG 2H

FIG 2I

FIG 3A

FIG 3B

FIG 3C

FIG 4A

FIG 4B

FIG 4C

FIG 4D

FIG 4E

FIG 5A

FIG 5B

FIG 5C

FIG 5D

FIG 5E

FIG 5F

FIG 5G

FIG 5H

FIG 5I

FIG 5J

FIG 5K

Vbus+  Q1  Q2  Vbus-

FIG 5L

FIG 6

FIG 7A

FIG 7B

FIG 7C

FIG 7D

FIG 7E

FIG 8A

FIG 8B

FIG 8C

FIG 8D

FIG 8E

FIG 8F

FIG 9

FIG 10

FIG 11

FIG 12A

FIG 12B

FIG 12C

FIG 12D

FIG 13A

FIG 13B

FIG 13C

FIG 13D

FIG 13E

FIG 13F

FIG 14A

FIG 14B

FIG 14C

◄— Sb4

FIG 14D

7

◄— Sb5

FIG 14E

6

6mm

18

FIG 15A

6

6mm

18

FIG 15B

6

6mm

18

FIG 15C

6

6mm

18

FIG 15D

6

202        2

FIG 16A

FIG 16B

FIG 16C

FIG 16D

FIG 16E

FIG 16F

FIG 17A

FIG 17B

FIG 17C

FIG 17D

FIG 17E

Source or Gate Pin

GaN

Top

Bottom

631  Drain Pins  Gate Pin  Source Pins

SiC

Drain Pin

Top

Bottom

Source Pins  Gate Pin  Source Pins

632

Via

632

631

631

FIG 18

**Drian**

**Normal On GaN/SiC**

G1

**Normal off SiMOS**

S1

**Source**

FIG 19A

Normal On
GaN/SiC

Normal off
SiMOS

FIG 19B

Normal On
GaN/SiC

201

2

Normal off
SiMOS

202

FIG 19C

Normal On
GaN/SiC

201

2

Normal off
SiMOS

202

FIG 19D

FIG 20A

FIG 20B

FIG 20C

FIG 20D

FIG 21A

FIG 21B

FIG 22A

FIG 22B

FIG 23

FIG 24A

Thermal Path

DBC

Q1
Q2
2

FIG 24B

Thermal Path

FIG 24C

Tcase

Rth_DietoCase

Pdie

Rth_PCBtoCase

Tdie

Rth_DietoPCB

Tpcb

FIG 24D

FIG 25A

FIG 25B

FIG 25C

FIG 25D

FIG 25E

FIG 26A

FIG 26B

FIG 26C

FIG 27A

VA

Ccer

Vds

Rth

Cy2

Lth

Rin

Cth

Cy1

Line_G

GND_pw

Icom

Lcom

GND

FIG 27B

25

24

DC
(Vbus+/Vbus-)

FIG 27C

4

26

5

24

FIG 27D

4

5

27

FIG 27E

FIG 27F

FIG 27G

FIG 28A

FIG 28B

FIG 28C

FIG 28D

FIG 29A

FIG 29B

FIG 29C

<table>
<tr><td colspan="2">**INTERNATIONAL SEARCH REPORT**</td><td>International application No.<br>**PCT/CN2023/082358**</td></tr>
</table>

**A. CLASSIFICATION OF SUBJECT MATTER**

H01L23/34(2006.01)i; H01L21/48(2006.01)i; H01L23/495(2006.01)i

According to International Patent Classification (IPC) or to both national classification and IPC

**B. FIELDS SEARCHED**

Minimum documentation searched (classification system followed by classification symbols)

IPC:H01L

Documentation searched other than minimum documentation to the extent that such documents are included in the fields searched

Electronic data base consulted during the international search (name of data base and, where practicable, search terms used)

CNTXT; ENTXT; ENTXTC; DWPI; CNKI; IEEE: 高频, 功率, 封装, 电容, 电路, 回路, 绝缘, 导热, 散热, 塑封, 连接, 电极, 金属, 焊料, 焊接, 焊盘, 引脚, 直流, 陶瓷, 共模抑制, high frequency, power, package, capacity, circuit, insulation, heat conduction, heat dissipation, mold encapsulation, connect, electrode, metal, solder, pad, soldering, pin, direct current, ceramic, common mode rejection

**C. DOCUMENTS CONSIDERED TO BE RELEVANT**

| Category* | Citation of document, with indication, where appropriate, of the relevant passages | Relevant to claim No. |
|---|---|---|
| PX | CN 114664758 A (SHANGHAI PEITABLELAND ELECTRONIC CO., LTD. et al.) 24 June 2022 (2022-06-24)<br>entire document | 1-89 |
| PX | CN 115621217 A (SHANGHAI PEITABLELAND ELECTRONIC CO., LTD. et al.) 17 January 2023 (2023-01-17)<br>entire document | 1-89 |
| X | CN 106373952 A (DELTA ELECTRONICS INC.) 01 February 2017 (2017-02-01)<br>description, paragraphs 2-110, figures 1-11D | 73-75, 77-80 |
| Y | CN 106373952 A (DELTA ELECTRONICS INC.) 01 February 2017 (2017-02-01)<br>description, paragraphs 2-110, figures 1-11D | 1-72, 76, 81-89 |
| Y | CN 104009023 A (ADVANCED SEMICONDUCTOR ENGINEERING INC.) 27 August 2014 (2014-08-27)<br>description, paragraphs 15-51, figures 1A, 2-3, 5-14 | 1-72, 76, 81-89 |

☑ Further documents are listed in the continuation of Box C.    ☑ See patent family annex.

\* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **25 December 2023** | **25 December 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

CORRECTED VERSION

**EP 4 498 427 A1**

<table>
<tr><td colspan="3" align="center">INTERNATIONAL SEARCH REPORT</td><td colspan="2">International application No.<br>**PCT/CN2023/082358**</td></tr>
<tr><td colspan="5">C.    DOCUMENTS CONSIDERED TO BE RELEVANT</td></tr>
<tr><td>Category*</td><td colspan="3">Citation of document, with indication, where appropriate, of the relevant passages</td><td>Relevant to claim No.</td></tr>
<tr><td>A</td><td colspan="3">CN 104900609 A (DELTA ELECTRONICS INTERNATIONAL (SINGAPORE) PRIVATE CO., LTD.) 09 September 2015 (2015-09-09)<br>entire document</td><td>1-89</td></tr>
<tr><td>A</td><td colspan="3">CN 114078786 A (DELTA ELECTRONIC ENTERPRISE MANAGEMENT (SHANGHAI) CO., LTD.) 22 February 2022 (2022-02-22)<br>entire document</td><td>1-89</td></tr>
<tr><td>A</td><td colspan="3">JP 2007157863 A (HITACHI LTD.) 21 June 2007 (2007-06-21)<br>entire document</td><td>1-89</td></tr>
<tr><td>A</td><td colspan="3">US 2008054439 A1 (DENSO CORP et al.) 06 March 2008 (2008-03-06)<br>entire document</td><td>1-89</td></tr>
</table>

Form PCT/ISA/210 (second sheet) (July 2022)

<table>
<tr><td colspan="2" rowspan="2"><strong>INTERNATIONAL SEARCH REPORT</strong><br>Information on patent family members</td><td colspan="2">International application No.</td></tr>
<tr><td colspan="2"><strong>PCT/CN2023/082358</strong></td></tr>
</table>

| Patent document cited in search report | | | Publication date (day/month/year) | Patent family member(s) | | | Publication date (day/month/year) |
|---|---|---|---|---|---|---|---|
| CN | 114664758 | A | 24 June 2022 | None | | | |
| CN | 115621217 | A | 17 January 2023 | None | | | |
| CN | 106373952 | A | 01 February 2017 | US | 2017025379 | A1 | 26 January 2017 |
| | | | | US | 10096562 | B2 | 09 October 2018 |
| | | | | TW | 201705388 | A | 01 February 2017 |
| | | | | CN | 106373952 | B | 05 April 2019 |
| | | | | TW | 579982 | B1 | 21 April 2017 |
| CN | 104009023 | A | 27 August 2014 | US | 2014239464 | A1 | 28 August 2014 |
| | | | | US | 9484313 | B2 | 01 November 2016 |
| | | | | TW | 201434120 | A | 01 September 2014 |
| | | | | TWI | 541961 | B | 11 July 2016 |
| | | | | CN | 104009023 | B | 08 August 2017 |
| | | | | CN | 107275241 | B | 19 May 2020 |
| | | | | CN | 107275241 | A | 20 October 2017 |
| CN | 104900609 | A | 09 September 2015 | US | 2015255380 | A1 | 10 September 2015 |
| | | | | US | 9425131 | B2 | 23 August 2016 |
| | | | | CN | 104900609 | B | 20 July 2018 |
| | | | | SG | 10201400390 | B | 14 March 2017 |
| | | | | SG | 10201400390 | A1 | 29 October 2015 |
| CN | 114078786 | A | 22 February 2022 | US | 2021175184 | A1 | 10 June 2021 |
| | | | | US | 11444036 | B2 | 13 September 2022 |
| | | | | EP | 4075498 | A2 | 19 October 2022 |
| | | | | EP | 4075498 | A3 | 01 March 2023 |
| | | | | EP | 4075497 | A3 | 01 March 2023 |
| JP | 2007157863 | A | 21 June 2007 | None | | | |
| US | 2008054439 | A1 | 06 March 2008 | US | 7999369 | B2 | 16 August 2011 |
| | | | | JP | 2008060531 | A | 13 March 2008 |
| | | | | JP | 5374831 | B2 | 25 December 2013 |
| | | | | US | 2011254177 | A1 | 20 October 2011 |
| | | | | US | 8432030 | B2 | 30 April 2013 |
| | | | | CN | 101136396 | A | 05 March 2008 |
| | | | | CN | 101136396 | B | 10 August 2011 |

Form PCT/ISA/210 (patent family annex) (July 2022)